(19) Europäisches Patentamt
European Patent Office
Office européen des brevets

(11) EP 1 696 265 A2

# (12) EUROPEAN PATENT APPLICATION

(43) Date of publication:
**30.08.2006 Bulletin 2006/35**

(51) Int Cl.:
*G03F 7/00* (2006.01)

(21) Application number: **06003725.6**

(22) Date of filing: **23.02.2006**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **23.02.2005 JP 2005047339**

(71) Applicant: **FUJI PHOTO FILM CO., LTD.**
**Minami-Ashigara-shi, Kanagawa (JP)**

(72) Inventors:
- **Takizawa, Hiroo**
**Minami-Ashigara-shi,**
**Kanagawa (JP)**
- **Morinaga, Naoki**
**Minami-Ashigara-shi,**
**Kanagawa (JP)**

(74) Representative: **Grünecker, Kinkeldey, Stockmair & Schwanhäusser Anwaltssozietät**
**Maximilianstrasse 58**
**80538 München (DE)**

## (54) Hologram recording material, hologram recording method, optical recording medium, and dye therefor

(57) A hologram recording material is provided and has: a sensitizing dye represented by formula specified in the specification, capable of absorbing hologram recording light to generate an excited state thereof and discoloring itself when irradiated with light after hologram recording; and an interference fringe-recording component capable of undergoing electron or energy transfer from excited state of sensitizing dye to record an interference fringes providing a refractive index modulation.

*FIG. 1*

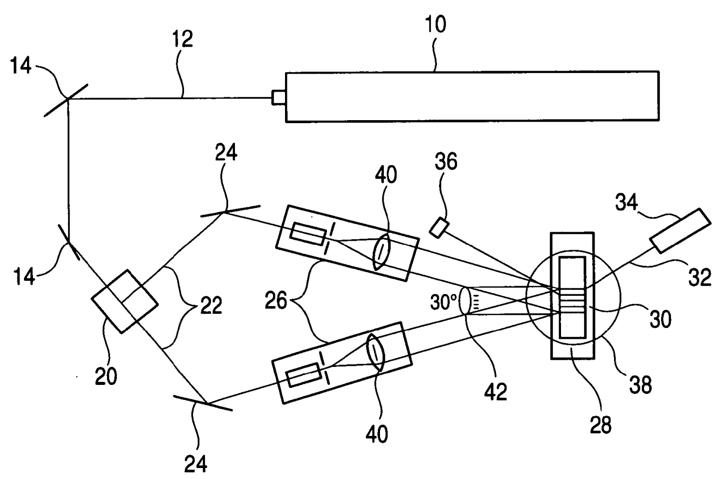


EP 1 696 265 A2

## Description

### FIELD OF THE INVENTION

The present invention relates to a hologram recording material and hologram recording method which can be applied to high density optical recording medium, three-dimensional display, holographic optical element, etc.

### BACKGROUND OF THE INVENTION

The general principle of preparation of hologram is described in some literatures and technical books, e.g., Junpei Tsujiuchi, ''Holographic Display", Sangyo Tosho, Chapter 2. In accordance with these literatures and technical books, a recording object is irradiated with one of two fluxes of coherent laser beams and a photosensitive hologram recording material is disposed in a position such that all the lights reflected by the recording object can be received. Besides the light reflected by the recording object, the other coherent light is incident on the hologram recording material without hitting the object. The light reflected by the object is called object light. The light with which the recording material is directly irradiated is called reference light. The band of interference of reference light with object light is then recorded as image data. Subsequently, when the hologram recording material thus processed is irradiated with the same light (reproducing light) as the reference light, the hologram performs diffraction in such a manner that the wave front of the first reflected light which has reached the recording material from the object during recording is reproduced. As a result, substantially the same object image as the real image of the object can be **three-dimensionally** observed.

The hologram formed by allowing reference light and object light to be incident on the hologram recording material in the same direction is called transmission hologram. The interference fringes are formed in the direction perpendicular or substantially perpendicular to the surface of the recording material at an interval of from about 1,000 to 3,000 lines per mm.

On the other hand, the hologram formed by allowing reference light and object light to be incident on the hologram recording material in opposite directions is normally called reflection hologram. The interference fringes are formed in the direction parallel to or substantially parallel to the surface of the recording material at an interval of from about 3,000 to 7,000 lines per mm.

The transmission hologram can be prepared by any known method as disclosed in JP-A-6-43634. The reflection hologram can be prepared by any known method as disclosed in JP-A-2-3082, JP-A-3-50588, etc.

On the other hand, the hologram having a sufficiently thick layer relative to the interval of interference fringes (normally five times the interval of interference fringes or about 1 μm or more) is called volume hologram.

On the contrary, the hologram having a layer thickness which is five times or less the interval of interference fringes or about 1 μm or less is called plane or surface hologram.

Further, the hologram involving the absorption by dye or silver causing the recording of an interference fringes is called amplified hologram. The hologram involving recording by surface relief or refractive index modulation is called phase hologram. The amplified hologram is subject to drastic drop of light diffraction efficiency or reflectance due to absorption of light and thus is disadvantageous in percent utilization of light. In general, the phase hologram is preferably used.

In accordance with the volume phase type hologram, many interference fringess having different refractive indexes are formed in the hologram recording material without by making optical absorption, making it possible to modulate the phase of light without absorbing light.

In particular, the reflection volume phase type hologram is also called Lipman type hologram. In accordance with the reflection volume phase type hologram, wavelength-selective reflection involving Bragg diffraction allows the formation of full-color image, reproduction of white color and enhancement of resolution at a high diffraction efficiency, making it possible to provide a high resolution full-color three-dimensional display.

In recent years, hologram has been put into practical use in the art of holographic optical element (HOE) such as headup display (HUD) to be mounted on automobile, pickup lens for optical disc, head mount display, color filter for liquid crystal and reflection type liquid crystal reflector by making the use of its wavelength-selective reflectivity.

Studies have been made also on the practical use or application of hologram to lens, diffraction grating, interference filter, connector for optical fiber, light polarizer for facsimile, window glass for building, etc.

In the recent tend for highly informative society, networks such as internet and highvision TV have bee rapidly spread. Further, with the operation of HDTV (High Definition Television) close at hand, there has been a growing demand for high density recording medium for simply recording image data having a capacity of 100 GB or more at reduced cost also in consumers' use.

In the trend for enhancement of computer capacity, an ultrahigh density recording medium capable of recording data having a capacity of about 1 TB or more at a high rate and reduced cost has been desired also in business uses such as computer backup and broadcast backup.

Under these circumstances, replaceable and random-accessible small-sized inexpensive optical recording media have been noted more than ever relative to magnetic tapes, which are not random-accessible, and hard discs, which are not replaceable and are subject to failure. Speaking from the standpoint of physical principle, however, existing two-dimensional optical recording media such as DVD-R allow recording of 25 GB data at greatest per one side even if the wavelength of the recording light is reduced. Thus, these two-dimensional recording media cannot be expected to have a recording capacity great enough to meet the future demand.

Then, three-dimensional optical recording media which perform recording in the thickness direction have been recently noted as ultimate ultrahigh density recording media. Effective methods for this system include method involving the use of two-photon absorbing material and method involving the use of holography (interference). Therefore, volume phase type hologram recording materials have recently been suddenly noted as three-dimensional optical recording media (holographic memory).

In operation, the holographic memory comprising a volume phase type hologram recording material records many two-dimensional digital data (called signal light) using a spatial light modulation element (SLM) such as DMD and LCD instead of object light reflected by the three-dimensional object. Since the recording involves multiplexed recording such as angle-multiplexed recording, phase-multiplexed recording, wavelength-multiplexed recording and shift-multiplexed recording, a capacity as high as up to I TB can be attained. Further, reading is normally accomplished by the use of CCD, CMOS or the like. These elements allow parallel writing/reading, making it possible to raise the transfer rate up to 1 Gbps.

However, the hologram recording materials to be used in holographic memory have severer requirements than for the three-dimensional display and HOE as follows.

(1) To have a high sensitivity.
(2) To have a high resolution.
(3) To have a high hologram diffraction efficiency.
(4) To use a fast dry processing during recording.
(5) To allow multiplexed recording (broad dynamic range).
(6) To have a small shrinkage after recording.
(7) To have good hologram storage properties.

In particular, the requirements (1) To have a high sensitivity, (3) To have a high hologram diffraction efficiency, (4) To use a fast dry processing during recording, (6) To have a small shrinkage after recording and (7) To have good hologram storage properties are chemically opposing properties. It is very difficult to meet these requirements at the same time.

Examples of known volume phase type hologram recording materials include write-once-read-many type hologram recording materials such as gelatin bichromate process hologram recording material, bleached silver halide process hologram recording material and photopolymer process hologram recording material and rewritable type hologram recording materials such as photorefractive process hologram recording material and photochromic polymer process hologram recording material.

However, none of these known volume phase type hologram recording materials cannot meet all these requirements particularly when used as high sensitivity optical recording medium. Thus, these known volume phase type hologram recording materials leave something to be desired.

In some detail, the gelatin bichromate process hologram recording material is advantageous in that it has a high diffraction efficiency and a low noise but is disadvantageous in that it has extremely poor storage properties, requires wet processing and exhibits a low sensitivity. Thus, the gelatin bichromate process hologram recording material is not suitable for holographic memory.

The bleached silver halide process hologram recording material is advantageous in that it has a high sensitivity but is disadvantageous in that it requires wet processing and troublesome bleaching process, causes great scattering and has a poor light-resistance. Thus, the bleached silver halide process hologram recording material, too, is not suitable for holographic memory.

The photorefractive hologram recording material is advantageous in that it is rewritable but is disadvantageous in that it requires the application of a high electric field during recording and has poor record storage properties.

The photochromic polymer process hologram recording material such as azobenzene polymer process hologram recording material is advantageous in that it is rewritable but is disadvantageous in that it has an extremely low sensitivity and poor record storage properties. For example, WO974436SAI proposes a rewritable hologram recording material utilizing the refractive anisotropy and orientation control of azobenzene polymer (photochromic polymer). However, this type of a rewritable hologram recording material is disadvantageous in that since the quantum yield of isomerization of azobenzene is low and this process involves orientation change, the sensitivity is extremely low. This type of a rewritable hologram recording material is also disadvantageous in that it has poor record storage properties, which

are contrary to rewritability. Thus, this type of a rewritable hologram recording material cannot be put into practical use.

Under these circumstances, the dry-processed photopolymer process hologram recording material disclosed in the above cited JP-A-6-43634, JP-A-2-3082 and JP-A-3-50588 has the following arrangement. In other words, the dry-processed photopolymer process hologram recording material is essentially composed of a binder, a radical-polymerizable monomer and a photopolymetizafion initiator. In order to enhance refractive index modulation, one of the binder and the radical-polymerizable monomer comprises a compound having an aromatic ring, chlorine or bromine incorporated therein to make a difference in refractive index therebetween. In this arrangement, the hologram exposure causes the progress of polymerization with the monomer and the binder gathering at the bright area and the dark area of the interference fringes thus formed, making it possible to form a refractive index difference. Thus, it can be said that the dry-processed photopolymer process hologram recording material is a relatively practical hologram recording material which can attain a high diffraction efficiency and dry processing properties at the same time.

However, the dry-processed photopolymer process hologram recording material is disadvantageous in that it has a sensitivity of about one thousandth of that of the bleached silver halide process hologram recording material, requires a heat-fixing step for about 2 hours to enhance diffraction efficiency, requires radical polymerization causing the effect of polymerization inhibition by oxygen and is subject to shrinkage after exposure and fixing and hence change of diffraction wavelength and angle during reproduction. Further, the dry-processed photopolymer process hologram recording material is in the form of soft membrane and lacks storage properties. Accordingly, the dry-processed photopolymer process hologram recording material can be by no means used for holographic memory.

In general, as opposed to radical polymerization, cationic polymerization, particularly cationic polymerization involving the ring opening of an epoxy compound, etc., causes little shrinkage after polymerization and no polymerization inhibition by oxygen. As a result, a rigid membrane can be given. It is also pointed out that cationic polymerization is more suitable for holographic memory than radical polymerization.

For example, JP-A-5-107999 and JP-A-8-16078 disclose a hologram recording material comprising in combination a cationically-polymerizable compound (monomer or oligomer) instead of binder and a sensitizing dye, a radical polymerization initiator, a cationic polymerization initiator and a radical-polymerizable compound.

Further, JP-T-2001-523842 and JP-T-11-512847 disclose a hologram recording material comprising only a sensitizing dye, a cationic polymerization initiator, a cationically-polymerizable compound and a binder but free from radical polymerization.

The aforementioned cationic polymerization process hologram recording material shows some improvement in shrinkage resistance as compared with the radical polymerization process hologram recording material but has a lowered sensitivity as opposed to the improvement. It is thought that this disadvantage gives a great problem in transfer rate during practical use. Further, the cationic polymerization process hologram recording material exhibits a reduced diffraction efficiency that probably gives a great problem in S/N ratio and multiplexed recording properties.

As previously mentioned, the photopolymer process hologram recording method involves the movement of materials. This causes a dilemma, In some detail, when the hologram recording material to be applied to holographic memory is arranged to have better storage properties and shrinkage resistance, the resulting sensitivity is lowered (cationic polymerization process hologram recording material). On the contrary, when the hologram recording material is arranged to have an enhanced sensitivity, the resulting storage properties and shrinkage resistance are deteriorated (radical polymerization process hologram recording material). In order to enhance the recording density of holographic memory, it is essential that multiplexed recording involving more than 50 times, preferably 100 times or more recording jobs be effected. However, since the photopolymer process hologram recording material employs polymerization process involving the movement of materials to perform recording, the recording speed in the latter half of multiplexed recording process, in which most of the compound has been polymerized, is reduced as compared with that in the initial stage of multiplexed recording process. Accordingly, exposure must be adjusted and a broad dynamic range must be used to control the recording speed. This gives a practically great problem.

The dilemma caused by the requirements for higher sensitivity, better storage properties and dry processing properties and the problem of multiplexed recording properties (high recording density) cannot be avoided from the physical standpoint of view so far as the related art photopolymer process hologram recording material is used. It is also difficult for the silver halide process recording material in principle from the standpoint of dry processing properties to meet the requirements for holographic memory.

In order to apply a hologram recording material to holographic memory, it has been keenly desired to develop quite a new recording system which can give essential solution to these problems, particularly one which can attain higher sensitivity, lower shrinkage, better storage properties, dry processing properties and multiplexed recording properties (high recording density) at the same time.

It has been particularly desired to develop a hologram recording material which undergoes no deterioration even when irradiated with reproducing light after recording, i.e., so-called fixed hologram recording material which allows non-destructive reproduction and thus exhibits excellent storage properties.

It has further been particularly desired to develop a hologram recording material which, when fixed after recording, does not absorb hologram reproduction wavelength, making it possible to obtain a high absolute diffraction efficiency.

**SUMMARY OF THE INVENTION**

An object of an illustrative, non-limiting embodiment of the invention is to provide a hologram recording material and hologram recording method which can be applied to high density optical recording medium, three-dimensional display, holographic optical element, etc. and can attain a high sensitivity, high diffraction efficiency, good storage properties, low shrinkage factor, dry processing properties and multiplexed recording properties (high recording density) at the same time.

Another object of an illustrative, non-limiting embodiment of the invention is to provide a hologram recording material which undergoes no deterioration even when irradiated with reproducing light after recording, i.e., so-called fixed hologram recording material which allows non-destructive reproduction and thus exhibits excellent storage properties.

Another object of an illustrative, non-limiting embodiment of the invention is to provide a hologram recording material which, when fixed after recording, does not absorb hologram reproduction wavelength, making it possible to obtain a high absolute diffraction efficiency.

As a result of the inventors' extensive studies, the aforementioned aims of the invention were accomplished by the following means.

(1) A hologram recording material including at least: a sensitizing dye represented by the following formula (1), capable of absorbing hologram recording light to generate an excited state thereof and discoloring itself upon irradiation after hologram recording; and an interference fringe-recording component capable of recording interference fringes as a refractive index modulation by an energy or electron transfer from the excited state:

D-L-E-LP (1)

wherein D represents a group containing a sensitizing dye; L represents a single bond or a connecting group; E represents a site capable of disconnecting the bond between E and LP to discolor the sensitizing dye; and LP represents a group containing a site capable of disconnecting the bond between E and LP upon irradiation.

(2) The hologram recording material as defined in Clause (1), wherein E is a site at which a nucleating agent, an electrophilic agent or a radical is generated by disconnecting the bond between E and LP.

(3) The hologram recording material as defined in Clause (1) or(2), wherein E is a site at which a nucleating agent is generated by disconnecting the bond between E and LP.

(4) The hologram recording material as defined in Clause (2) or (3), wherein the nucleating agent generated is any of -S-, -SH, -O-, -OH and $-NHR_{31}$ in which $R_{31}$ represents a hydrogen atom, alkyl group, alkenyl group, cycloalkyl group, aryl group or heterocyclic group.

(5) The hologram recording material as defined in any one of Clauses (2) to (4), wherein the nucleating agent generated is either -S- or -SH.

(6) The hologram recording material as defined in any one of Clauses (1) to (5), wherein LP is represented by the following formula (2):

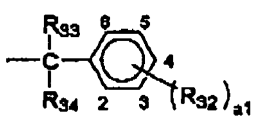

wherein $R_{32}$ represents a substituent; $R_{33}$ and $R_{34}$ each independently represent a hydrogen atom, alkyl group, alkenyl group, cycloalkyl group, aryl group, heterocyclic group or acyl group; and al represents an integer of from 1 to 5.

(7) The hologram recording material as defined in any one of Clauses (1) to (6), wherein D represents a group containing any of cyanine dye, melocyanine dye, oxonol dye, benzylidene dye and styryl dye.

(8) The hologram recording material as defined in any one of Clauses (1) to (7), wherein the formula (1) is represented by any one of the following formulae (3-1) to (3-5):

(3-1)

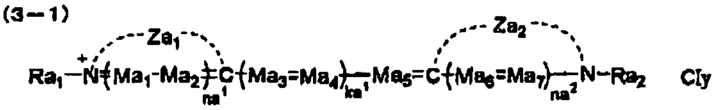

(3-2)

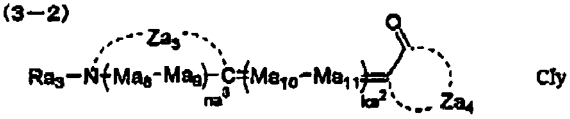

(3-3)

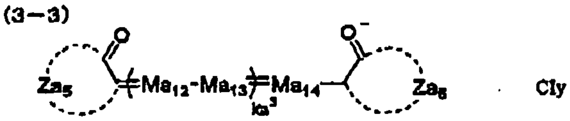

(3-4)

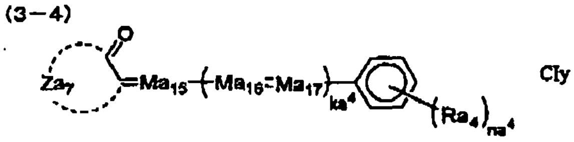

(3-5)

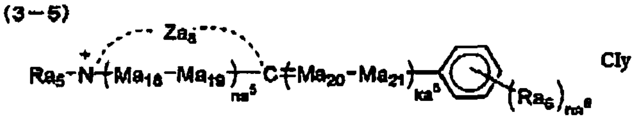

wherein $Za_1$, $Za_2$, $Za_3$ and $Za_8$ each independently represent an atomic group constituting a 5-membered or 6-membered nitrogen-containing heterocyclic group; $Za_4$ to $Za_7$ each independently represent an atomic group constituting a 5-membered or 6-membered ring; $Ra_1$, $Ra_2$, $Ra_3$ and $Ra_5$ each independently represent a hydrogen atom, alkyl group, alkenyl group, aryl group or heterocyclic group; $Ra_4$ and $Ra_6$ each independently represent a substituent; $Ma_1$ to $Ma_{21}$ each independently represent a methine group which may have substituents and may form a ring with other methine groups; $na^1$, $na^2$, $na^3$ and $na^5$ each independently represent 0 or 1; $na^4$ and $na^6$ each independently represent an integer of from 0 to 5, with the proviso that when $na^4$ is 2 or more, the plurality of $Ra_4$'s may be the same or different or may be connected to each other to form a ring and with the proviso that when $na^6$ is 2 or more, the plurality of $Ra_6$'s may be the same or different or may be connected to each other to form a ring; $ka^1$ to $ka^5$ each independently represent an integer of from 0 to 3, with the proviso that when $ka^1$ is 2 or more, the plurality of $Ma_3$'s and $Ma_4$'s may be the same or different, when $ka^2$ is 2 or more, the plurality of $Ma_{10}$'s and $Ma_{11}$'s may be the same or different, when $ka^3$ is 2 or more, the plurality of $Ma_{12}$'s and $Ma_{l3}$'S may be the same or different, when $ka^4$ is 2 or more, the plurality of $Ma_{16}$'s and $Ma_{17}$'s may be the same or different and when $ka^5$ is 2 or more, the plurality of $Ma_{20}$'s and $Ma_{21}$'s may be the same or different; CI represents an ion that neutralizes electric charge; y represents the number ofCI's required to neutralize electric charge; the sensitizing dye represented by the formula (3-1) comprises a group represented by the following formula (4) incorporated in any of Rat, $Ra_2$ and $Ma_3$ to $Ma_5$; the sensitizing dye represented by the formula (3-2) comprises a group represented by the following formula (4) incorporated in any of $Ra_3$, $Ma_{10}$ and $Ma_{11}$; the sensitizing dye represented by the formula (3-3) comprises a group represented by the following formula (4) incorporated in any of $Ma_{12}$ to $Ma_{14}$; the sensitizing dye represented by the formula (3-4) comprises a group represented by the following formula (4) incorporated in any of $Ra_4$, $Ma_{16}$ and $Ma_{17}$; and the sensitizing dye represented by the formula (3-5) comprises a group represented by the following formula (4) incorporated in any of $Ra_5$, $Ra_6$, $Ma_{20}$ and $Ma_{21}$:

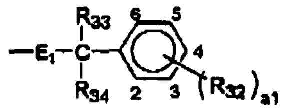

wherein $R_{32}$, $R_{33}$, $R_{34}$ and a1 are as defined in the formula (2); and El represents any of -O-, -S- and - $NR_{31}$- in which $R_{31}$ represents a hydrogen atom, alkyl group, alkenyl group, cycloalkyl group, aryl group or heterocyclic group.
(9) The hologram recording material as defined in Clause (6) or (8), wherein at least one of $R_{32}$'s in the formula (2) of Clause (6) or the formula (4) of Clause (8) is a nitro group or alkoxy group.
(10) The hologram recording material as defined in Clause (9), wherein at least one of $R_{32}$'s in the formula (9) is a nitro group which substitutes in 2-position.
(11) The hologram recording material as defined in Clause (9), wherein at least two of $R_{32}$'s in the formula (9) are alkoxy groups which substitute in 3-position and 4-position.
(12) The hologram recording material as defined in Clause (8), wherein the group represented by the formula (4) of Clause (8) is represented by any of the following formulae (6-1) to (6-3):

(6-1)

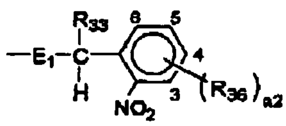

(6-2)

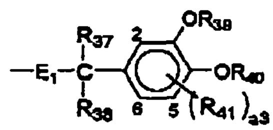

(6-3)

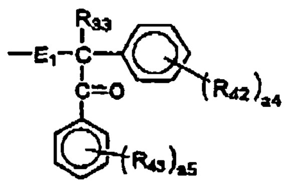

wherein E1 is as defined in the formula (4); $R_{35}$ represents a hydrogen atom, alkyl group or aryl group; $R_{36}$ represents a substituent; a2 represents an integer of from 0 to 4, with the proviso that when a2 is 2 or more, the plurality of $R_{a6}$'s may be the same or different and may be connected to each other to form a ring; $R_{37}$ and $R_{38}$ each independently represent a hydrogen atom or alkyl group; $R_{39}$ and $R_{40}$ cach independently represent an alkyl group; $R_{41}$ represents a substituent; a3 represents an integer of from 0 to 3, with the proviso that when a3 is 2 or more, the plurality of $R_{41}$'s may be the same or different and may be connected to each other to form a ring; $R_{42}$ and $R_{43}$ each independently represent a substituent; and a4 and a5 each independently represent an integer of from 0 to 5, with the proviso that when a4 is 2 or more, the plurality of $R_{42}$'s may be the same or different and may be connected to each other to form a ring and when a5 is 2 or more, the plurality of $R_{43}$'s may be the same or different and may be connected to each other to form a ring.
(13) The hologram recording material as defined in Clauses (8) or (12), wherein E1 in the formula (4) of Clause (8) or the formulae (6-1) to (6-3) of Clause (12) is -S-.
(14) The hologram recording material as defined in Clauses (8) to (13), wherein the sensitizing dye represented by the formula, (1) is represented by any of the formulae (3-1), (3-2) and (3-4).
(15) The hologram recording material as defined in Clause (14), wherein the sensitizing dye represented by the formula (1) is represented by any of the formulae (3-1) and (3-2).
(16) The hologram recording material as defined in Clause (14), wherein the sensitizing dye represented by the formula (1) is represented by the formulae (3-1).
(17) The hologram recording material as defined in Clauses (I) to (13), wherein the sensitizing dye represented by the formula (1) is represented by the formulae (7-1) or (7-2).

(7-1)

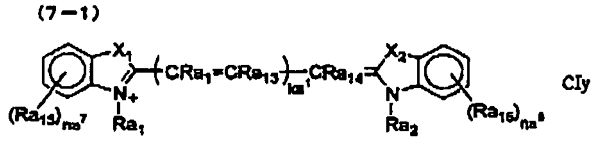

(7-2)

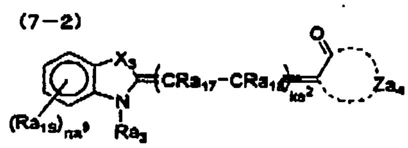

Cly

wherein $Ra_1$ to $Ra_3$, $ka^1$, $ka^2$, $Za_4$, Cl and y are as defined in Clauses (3-1) and (3-2); $X_1$ to $X_3$ each independently represent -O-, -S-, $-NR_{20}$- or $-CR_{21}R_{22}$- in which $R_{20}$ to $R_{22}$ each independently represent a hydrogen atom, alkyl group, alkenyl group, aryl group or heterocyclic group; $Ra_{12}$ to $Ra_{14}$, $Ra_{17}$ and $Ra_{18}$ each independently represent a hydrogen atom, alkyl group, alkenyl group, aryl group, heterocyclic group, halogen atom, nitro group, alkoxy group, aryloxy group, acylamino group, carbamoyl group, hydroxyl group, alkylthio group or cyano group; $Ra_{15}$, $Ra_{16}$ and $Ra_{19}$ each independently represent a substituent; $na^7$ to $na^9$ each independently represent an integer of from 0 to 5, with the proviso that when $na^7$ is 2 or more, the plurality of $Ra_{15}$'s may be the same or different and may be connected to each other to form a ring, when $na^5$ is 2 or more, the plurality of $Ra_{16}$'s may be the same or different and may be the same or different and when $na^9$ is 2 or more, the plurality of $Ra_{19}$'s may be the same or different and may be connected to each other to form a ring, with the proviso that when $ka^1$ is 2 or more, the plurality of $Ra_{12}$'s and $Ra_{13}$'s may be the same or different and when $ka^2$ is 2 or more, the plurality of $Ra_{17}$'s and $Ra_{18}$'s may be the same or different; the sensitizing dye represented by the formula (7-1) comprises a group represented by the formula (4) incorporated in any of $Ra_1$, $Ra_2$ and $Ra_{12}$ to $Ra_{14}$; and the sensitizing dye represented by the formula (7-2) comprises a group represented by the formula (4) incorporated in any of $Ra_3$, $Ra_{17}$ and $Ra_{18}$.

(18) The hologram recording material as defined in Clause (17), wherein the group represented by the formula (4) in the formula (7-1) or (7-2) of Clause (17) is one represented by any of the formulae (6-1) to (6-3).

(19) The hologram recording material as defined in Clause (17) or (18), wherein the sensitizing dye represented by the formula (1) of Clause (1) is represented by the formula (7-1).

(20) The hologram recording material as defined in any one of Clauses (1) to (19), wherein LP in the sensitizing dye represented by the formula (1) of Clause (1) does not disconnect from E (that is, LP does not disconnect the bond between E and LP) and thus does not discolor itself when irradiated with hologram recording light but can disconnect from E (that is, LP can disconnect the bond between E and LP) and thus discolor itself when irradiated with light other than hologram recording light.

(21) A hologram recording/reproducing method, which comprises effecting hologram recording with a sensitizing dye represented by any of the formulae (1) and (3-1) to (3-5), and then irradiating with light other than hologram recording light so that the compound represented by any of the formulae (1) and (3-1) to (3-5) is self-discolored and fixed, whereby reproduction can be effected by irradiating with the same light as hologram recording light without extinguishing recorded interference fringes providing the refractive index modulation.

(22) A hologram recording method, which comprises performing any of 1) polymerization reaction, 2) color development reaction, 3) latent image color development-coloring material self-sensitized amplification color development reaction (i.e., color development reaction amplified by a self-sensitization with a coloring material of a latent image), 4) latent image color development reaction-coloring material sensitizing polymerization reaction (i.e., a polymerization reaction sensitized with a coloring material of a latent image), 5) change of orientation (or alignment) of a compound having an intrinsic birefringence (i.e., an alignment change in a compound having a birefringence), 6) dye discoloration reaction and 7) remaining discolorable dye latent image-latent image sensitization polymerization reaction (i.e., a latent image-sensitized polymerization reaction sensitized by a latent image of a residual of a discolorable dye), using a sensitizing dye represented by any of the formulae (3-1) to (3-5) of the formulae (1) and (7) of Clause (1), to record interference fringes providing a refractive index modulation.

(23) The hologram recording method as defined in Clause (22), wherein hologram recording involving 3) latent image color development-coloring material sensitized polymerization reaction defined in Clause (22) comprises: at least a first step of forming a coloring material having no absorption at hologram reproducing light wavelength as a latent image by hologram exposure; and a second step of irradiating the coloring material latent image with light having a wavelength, which is different from hologram exposure wavelength and in which the sensitizing dye represented by any of the formulae (1) and (3-1) to (3-5) exhibits a molar absorption coefficient of 5,000 or less to make self-sensitized amplified production of a coloring material, whereby an interference fringes is recorded as refractive index modulation, which steps being effected in a dry process.

(24) A hologram recording method, which comprises using, as a group of compounds capable of performing hologram recording by 2) color development reaction or 3) latent image color development-coloring material self-sensitized amplification color development reaction defined in Clause (22), at least:

1) a sensitizing dye represented by any of the formulae (1) and (3-1) to (3-5) which absorbs light upon hologram

exposure to generate excited state; and

2) an interference fringe-recording component containing a dye precursor which can form a coloring material that has absorption at a longer wavelength than in the original state (i.e., absorption shifted to a longer wavelength than that the dye precursor) and that has no absorption at hologram reproducing light wavelength, which the interference fringe-recording component can undergo an electron or energy transfer (or movement) from excited state of the sensitizing dye or coloring material to cause color development by which the interference fringes providing the refractive index modulation is recorded.

(25) The hologram recording method as defined in Clause (22), wherein hologram recording involving 4) latent image color development-coloring material sensitized polymerization reaction defined in Clause (22) comprises at least a first step of forming a coloring material having no absorption at hologram reproducing light wavelength as a latent image by hologram exposure and a second step of irradiating the coloring material latent image with light having a wavelength different from hologram exposure wavelength to cause polymerization, whereby an interference fringes is recorded as refractive index modulation, which steps being effected in a dry process.

(26) A hologram recording method, which comprises, using as a group of compounds capable of performing hologram recording defined in Clause (25), at least:

1) a sensitizing dye represented by any of the formulae (1) and (3-1) to (3-5) which absorbs light upon hologram exposure to generate the excited state at the first step;

2) a group of dye precursors as an interference Singe-recording component which can form a coloring material that has absorption at a longer wavelength than in the original state and that has no absorption at hologram reproducing light wavelength, at the longer wavelength the sensitizing dye exhibiting a molar absorption coefficient of 5,000 or less, when an electron or energy transfers (moves) from excited state of sensitizing dye at the first step or from excited state of coloring material at the second step;

3) a polymerization initiator which can initiate the polymerization of a polymerizable compound when electron or energy moves from excited state of sensitizing dye at the first step and from excited state of coloring material at the second step;

4) a polymerizable compound; and

5) a binder.

(27) A hologram recording method, which comprises, using as a group of compounds capable of performing 6) dye discoloration reaction defined in Clause (22), at least:

1) a sensitizing dye represented by any of the formulae (1) and (3-1) to (3-5) which absorbs light upon hologram exposure to generate excited state; and

2) a discolorable dye or discoloring agent precursor and discoloring dye as interference fringe-recording component, wherein when subjected to hologram exposure, the sensitizing dye generates the excited state in which it then undergoes direct energy movement or electron movement to the discolorable dye to discolor the discolorable dye or undergoes energy movement or electron movement with the discoloring agent precursor to cause the discoloring agent precursor to generate a discoloring agent which then discolors the discolorable dye, causing refractive index modulation by which an interference fringes is formed, with the proviso that the discoloring agent precursor is any of radical generator, acid generator, base generator, nucleophilic agent generator, electrophilic agent generator and triplet oxygen.

(28) The hologram recording method as defined in Clauses (22) and (27), wherein hologram recording involving 7) remaining discolorable dye latent image-latent image polymerization reaction defined in Clause (22) comprises a first step at which the sensitizing dye represented by any of the formulae (1) and (3-1) to (3-5) having absorption at hologram exposure wavelength absorbs light during hologram exposure to generate excited state in which it undergoes direct energy movement or electron movement to the discolorable dye defined in Clause (27) to discolor the discolorable dye or undergoes energy movement or electron movement with the discoloring agent precursor to cause the discoloring agent precursor to generate a discoloring agent which then discolors the discolorable dye, whereby the discolorable dye left undiscolored forms a latent image and a second step at which the latent image of discolorable dye left undiscolored is irradiated with light having a wavelength different from that used for hologram exposure to activate the polymerization initiator to cause polymerization by which an interference fringes is recorded as refractive index modulation.

(29) A hologram recording method, which comprises using as a group of compounds capable of performing hologram recording defined in Clause (28) at least:

1) a sensitizing dye represented by any of the formulae (1) and (3-1) to (3-5) which absorbs light upon hologram exposure to generate excited state at the first step;
2) a discolorable dye having a molar absorption coefficient of 1,000 or less at hologram reproducing light wavelength capable of performing direct energy or electron movement to the discoloring agent precursor from excited state of sensitizing dye to generate a discoloring agent with which discoloration can be made at the first step;
3) a polymerization initiator (optionally acting as a discoloring agent precursor 2) as well) which can undergo electron or energy transfer from excited state of remaining discolorable dye to initiate the polymerization of the polymerizable compound at the second step;
4) a polymerizable compound; and
5) a binder.

(30) A hologram recording method, which comprises effecting volume phase type hologram recording involving hologram recording/reproduction method defined in Clause (21) or hologram recording method defined in Clauses (22) to (29) using a hologram recording material defined in Clauses (1) to (20).
(31) The hologram recording material as defined in any one of Clauses (1) to (20), the hologram recording/reproduction method as defined in Clause (21) or the hologram recording method as defined in any one of Clauses (22) to (30), wherein hologram recording defined in Clauses (1) to (30) is effected in a non-rewritable process (that is, the recorded interference fringes are non-rewritable).
(32) A hologram recording method involving multiplexed recording comprising 10 or more recording jobs (holographic exposures) using a hologram recording material defined in Clauses (1) to (20) and a hologram recording/reproduction method defined in Clause (21) or a hologram recording method defined in any one of Clauses (22) to (29).
(33) The hologram recording method as defined in Clause (32) involving multiplexed recording comprising 50 or more recording jobs using a hologram recording material defined in Clause (32).
(34) The hologram recording method as defined in Clause (32) involving multiplexed recording comprising 100 or more recording jobs using a hologram recording material defined in Clause (32).
(35) The hologram recording method as defined in Clauses (32) to (34), wherein multiplexed recording defined in Clause (32) can be effected from beginning to end with the exposure kept constant.
(36) The hologram recording material as defined in Clauses (1) to (35), wherein the hologram recording material defined in Clauses (1) to (35) has a light-shielding filter provided on the front surface, back surface or both surfaces thereof which can cut a part of light in the ultraviolet, visible and infrared ranges other than recording light and reproducing light.
(37) An optical recording medium comprising a hologram recording material defined in Clauses (1) to (36) and a method of recording on an optical recording medium comprising a hologram recording method defined in Clauses (1) to (36).
(38) An optical recording medium comprising a hologram recording material defined in Clauses (1) to (37) stored in a light-shielding cartridge during storage.
(39) A three-dimensional display hologram comprising a hologram recording material defined in Clauses (1) to (36) and a method of producing a three-dimensional display hologram using a hologram recording method defined in Clauses (1) to (36).
(40) A holographic optical element comprising a hologram recording material defined in Clauses (1) to (36) and a method of producing a holographic optical element using a hologram recording method defined in Clauses (1) to (36).
(41) A compound represented by any of the formulae (5-1) to (5-5):

(5-1)

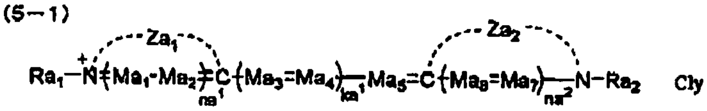

(5-2)

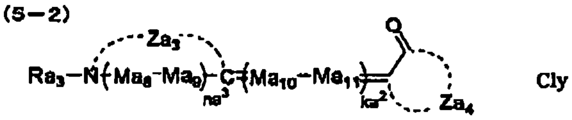

(5-3)

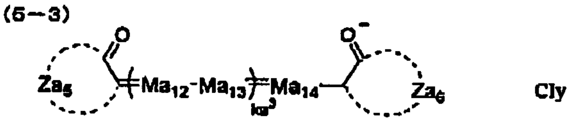

(5-4)

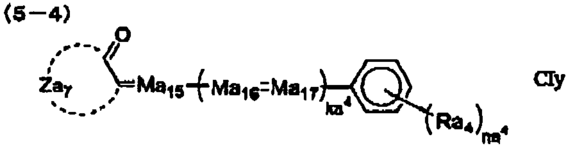

(5-5)

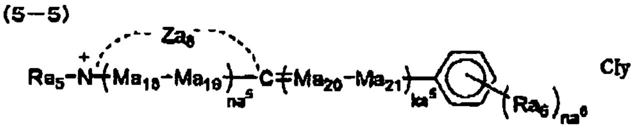

wherein $Za_1$ to $Za_8$, $Ra_1$ to $Ra_6$, $Ma_1$ to $Ma_{21}$, $na^1$ to $na^6$, $ka^1$ to $ka^5$, CI and y are as defined in the formulae (3-1) to (3-5); the sensitizing dyc represented by the formula (5-1) comprises a group represented by any of the following formulae (6-1) to (6-3) incorporated in any of $Ra_1$, $Ra_2$ and $Ma_3$ to $Ma_5$; the sensitizing dye represented by the formula (5-2) comprises a group represented any of the following formulae (6-1) to (6-3) incorporated in any of $Ra_3$, $Ma_{10}$ and $Ma_{11}$; the sensitizing dye represented by the formula (5-3) comprises a group represented any of the following formulae (6-1) to (6-3) incorporated in any of $Ma_{12}$ to $Ma_{14}$; the sensitizing dye represented by the formula (5-4) comprises a group represented any of the following formulae (6-1) to (6-3) incorporated in any of $Ra_4$, $Mal_{16}$ and $Ma_{17}$; and the sensitizing dye represented by the formula (5-5) comprises a group represented any of the following formulae (6-1) to (6-3) incorporated in any of $Ra_3$, $Ra_6$, $Ma_{20}$ and $Ma_{21}$:

(6-1)

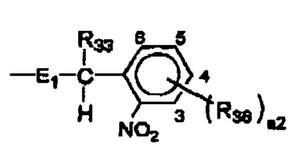

(6-2)

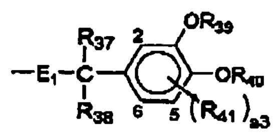

(6-3)

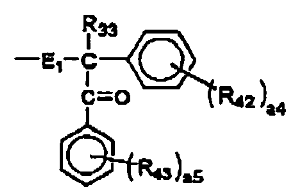

wherein E1 is as defined in the formula (4); $R_{35}$ represents a hydrogen atom, alkyl group or aryl group; $R_{36}$ represents a substituent; a2 represents an integer of from 0 to 4, with the proviso that when a2 is 2 or more, the plurality of $R_{36}$'s may be the same or different and may be connected to each other to form a ring; $R_{37}$ and $R_{38}$ each independently represent a hydrogen atom or alkyl group; $R_{39}$ and $R_{40}$ each independently represent an alkyl group; $R_{41}$ represents a substituent; a3 represents an integer of from 0 to 3, with the proviso that when a3 is 2 or more, the plurality of $R_{41}$'s may be the same or different and may be connected to each other to form a ring; $R_{42}$ and $R_{43}$ each independently represent a substituent; and a4 and a5 each independently represent an integer of from 0 to 5, with the proviso that when a4 is 2 or more, the plurality of $R_{42}$'s may be the same or different and may be connected to each other to form a ring and when a5 is 2 or more, the plurality of $R_{43}$'s may be the same or different and may be connected to each other to form a ring.

(42) The compound as defined in Clause (41), wherein E1 in the formulae (6-1) to (6-3) of Clause (41) is -S-.

(43) The compound as defined in Clause (41) or (42), which is represented by any of the formulae (5-1), (5-2) and (5-4).

(44) The compound as defined in Clause (41) or (42), which is represented by any of the formulae (5-1) and (5-2).

(45) The compound as defined in Clause (41) or (42), which is represented by the formulae (5-1).

(46) A compound represented by the formula (7-1) or (7-2):

(7−1)

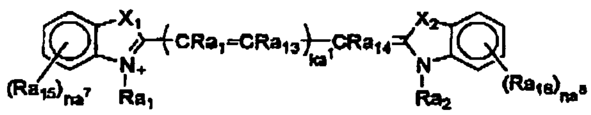

Cly

(7−2)

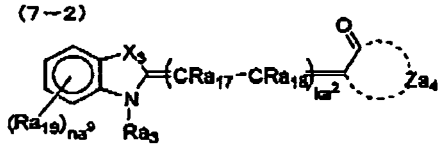

Cly

wherein $Ra_1$ to $Ra_3$, $ka^1$, $ka^2$, $Za_4$, Cl and y are as defined in Clauses (3-1) and (3-2); $X_1$ to $X_3$ each independently represent -O-, -S-, $-NR_{20}-$ or $-CR_{21}R_{22}-$ in which $R_{20}$ to $R_{22}$ each independently represent a hydrogen atom, alkyl group, alkenyl group, aryl group or heterocyclic group; $Ra_{12}$ to $Ra_{14}$, $Ra_{17}$ and $Ra_{18}$ each independently represent a hydrogen atom, alkyl group, alkenyl group, aryl group, heterocyclic group, halogen atom, nitro group, alkoxy group, aryloxy group, acylamino group, carbamoyl group, hydroxyl group, alkylthio group or cyano group; $Ra_{15}$, $Ra_{16}$ and $Ra_{19}$ each independently represent a substituent; $na^7$ to $na^9$ each independently represent an integer of from 0 to 5, with the proviso that when $na^7$ is 2 or more, the plurality of $Ra_{15}$'s may be the same or different and may be connected to each other to form a ring, when $na^8$ is 2 or more, the plurality of $Ra_{16}$'s may be the same or different and may be the same or different and when $na^9$ is 2 or more, the plurality of $Ra_{19}$'s may be the same or different and may be connected to each other to form a ring, with the proviso that when $ka^1$ is 2 or more, the plurality of $Ra_{12}$'s and $Ra_{13}$'s may be the same or different and when $ka^2$ is 2 or more, the plurality of $Ra_{17}$'s and $Ra_{18}$'s may be the same or different; the sensitizing dye represented by the formula (7-1) comprises a group represented by the formula (6-1) to (6-3) incorporated in any of $Ra_1$, $Ra_2$ and $Ra_{12}$ to $Ra_{14}$, and the sensitizing dye represented by the formula (7-2) comprises a group represented by the formula incorporated in any of $Ra_3$, $Ra_{17}$ and $Ra_{18}$.

(47) The compound as defined in Clause (46), which is represented by the formula (7-1).

(48) An optical self-discolorable dye represented by any of the formulae (5-1) to (5-5) and (7-1) and (7-2) defined in Clauses (41) to (47).

(49) An optical self-discolorable sensitizing dye represented by any of the formulae (5-1) to (5-5) and (7-1) and (7-2) defined in Clauses (41) to (47).

It is made obvious that when fixed after hologram recording, the hologram recording material comprising an optically self-discolorable sensitizing dye of the invention undergoes decomposition of the sensitizing dye, making it possible to avoid deterioration even when irradiated with reproducing light, i.e., allowing non-destructive reproduction and providing excellent storage properties.

It is also made obvious that the hologram recording material of the invention absorbs no hologram reproducing light after fixing, making it possible to obtain a high absolute diffraction efficiency.

It is further made obvious that the hologram recording material of the invention which undergoes, little shrinkage during recording and shows a linear rise of diffraction efficiency with exposure, making it possible to perform hologram recording as well.

As mentioned above, the hologram recording material and recording/reproduction method of the invention can be applied to holographic memory, etc. to advantage from the standpoint of capacity, storage properties, system simplification, etc.

BRIEF DESCRIPTION OF THE DRAWINGS

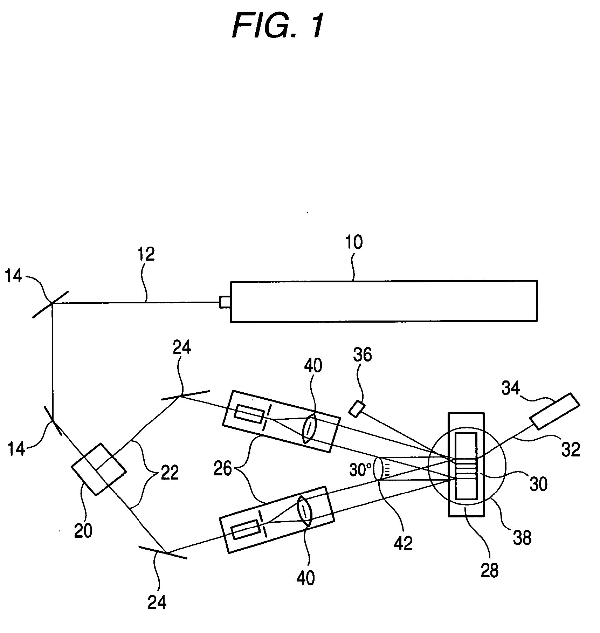

Fig. 1 is a schematic diagram illustrating a two-flux optical system for hologram exposure.

Reference numerals and signs in Fig. 1 are set forth below.

10: YAG laser; 12: Laser beam; 14: Mirror; 20: Beam splitter; 22: Beam segment 24: Mirror; 26: Spatial filter; 28: Sample; 30: Hologram recording material; 32: He-Ne laser beam; 34: He-Ne laser, 36: Detector, 38: Rotary stage; 40: Beam expander; and 42: Fixing xenon lamp + band pass filter.

DETAILED DESCRIPTION OF THE INVENTION

Exemplary embodiments of a hologram recording material of the invention will be further described hereinafter.

A hologram recording material of the invention includes at least: a sensitizing dye represented by the following formula (1), capable of absorbing hologram recording light to generate an excited state thereof and discoloring itself upon irradiation after hologram recording; and an interference fringe-recording component capable of recording interference fringes as a retractive index modulation by an energy or electron transfer from the excited state:

D-L-E-LP (1)

In the formula (1). D represents a group containing a sensitizing dye. Preferred examples of the sensitizing dye include those which absorb any of ultraviolet rays, visible light and infrared rays having a wavelength range of from 200 to 2,000 mn, preferably ultraviolet rays and visible light having a wavelength range of from 300 to 700 nm, more preferably visible light having a wavelength range of from 400 to 700 nm to generate excited state.

Preferred examples of the sensitizing dye contained in D include cyanine dye, squarilium cyanine dye, styryl dye, pyrilium dye, melocyanine dye, benzylidine dye, oxonol dye, azlenium dye, coumarine dye, ketocoumarine dye, styrylcoumarinc dye, pyrane dye, xanthene dye, thioxanthene dye, phenothiazine dye, phenoxazine dye, phenazine dye, phthalocyanine dye, azaporphyrin dye, porphyrin dye, condensed aromatic dye, perylene dye, azomethine dye, anthraquinone dye, metal complex dye, and metaloccne dye. More desirable among these sensitizing dyes are cyanine dye, squarilium cyanine dye, pyrilium dye, melocyanine dye, oxonol dye, coumarine dye, ketocoumarine dye, styrylcoumarine dye, pyrane dye, xanthene dye, thioxanthene dye, condensed aromatic dye, metal complex dye, and metalocene dye. Even more desirable among these sensitizing dyes are cyanine dye, melocyanine dye, oxonol dye, benzylidne dye, and styryl dye. As the metal complex dyes, Ru complex dyes are particularly preferred. As the metalocene dyes, ferrocenes are particularly preferred.

In addition to these sensitizing dyes, dyes and dyestuffs disclosed in Sinya Ogawara, "Shikiso Handobukku (Handbook of Dyes)", Kodansha, 1986, Shinya Ogawara, "Kinosei Shikiso no Kagaku (Chemistry of Functional Dyes)", CMC, 1981, and Tadasaburo Ikemori, "Tokushu Kino Zairyo (Specially Functional Materials)", CMC, 1986 may be used as sensitizing dye of the invention. The sensitizing dye to be used in the invention is not limited to these examples. Any dye or dyestuff may be used so far as it absorbs light in the visible range. These sensitizing dyes may be selected such that they are adapted for the wavelength of radiation from the light source depending on the purpose. Two or more sensitizing dyes may be used in combination depending on the purpose.

Since the hologram recording material needs to be used in the form of thick layer and light needs to be transmitted by the layer, the molar absorption coefficient of the sensitizing dye at the wavelength of hologram exposure is preferably reduced to maximize the added amount of the sensitizing dye for the purpose of enhancing sensitivity. The molar absorption coefficient of the sensitizing dye at the wavelength of hologram exposure is preferably from not smaller than 1 to not greater than 10,000, more preferably from not smaller than 1 to not greater than 5,000, even more preferably from not smaller than 5 to not greater than 2,500, most preferably from not smaller than 10 to not greater than 1,000.

The transmittance of the hologram recording material at the recording wavelength is preferably from 10% to 99%, more preferably from 20% to 95%, even more preferably from 30% to 90%, particularly from 40% to 85% from the standpoint of diffraction efficiency, sensitivity and recording density (multiplexity). To this end, the molar absorption coefficient of the sensitizing dye at the recording wavelength and the molarity of the sensitizing dye to be added are preferably adjusted according to the thickness of the hologram recording material.

$\lambda$max of the sensitizing dye is preferably shorter than the wavelength of hologram recording, more preferably between the wavelength of hologram recording and the wavelength of 100 nm shorter than the wavelength of hologram recording.

Further, the molar absorption coefficient of the sensitizing dye at the recording wavelength is preferably one fifth or less, more preferably one tenth or less of that at $\lambda$max. In particular, when the sensitizing dye is an organic dye such as cyanine dye and melocyanine dye, the molar absorption coefficient of the sensitizing dye at the recording wavelength is more preferably one twenticth or less, even more preferably one fiftieth or less, particularly one hundredth or less of that at $\lambda$max.

The sensitizing dye contained in D is discolored by E which is disconnected from LP when irradiated with light. The term "discoloration" as used herein is meant to indicate that either of, preferably both of, the shifting of $\lambda$max to shorter wavelength and the drop of molar absorption coefficient occur. The molar absorption coefficient of the dye represented by the formula (1) of the invention at the wavelength of hologram reproducing light for the dye represented by the formula (1) after optical self-discoloration reaction is preferably 2,500 or less, more preferably 1,000 or less, even more preferably 500 or less, most preferably 100 or less.

The sensitizing dye contained in D may be connected to L at any site thereof

In the formula (1), L represents a mere bond or connecting group. The connecting group represented by L may be any connecting group, preferably a connecting group having from 0 to 100, preferably from not smaller than 1 to not greater than 20 carbon atoms formed by singly or in combination alkylene group (preferably alkylene group having from 1 to 20 carbon atoms such as methylene, ethylene, butylene, pentylene, hexylene and octylene), arylene group (preferably

$C_6$-$C_{26}$ arylene group such as phenylene and naphthylene), alkenylene group (preferably $C_2$-$C_{20}$ alkenylene group such as ethenylene and propenylene), alkinylene group (preferably $C_2$-$C_{20}$ alkinylene group such as ethynylene and propynylene), amide group, ester group, sulfamide group, sulfonic acid ester group, ureido group, sulfonyl group, sulfinyl group, thioether group, ether group, carbonyl group and heteryl group (preferably $C_1$-$C_{26}$ heteryl group such as 6-chloro-1,3,5-triazyl-2,4-diil group, pyrimidine-2,4-diil group and quinoxaline-2,3-diil group).

In the formula (1), E represents a site at which the sensitizing dye can be discolored when the molecule is disconnected from LP. E is preferably a site at which a nucleophilic agent, electrophilic agent or radical, more preferably nucleophilic agent is generated when disconnected from LP. The nucleophilic agent thus generated is more preferably any of -S-, -SH, -O-, -OH and -NHR$_{31}$, even more preferably any of -S- and -SH, $R_{31}$ represents a hydrogen atom, alkyl group (preferably $C_1$-$C_{20}$ alkyl group such as methyl, ethyl, n-propyl, isopropyl, n-butyl, n-pentyl, benzyl, 3-sulfopropyl, 4-sulfobutyl, carboxylmethyl and 5-carboxypentyl), alkenyl group (preferably $C_2$-$C_{20}$ alkenyl group such as vinyl, allyl, 2-butenyl, 1,3-butadienyl), cycloalkyl group (preferably $C_3$-$C_{20}$ cycloalkyl group such as phenyl, 2-chlorophenyl, 4-methoxyphenyl, 3-methylophenyl and 1-naphthyl), aryl group (preferably $C_6$-$C_{20}$ aryl group such as phenyl, 2-chlorophenhyl, 4-methoxyphenyl, 3-methylophenyl and 1-naphthyl) or heterocyclic group (preferably $C_1$-$C_{20}$ heterocyclic group such as pyridyl, chenyl, furyl, thiazolyl, imidazolyl, pyrazolyl, pyrrolidino and morpholino), preferably hydrogen atom or alkyl group.

In the formula (1), LP represents a group containing a site at which the molecule can be disconnected from E when the interference ninge-recording component is irradiated with light. The light with which the interference fringe-recording component is irradiated is preferably any of ultraviolet ray, visible light and infrared ray having a wavelength of from 200 to 2,000 nm, more preferably ultraviolet ray or visible light having a wavelength of from 250 to 700 nm.

During the optical self-discoloration of the sensitizing dye represented by the formula (1), the interference fringe-recording component is preferably irradiated with light having a wavelength different from that of hologram recording light.

LP is preferably represented by the following formula (2):

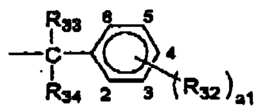

In the formula (2), $R_{32}$ represents a substituent. Preferred examples of the substituent $R_{32}$ include alkyl group (preferably alkyl group having from 1 to 20 carbon atoms such as methyl, ethyl, n-propyl, isopropyl, n-butyl, n-pentyl, benzyl, 3-sulfopropyl, 4-sulfobutyl, carboxymethyl, and 5-carboxypentyl), alkenyl groups (preferably alkenyl group having from 2 to 20 carbon atoms such as vinyl, allyl 2-butenyl and 1,3-butadienyl), cycloalkyl groups (preferably cycloalkyl group having from 3 to 20 carbon atoms such as cyclopentyl and cyclohexyl), aryl groups (preferably aryl group having from 6 to 20 carbon atoms such as phenyl, 2-chlorophenyl, 4-methoxyphenyl, 3-methylphenyl, 1-naphthyl and 2-nitrophenyl), heterocyclic groups (preferably heterocyclic group having from 1 to 20 carbon atoms such as pyridyl chenyl, furyl, thiazolyl, imidazolyl, pyrazolyl, pyrrolidino, piperidino, morpholino), alkinyl groups (preferably having from 2 to 20 carbon atoms such as ethinyl, 2-propinyl, 1,3-butadinyl and 2-phenylethinyl), halogen atoms (e.g., F, Cl, Br, I), amino groups (preferably amino group having from 0 to 20 carbon atoms such as alkylamino and arylamino), cyano groups, nitro groups, hydroxyl groups, mercapto groups, carboxyl groups, sulfo groups, phosphonic acid groups, acyl groups (preferably acyl group having from 1 to 20 carbon atoms such as acetyl, benzoyl, salicyloyl, pivaloyl, 3,5-dimethoxybenzoyl and 4-methoxybenzoyl), alkoxy groups (preferably alkoxy group having from 1 to 20 carbon atoms such as methoxy, butoxy and cyclohexyloxy), aryloxy groups (preferably aryloxy group having from 6 to 26 carbon atoms such as phenoxy and 1-naphtoxy), alkylthio groups (preferably alkylthio group having 1 to 20 carbon atoms such as methylthio and ethyttbio), arylthio groups (preferably arylthio group having 6 to 20 carbon atoms phenylthio and 4-chlorophenylthio), alkylsulfonyl groups (preferably alkylsulfonyl group having from 1 to 20 carbon atoms such as methane sulfonyl and butanesulfonyl), arylsulfonyl groups (preferably arylsulfonyl group having from 6 to 20 carbon atoms such as benzenesulfonyl and paratoluenesulfonyl), sulfamoyl groups (preferably sulfamoyl group having from 0 to 20 carbon atoms such as sulfamoyl, N-methylsulfamoyl and N-phenylsulfamoyl), carbamoyl groups (preferably carbamoyl group having from 1 to 20 carbon atoms such as carbamoyl, N-methylcarbamoyl, N,N-dimethylcarbamoyl and N-phenylcarbamoyl), acylamino groups (preferably acylamino group having from 1 to 20 carbon atoms such as acetylamino and benzoylamino), imino groups (preferably imino group having from 2 to 20 carbon atoms such as phthalimino), acyloxy groups (preferably acryloxy group having from I to 20 carbon atoms such as acetyloxy and benzoyloxy), alkoxycarbonyl groups (preferably alkoxycarbonyl group having from 2 to 20 carbon atoms such as methoxycarbonyl and phenoxycarbonyl), and carbamoylamino groups (preferably carbamoylamino group having from 1 to 20 carbon atoms such as carbamoylamino, N-methylcarbamoylamino and N-phenylcarbamoylamino. More desirable among these substituents are alkyl groups,

alkenyl groups, aryl groups, alkinyl groups, halogen atoms, amino groups, nitro groups, alkoxy groups, aryloxy groups, alkylthio groups, arylthio groups, acylamino groups, acyloxy groups, carbamoyl groups, and alkoxycarbonyl groups. Even more desirable among these substituents are alkyl groups, alkenyl groups, aryl groups, alkinyl groups, halogen atoms, amino groups, nitro groups, alkoxy groups, aryloxy groups, acylamino groups, and acyloxy groups. Still more preferably, one or more nitro groups or alkoxy groups are incorporated. The alkoxy group is more preferably a methoxy group.

$R_{33}$ and $R_{34}$ each independently represent a hydrogen atom, alkyl group, alkenyl group, cycloalkyl group, aryl group, heterocyclic group or acyl group (Preferred examples of these groups include those listed above with reference to $R_{32}$). $R_{33}$ is preferably any of hydrogen atom, alkyl group, aryl group and acyl group. The aryl group represented by $R_{33}$ is more preferably 2-nitroophenyl group. The acyl group represented by $R_{33}$ is more preferably benzoyl group, even more preferably substituted by alkoxy group. $R_{34}$ is preferably a hydrogen atom or alkoxy group.

The suffix a1 represents an integer of from 1 to 5, preferably from 1 to 3. When a1 is 2 or more, the plurality of $R_{32}$'s may be the same or different and may be connected to each other to form a ring. Preferred examples of the ring thus formed include benzene ring and pyridine ring.

In the case where $R_{32}$ is a nitro group, when a1 is 1, the nitro group is preferably on the 2-position. When a1 is 2, the nitro group is preferably on the 2- or 6-position.

Further, when $R_{32}$ is an alkoxy group, a1 is preferably 2 or more. In this case, the alkoxy group is preferably on the 3- or 4-position.

The sensitizing dye represented by the formula (1) is more preferably represented by any of the formulae (3-1) to (3-5). The dyes represented by the formula (3-1) are generically called cyanine dye. The dyes represented by the formula (3-2) arc generically called melocyanine dye. The dyes represented by the formula (3-3) are generically called oxonol dye. The dyes represented by the formula (3-4) are generically called benzylidene dye. The dyes represented by the formula (3-5) are generically called styryl dye.

(3-1)

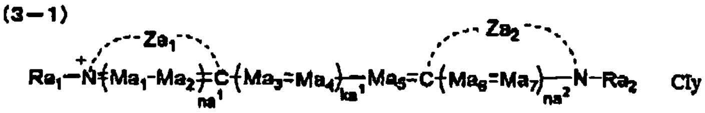

(3-2)

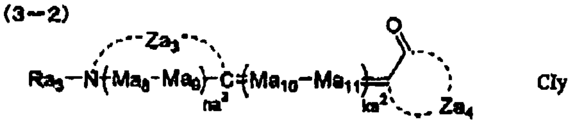

(3-3)

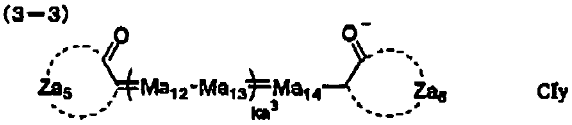

(3-4)

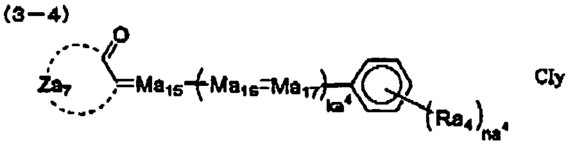

(3-5)

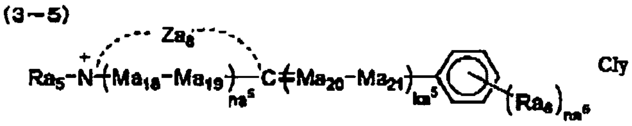

In the formulae (3-1), (3-2) and (3-5), $Za_1$, $Za_2$, $Za_3$ and $Za_8$, each independently represent an atomic group constituting a 5-membered or 6-membered nitrogen-containing heterocyclic ring. Preferred examples of the atomic group include $C_3$-$C_{25}$ oxazole nucleus (e.g., 2-3-methyloxazolyl, 2-3-ethyloxazolyl, 2-3,4-diethyloxazolyl, 2-3-methylbenzooxazolyl, 2-3-ethylbenzooxazolyl, 2-3-sulfoethylbenzooxazolyl, 2-3-sulfopropylbenzooxazolyl, 2-3-methylthioethyl benzooaxazolyl, 2-3-methoxyethylbenzooxazolyl, 2-3-sulfobutylbenzooxazolyl, 2-3-methyl-β-naphthooxazolyl, 2-3-methyl-α-naphthooxazolyl, 2- 3-sulfopropyl-β-naphthoaxazolyl, 2-3-sulfopropyl-β-naphthooxazolyl, 2-3-(3-naphthoxyethyt)benzooxazolyl, 2-3,5-dimethyl benzooxazolyl, 2-6-chloro-3-methylbenzooxazolyl, 2-5-bromo-3-methylbenzooxazolyl. 2-3-ethyl-5-methoxy benzooxazolyl, 2-5-phenyl-3-suifopropylbenzooxazolyl, 2-5-(4-bromophenyl)-3-sulfobutyl benzooxaxolyl, 2-3-dimethyl-5,6-dimethylthiobenzooxazolyl, 2-3-sulfopropyloxazolyl, 2,3-sulfopropyl-γ-naphthooxazolyl. 2-3-ethyl-α-naphthooxazolyl, 2-5-chloro-3-ethyl-α-naphthooxazolyl, 2-5-chloro-3-ethyl benzooxazolyl, 2-5-chloro-3-sulfopropylbenzooxazolyl, 2-5,6-dichloro-3-sulfopropylbenzooxazolyl, 2-5-bromo-3-sulfopropylbenzooxazolyl, 2-3-ethyl-5-phenyl benzooxazolyl, 2-5-(1-pyrrolyl)-3-sulfopropyl benzooxazolyl, 2-5,6-dimethyl-3-sulfopropyl benzooxazolyl, 2-3-ethyl-5-sulfobenzooxazolyl), $C_3$-$C_{25}$ thiazole nucleus (e.g., 2-3-methylthiazolyl, 2-3-ethyl thiazolyl, 2-3-sulfopropylthiazolyl, 2-3-sulfobutyl thiazolyl, 2-3,4-dimethylthiazolyl, 2-3,4,4-trimethyl thiazolyl, 2-3-catboxyethylthiazolyl, 2-3-methyl benzothiazolyl, 2-3-ethylbenzothiazolyl, 2-3-butyl benzothiazolyl, 2-3-sulfopropylbenzothiazolyl, 2,3-sulfobutylbenzothiazolyl, 2-3-methyl-β-naphthothiazolyl, 2-3-sulfopropyl-γ-naphtho thiazolyl, 2-3-(1-naphthoxyethyl)bemothiazolyl, 2-3, 5-dimethylbenzothiazolyl, 2-6-chloro-3-methyl benzothiazolyl, 2-6-iodo-3-ethylbenzothiazolyl, 2-5-bromo-3-methylbenzothiazolyl, 2-3-ethyl-5-methoxy benzothiazolyl, 2-5-phenyl-3-sulfopropyl benzothiazolyl, 2-5-(4-bromophenyl)-3-sulfobutyl benzothiazolyl, 2-3-dimethyl-5,6-dimethylthio benzothiazolyl, 2-5-chloro-3-ethylbenzothiazolyl, 2-5-chloro-3-sulfopropylbenzothiazolyl, 2-3-ethyl-5-iodobenzothiazolyl), $C_3$-$C_{25}$ imidazole nucleus (e.g., 2-1, 3-diethylimidazolyl, 2-1,3-dimethylimidazolyl, 2-1-methylimidazolyl, 2-1,3,4-methylimidazolyl, 2-1,3-diethylbenzoimidazolyl, 2-1,3.5-trimethylbenzo imidazolyl 2-6-chloro-1,3-dimethylbenzoimidazolyl, 2-5,6-dichloro-1,3-diethylbenzoimidazolyl, 2-1.3-disulfopropyl-5-cyano-6-chlorobenzoimidazolyl, 2-5,6-dichloro-3-ethyl-l-sulfopropylbenzoimidazolyl. 2-5-chloro-6-cyano-1,3-diethylbenzoimidazolyl, 2-5-chloro-1,3-diethyl-6-tifluommethylbenzoimidazolyl), $C_{10}$-$C_{30}$ indolenine nucleus (e.g., 3,3-dimethyl-1-pentylindolenine, 3.3-dimethyl-1-mlfoproopyl indolenine, 5-carbmcy-1,3,3 trimethylindolenine, 5-carbamoyl-1,3,3-trimethylindolenine, 1,3,3 trimethyl-4,5-benzoindolenine), $C_9$-$C_{25}$ quinoline nucleus (e.g., 2-1-methylquinolyl, 2-1-ethylquinolyl, 2-1-methyl-6-chlloroquinolyl, 2-1,3-diethylquinolyl, 2-1-methyl-6-methylthioquinolyl, 2-1-sulfopropylquinolyl, 4-1-methylquinolyl. 4-1-sulfoethylquinolyl, 4-1-methyl-7-chloroquinolyl, 4-1,8.diethylquinolyl, 4-1-methyl-6-methylqninolyl, 4-1-sulfopropylquinolyl), $C_3$-$C_{25}$ selenazole nucleus (e.g., 2-3-methylbenzoselenazolyl), and $C_5$-$C_{25}$ pyridine nucleus (e.g., 2-pyridyl). Other examples of the atomic group include thiazoline nucleus, oxazoline nucleus, selenazoline nucleus, tellurazoline nucleus, tellurazole nucleus, benzotellurazole nucleus, imidazoline nucleus, imidazo(4,5-quinozaline) nucleus, oxadiazole nucleus, thiadiazote nucleus, tetrazole nucleus, and pyrimidine nucleus.

These atomic groups may be substituted. Preferred examples of substituents on these atomic groups include alkyl group (e.g., methyl, ethyl, propyl), halogen atom (e.g., chlorine, bromine, iodine, fluorine), nitro group, alkoxy group (e.g., methoxy, ethoxy), aryl group (e.g., phenyl), heterocyclic group (e.g., 2-pyridyl, 3-pyridyl, 1-pyrrolyl, 2-chenyl), aryloxy group (e.g., phenoxy), acylamino group (e.g., acetylamino, benzoylamino), carbamoyl group (e.g., N,N-dimethylcarbamoyl), sulfo group, sulfonamide group (e.g., methanesulfonamide), sulfamoyl group (e.g., N-methylsulfamoyl), hydroxyl group, carboxyl group, alkylthio group (e.g., methylthio), and cyano group.

Preferred among these substituents are oxazole nucleus, imidazole nucleus, and thiazole nucleus. These heterocyclic rings may be further substituted. Examples of rings which can be condensed to these heterocyclic rings include benzene ring, benzofurane ring, pyridine ring, pyrrole ring, indole ring, and thiophene ring.

In the formula (3-1), the ring formed by $Za_1$ or $Za_2$ is preferably a benzooxazole ring.

In the formulae (3-2) to (3-4), $Za_4$ to $Za_7$ each independently represent an atomic group constituting a 5-membered or 6-membered ring, preferably an atomic group required to form an acidic nucleus, as defined in James, The Theory of the Photographic Process", 4th ed., Macmillan Inc., 1977, page 198. Specific examples of the atomic group include nuclei such as 2-pyrazolone-5-one, pyrazolidino-3,5-diono, imidazoline-5-one, hydantoin, 2-thiohydantoin, 4-thiohydantoin, 2-iminooxazolidine-4-one, 2-oxazoline-5-one, 2-thooxazoline-2,4-dione, isorhodanine, rhodanine, indane-1,3-dione, thiophene-3-one, thiophene-3-one-1,1-dioxide, indoline-2-one, indoline-3-one, 2-oxoindazolium, 5,7-dioxo-6,7-dihydrothiazolo(3,2-a)pyrimidine, 3,4-dihydro isoquinoline-4-one, 1,3-dioxane-4,6-dione, barbituric acid, 2-thiobarbituric acid, coumarine-2,4-dione, indazoline-2-one, pyrido(1,2-a)pyrimidine-1,3-dione, pyrazolo(1,5-b)quinazolone, pyrazolopyridone and 3-dicyanomethylidenyl-3-phenylpropionitrile.

Preferred among these nuclei are pyrazolidino-3,5-dione, rhodanine, indane-1,3-dione, thiophene-3-one, thiophene-3-one-1,1-dioxide, 1,3-dioxane-4,6-dione, barbituric acid, and 2-thiobarbituric acid.

In the formulae (3-1), (3-2) and (3-5). $Ra_1$, $Ra_2$, $Ra_3$ and $Ra_5$ each independently represent a hydrogen atom, alkyl group, alkenyl group, aryl group or heterocyclic group (Preferred examples of these groups include those listed above with reference to $R_{32}$), preferably alkyl group. $Ra_4$ and $Ra_6$ each independently represent a substituent (Preferred examples of the substituent include those listed above with reference to $R_{32}$), preferably an alkyl group, alkenyl group, aryl group, heterocyclic group, halogen atom, amino group, cyano group, nitro group, hydroxyl group, alkoxy group, aryloxy group, carbamoyl group, acylamino group or alkoxycarbonyl group, more preferably an alkyl group, alkenyl group, amino group, hydroxyl group, alkoxy group, aryloxy group or acylamino group.

In the formulae (3-1) to (3-5), $Ma_1$ to $Ma_{21}$ each independently represent a methine group which may have

substituents. Preferred examples of these substituents include $C_1$-$C_{20}$ alkyl group (e.g., methyl, ethyl, i-propyl), halogen atom (e.g., chlorine, bromine, iodine, fluorine), nitro group, $C_7$-$C_{20}$ alkoxy group (e.g., methoxy, ethoxy), $C_6$-$C_{26}$ aryl group (e.g., phenyl, 2-naphthyl), $C_0$-$C_{20}$ heterocyclic group (e.g., 2-pyridyl, 3-pyridyl), $C_6$-$C_{20}$ aryloxy group (e.g., phenoxy, 1-naphthoxy, 2-naphthoxy), $C_1$-$C_{20}$ acylamino group (e.g., acetylamino, benzoylamino), $C_1$-$C_{20}$ carbamoyl group (e.g., N,N-dimethylcarbamoyl), sulfo group, hydroxyl group, carboxyl group, $C_1$-$C_{20}$ alkylthio group (e.g., methylthio), and cyano group. These substituents may form a ring with other methine groups or chromophores, preferably unsubstituted methine group, ethyl-substituted methine group or methyl-substituted methine group.

In the formulae (3-1), (3-2) and (3-5), $na^1$, $na^2$, $na^3$ and $na^5$ each independently represent 0 or 1, preferably 0.

In the formulae (3-4) and (3-5), $na^4$ and $na^6$ each independently represent an integer of from 0 to 5. When $na^4$ is 2 or more, the plurality of $Ra_4$'s may be the same or different and may be connected to each other to form a ring. The ring thus formed is preferably a benzene ring or pyridine ring. When $na^6$ is 2 or more, the plurality of $Ra_6$'s may be the same or different and may be connected to each other to form a ring. The ring thus formed is preferably a benzene ring or pyridine ring.

In the formulae (3-1) to (3-5), $ka^1$ to $ka^5$ each independently represent an integer of from 0 to 3, preferably an integer of 0 to 2. When $ka^1$ is 2 or more, the plurality of $Ma_3$'s and $Ma_4$'s may be the same or different. When $ka^2$ is 2 or more, the plurality of $Ma_{10}$'s and $Ma_{11}$'s may be the same or different. When $ka^3$ is 2 or more, the plurality of $Ma_{12}$'s and $Ma_{13}$'s may be the same or different. When $ka^4$ is 2 or more, the plurality of $Ma_{16}$'s and $Ma_{17}$'s may be the same or different. When $ka^5$ is 2 or more, the plurality of $Ma_{20}$'s and $Ma_{21}$'s may be the same or different.

The suffixes $ka^1$, $ka^2$, $ka^3$, $ka^4$ and $ka^5$ are preferably 0 or 1, from 0 to 2, 0 or 1, 0 or 1 and 1 or 2, respectively.

CI represents an ion that neutralizes electric charge. The suffix y represents the number of CI's required to neutralize electric charge.

The sensitizing dye represented by the formula (3-1) comprises a group represented by the formula (4) incorporated in any of $Ra_1$, $Ra_2$ and $Ma_3$ to $Ma_5$, preferably $Ra_1$ or $Ra_2$, the sensitizing dye represented by the formula (3-2) comprises a group represented by the following formula (4) incmpornted in any of $Ra_3$, $Ma_{10}$ and $Ma_{11}$, preferably $Ra_3$, the sensitizing dye represented by the formula (3-3) comprises a group represented by the following formula (4) incorporated in any of $Ma_{12}$ to $Ma_{14}$, the sensitizing dye represented by the formula (3-4) comprises a group represented by the following formula (4) incorporated in any of $Ra_4$, $Ma_{16}$ and $Ma_{17}$, and the sensitizing dye represented by the formula (3-5) comprises a group represented by the following formula (4) incorporated in any of $Ra_5$, $Ra_6$, $Ma_{20}$ and $Ma_{21}$, preferably $Ra_5$.

Formula (4)

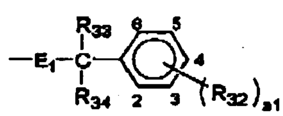

wherein $R_{32}$, $R_{33}$, $R_{34}$ and a1 are as defined in the formula (2); E1 represents -O-, -S- or -$NR_{31}$-, preferably -S-; and $R_{31}$ represents a hydrogen atom, alkyl group, alkenyl group, cycloalkyl group, aryl group or heterocyclic group.

The group represented by the formula (4) is more preferably represented by any of the following formulae (6-1) to (6-3).

(6-1) (6-2) (6-3)

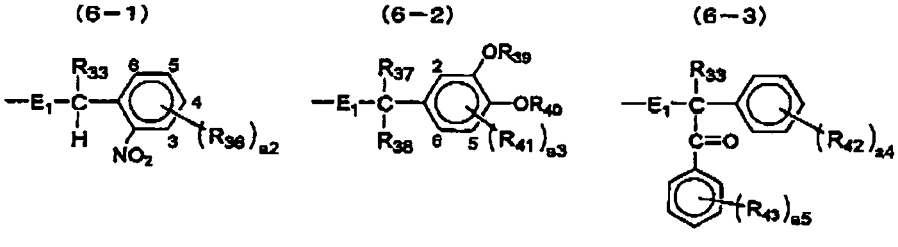

wherein El is as defined in the formula (4).

In the formula (6-1), $R_{35}$ represents a hydrogen atom, alkyl group or aryl group (Preferred examples of these groups include those listed above with reference to $R_{33}$), preferably hydrogen atom, methyl group or 2-nitrophenyl group. $R_{36}$ represents a substituent (Preferred examples of these groups include those listed above with reference to $R_{33}$), preferably alkyl group, alkenyl group, aryl group, alkinyl group, halogen atom, amino group, nitro group, alkoxy group, aryloxy group, alkylthio group, arylthio group, acylamino group, acyloxy group, carbamoyl group or alkoxycarbonyl group,

more preferably alkyl group, alkenyl group, aryl group, alkinyl group, halogen atom, amino group, nitro group, alkoxy group, aryloxy group, acyloxy group, acylamino group or acyloxy group, even more preferably nitro group or alkoxy group. The alkoxy group is more preferably a methoxy group.

The suffix a2 represents an integer of from 0 to 4, preferably from 0 to 2. When a2 is 2 or more, the plurality of $R_{36}$'s may be the same or different and may be connected to each other to form a ring. The ring thus formed is preferably a benzene ring or pyridine ring.

When $R_{36}$ is a nitro group, it is preferably on the 6-position. When $R_{36}$ is an alkoxy group, it is preferably on the 4- or 5-position.

In the formula (6-2), $R_{37}$ and $R_{38}$ each independently represent a hydrogen atom or alkyl group, preferably hydrogen atom or methyl group, and $R_{39}$ and $R_{40}$ each independently represent an alkyl group, preferably methyl group. $R_{41}$ represents a substituent (Preferred examples of these groups include those listed above with reference to $R_{36}$). The suffix a3 represents an integer of from 0 to 3, preferably 0 or 1. When a3 is 2 or more, the plurality of $R_{41}$'s may be same or different and may be connected to each other to form a ring. The ring thus formed is preferably a benzene ring or pyridine ring.

In the formula (6-3), $R_{42}$ and $R_{43}$ each independently represent a substituent (Preferred examples of these groups include those listed above with reference to $R_{36}$), preferably nitro group or alkoxy group, more preferably alkoxy group, most preferably methoxy group. The suffixes a4 and a5 each independently represent an integer of from 0 to 5, preferably from 0 to 2. When a4 is 2 or more, the plurality of $R_{42}$'s may be same or different and may be connected to each other to form a ring. The ring thus formed is preferably a benzene ring or pyridine ring,

When a5 is 2 or more, the plurality of $R_{43}$'s may be same or different and may be connected to each other to form a ring. The ring thus formed is preferably a benzene ring or pyridine ring.

The sensitizing dye represented by the formula (1) of the invention is preferably represented by any of the formulae (3-1), (3-2) and (3-4), more preferably any of the formulae (3-1) and (3-2), most preferably the formula (3-1).

The sensitizing dye represented by the formula (1) is more preferably represented by the following formula (7-1) or (7-2).

(7-1)

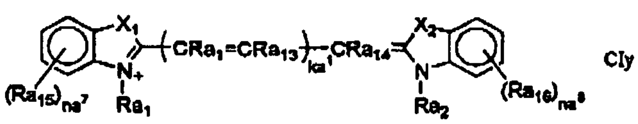

(7-2)

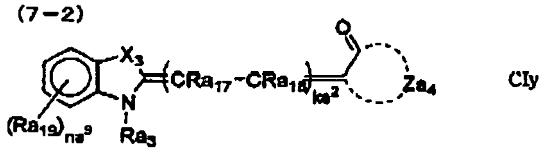

In the formulae (7-1) and (7-2), $Ra_1$ to $Ra_3$, $ka^1$, $ka^2$, $Za_4$, Cl and y are as defined in the formulae (3-1) and (3-2).

In the formulae (7-1) and (7-2), $X_1$ to $X_3$ each independently represent -O-, -S-, $-NR_{20}-$ or $-CRa_{21}R_{22}-$, preferably -O-, -S- or $-NR_{20}-$.

$R_{20}$ to $R_{22}$ each independently represent a hydrogen atom, alkyl group, alkenyl group, aryl group or heterocyclic group (Preferred examples of these groups include those listed above with reference to $Ra_1$), preferably hydrogen atom, alkyl group or aryl group, more preferably alkyl group. $X_1$ and $X_2$ each are more preferably -O-.

In the formulae (7-1) and (7-2), $Ra_{12}$ to $Ra_{14}$, $Ra_{17}$ and $Ra_{18}$ each independently represent a hydrogen atom, alkyl group, alkenyl group, aryl group, heterocyclic group, halogen atom, nitro group, alkoxy group, aryloxy group, acylamino group, carbamoyl group, hydroxyl group, alkylthio group or cyano group, preferably hydrogen atom, alkyl group, aryl group, heterocyclic group, halogen atom, alkoxy group or aryloxy group, more preferably hydrogen atom or alkyl group, even more preferably hydrogen atom, methyl group or ethyl group.

In the formulae (7-1) and (7-2), $Ra_{15}$, $Ra_{16}$ and $Ra_{19}$ each independently represent a substituent, preferably alkyl group, aryl group, heterocyclic group, halogen atom, alkoxy group, aryloxy group, alkylthio group, arylthio group, sulfamoyl group, carbamoyl group, acylamino group or alkoxycarbonyl group, more preferably alkyl group, aryl group, heterocyclic group, halogen atom or alkoxy group.

In the formulae (7-1) and (7-2), $na^7$ to $na^9$ each independently represent an integer of from 0 to 5, preferably from 0 to 2.

When $na^7$ is 2 or more, the plurality of $Ra_{15}$'s may be the same or different and may be connected to each other to form a ring. Preferred examples of the ring thus formed include benzene ring, benzofurane ring, pyridine ring, pyrrole ring, indole ring, and thiophene ring. When $na^8$ is 2 or more, the plurality of $Ra_{16}$'s may be the same or different and may be connected to each other to form a ring. Preferred examples of the ring thus formed include benzene ring, benzofurane ring, pyridine ring, pyrrole ring, indole ring, and thiophene ring.

When $na^9$ is 2 or more, the plurality of $Ra_{19}$'s may be the same or different and may be connected to each other to form a ring. Preferred examples of the ring thus formed include benzene ring, benzofurane ring, pyridine ring, pyrrole ring, indole ring, and thiophene ring.

when $ka^1$ is 2 or more, the plurality of $Ra_{12}$'s and $Ra_{13}$'s may be the same or different and when $ka^2$ is 2 or more, the plurality of $Ra_{17}$'s and $Ra_{18}$'s may be the same or different. The suffix $ka^1$ is preferably 0 or 1 and the suffix $ka^2$ is preferably from 0 to 2.

The sensitizing dye represented by the formula (7-1) comprises a group represented by the formula (4) incorporated in any of $Ra_1$, $Ra_2$ and $Ra_{12}$ to $Ra_{14}$, preferably $Ra_1$ or $Ra_2$ and the sensitizing dye represented by the formula (7-2) comprises a group represented by the formula (4) incorporated in any of $Ra_3$, $Ra_{17}$ and $Ra_{18}$, preferably $Ra_3$.

In the formula (7-1) or (7-2), the group represented by the formula (4) is more preferably represented by any of the formulae (6-1) to (6-3).

The sensitizing dye represented by the formula (1) is more preferably represented by the formula (7-1).

In the sensitizing dye represented by the formula (1), it is preferred that LP does not disconnect from E and discolor itself when irradiated with hologram recording light but disconnects from E and discolors itself when irradiated with light different from hologram recording light.

More preferably, the hologram recording/reproducing method comprises effecting hologram recording with a sensitizing dye represented by any of the formulae (1) and (3-1) to (3-5), and then irradiating entirely with light other than hologram recording light so that the compound represented by any of the formulae (1) and (3-1) to (3-5) is self-discolored and fixed, whereby reproduction can be effected by irradiating with the same light as hologram recording light without extinguishing recorded interference fringes developed by refractive index modulation.

The compounds represented by the following formulae (5-1) to (5-5) may be used for purposes other than hologram sensitizing dye, e.g., medicines, dyes, agricultural chemicals. However, these compounds are preferably used as optically self-discolorable dye, more preferably optically self-discolorable sensitizing dye particularly for photon mode recording material to be dry-processed As previously mentioned, these compounds are most preferably used as sensitizing dye for hologram recording material.

(5-1)

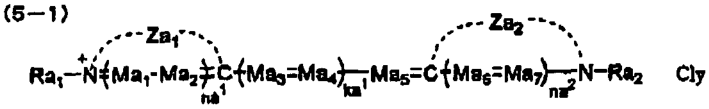

(5-2)

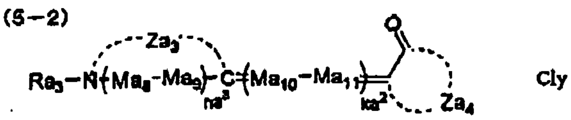

(5-3)

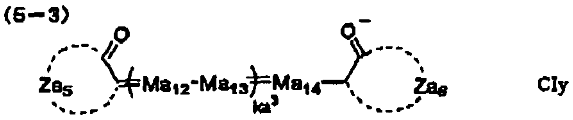

(5-4)

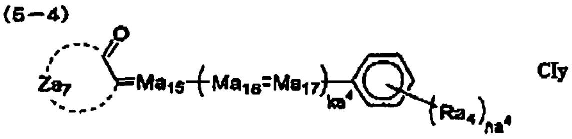

(5-5)

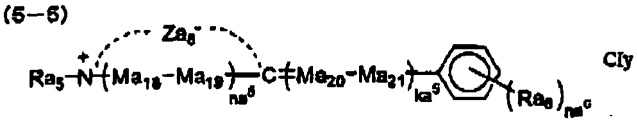

In the formulae (5-1) to (5-5), $Za_1$ to $Za_8$, $Ra_1$ to $Ra_6$, $Ma_1$ to $Ma_{21}$, $na^1$ to $na^6$, $ka^1$ to $ka^5$, Cl and y are as defined in the formulae (3-1) to (3-5).

The sensitizing dye represented by the formula (5-1) comprises a group represented by any of the following formulae (6-1) to (6-3) incorporated in any of $Ra_1$, $Ra_2$ and $Ma_3$ to $Ma_5$, the sensitizing dye represented by the formula (5-2) comprises a group represented any of the following formulae (6-1) to (6-3) incorporated in any of $Ra_3$, $Ma_{10}$ and $Ma_{11}$, the sensitizing dye represented by the formula (5-3) comprises a group represented any of the following formulae (6-1) to (6-3) incorporated in any of $Ma_{12}$ to $Ma_{14}$, the sensitizing dye represented by the formula (5-4) comprises a group represented any of the following formulae (6-1) to (6-3) incorporated in any of $Ra_4$, $Ma_{16}$ and $Ma_{17}$, and the sensitizing dye represented by the formula (5-5) comprises a group represented any of the following formulae (6-1) to (6-3) incorporated in any of $Ra_5$, $Ra_6$, $Ma_{20}$ and $Ma_{21}$.

The compounds represented by the formulae (5-1) to (5-5) of the invention each are preferably represented by any of the formulae (5-1), (5-2) and (5-4), more preferably the formula (5-1) or (5-2), even more preferably the formula (5-1).

The compounds represented by the formulae (5-1) to (5-5) of the invention each are preferably represented by the formula (7-1) or (7-2), more preferably the formula (7-1).

Specific examples of the sensitizing dye for hologram recording material represented by the formula (1) of the invention, the compound represented by the formulae (5-1) to (5-5), the discolorable dye of the invention, and the optically discolorable sensitizing dye of the invention will be given below, but the invention is not limited thereto.

<Cyanine dye>

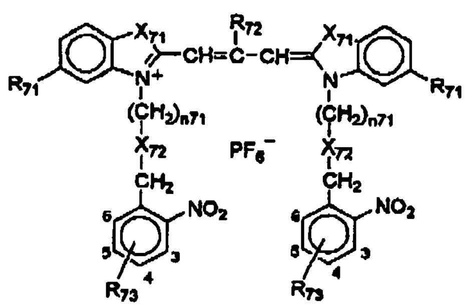

| | $X_{71}$ | $X_{72}$ | $R_{71}$ | $R_{72}$ | $R_{73}$ | n71 |
|---|---|---|---|---|---|---|
| S-1 | -O- | -S- | -H- | -H- | — | 2 |
| S-2 | " | " | " | " | — | 3 |
| S-3 | " | -O- | " | " | — | 2 |
| S-4 | " | -NH- | " | " | — | " |
| S-5 | " | -S- | " | " | 6-$NO_2$ | " |
| S-6 | " | " | " | " | 4-$OCH_5$, 5-$OCH_3$ | " |
| S-7 | " | " | " | -$C_2H_5$ | — | " |
| S-8 | " | " | -Cl- | -H- | — | " |
| S-9 | -S- | " | " | -$C_2H_5$ | — | " |
| S-10 | " | -$NCH_3$- | -Ph- | -H- | — | 3 |
| S-11 | —$N(C_2H_5)$— | —s— | —Cl— | " | — | 2 |
| S-12 | —$C(CH_3)_2$— | " | -H- | " | — | " |
| S-13 | " | —O— | " | " | — | " |

(continued)

| | $X_{71}$ | $X_{72}$ | $R_{71}$ | $R_{72}$ | $R_{73}$ | n71 |
|---|---|---|---|---|---|---|
| S-14 | -O- | -S- | —H— | " | 5-$N(CH_3)_2$ | " |
| S-15 | " | " | " | " | 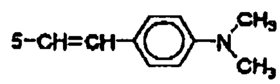 | " |
| S-16 | " | " | " | " | 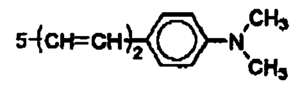 | " |
| S-17 | " | " | " | " | 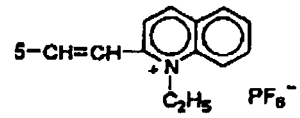 | " |
| S-18 | " | " | " | " | 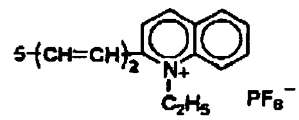 | " |

<Cyanine dye>

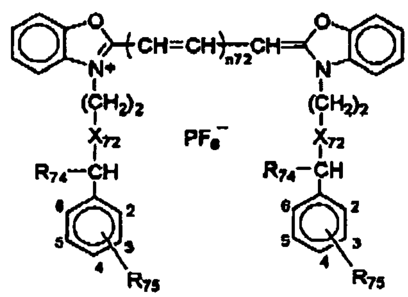

| | $X_{72}$ | $n_{72}$ | $R_{74}$ | $R_{75}$ |
|---|---|---|---|---|
| S-19 | -S- | 1 | $-CH_3$ | 3-$OCH_3$, 4-$OCH_3$ |
| S-20 | " | " | 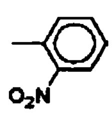 | 2-$NO_2$ |
| S-21 | " | " | 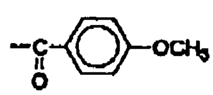 | 3-$OCH_3$, 5-$OCH_3$ |
| S-22 | -S- | 0 | -H- | 2-$NO_2$ |
| S-23 | " | " | " | 2-$NO_2$, 6-$NO_2$ |
| S-24 | " | " | " | 2-$NO_2$, 4-$OCH_3$, 5-$OCH_3$ |
| S-25 | " | " | " | 3-$OCH_3$, 4-$OCH_3$ |
| S-26 | -O- | " | " | 2-$NO_2$, 4-$OCH_3$, 5-$OCH_3$ |
| S-27 | —NH— | " | " | " |
| S-28 | " | " | " | 2-$NO_2$.5-$N(CH_3)_2$ |

(continued)

| | $X_{72}$ | $n_{72}$ | $R_{74}$ | $R_{75}$ |
|---|---|---|---|---|
| S-29 | " | " | " | 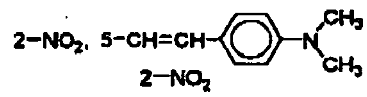 |
| S-30 | " | 2 | " | 2-$NO_2$ |

<Cyanine dye>

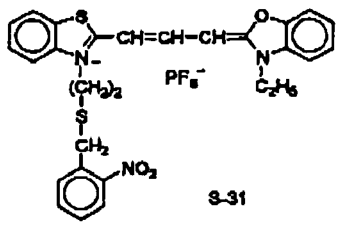

S-31

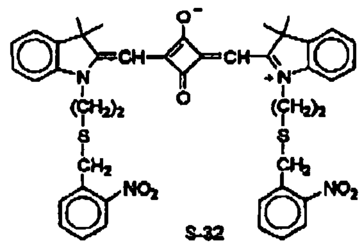

S-32

<Styryl dye>

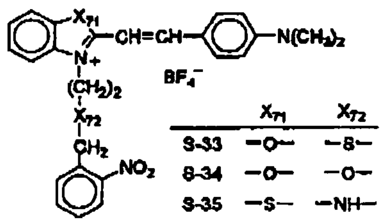

| | $X_{71}$ | $X_{72}$ |
|---|---|---|
| S-33 | -O- | -S- |
| S-34 | -O- | -O- |
| S-35 | -S- | -NH- |

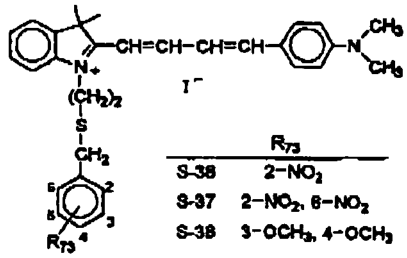

| | $R_{73}$ |
|---|---|
| S-36 | 2-$NO_2$ |
| S-37 | 2-$NO_2$, 6-$NO_2$ |
| S-38 | 3-$OCH_3$, 4-$OCH_3$ |

<Melocyanine dye>

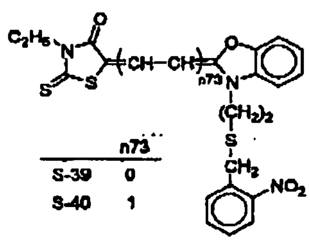

| | n73 |
|---|---|
| S-39 | 0 |
| S-40 | 1 |

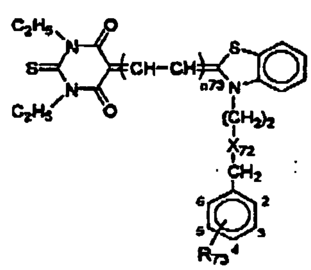

| | n73 | $X_{72}$ | $R_{73}$ |
|---|---|---|---|
| S-41 | 1 | -S- | 2-$NO_2$ |
| S-42 | 1 | " | 2-$NO_2$, 6-$NO_2$ |
| S-43 | 1 | " | 3-$OCH_3$, 4-$NO_2$ |
| S-44 | 1 | " | 2-$NO_2$, 5-$N(CH_3)_2$ |
| S-45 | 1 | " | 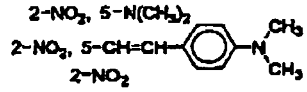 |
| S-46 | 1 | -O- | 2-$NO_2$ |
| S-47 | 2 | -S- | " |

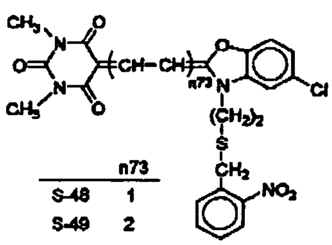

| | n73 |
|---|---|
| S-48 | 1 |
| S-49 | 2 |

<Melocyanine dye>

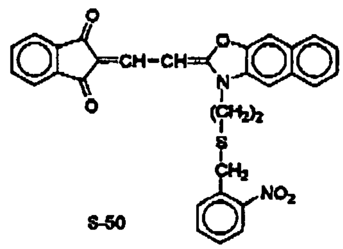

S-50

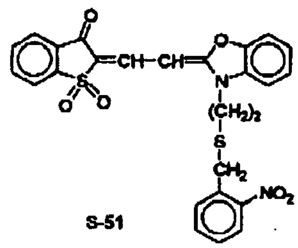

S-51

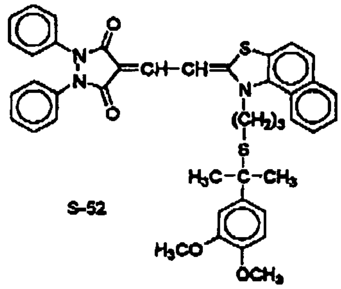

S-52

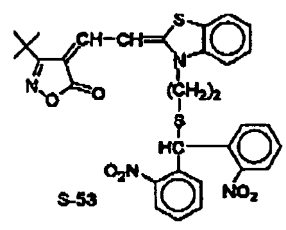

S-53

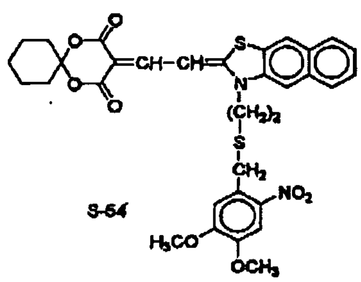

S-54

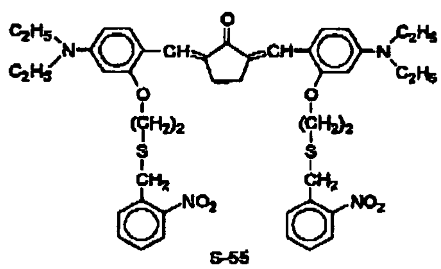

S-55

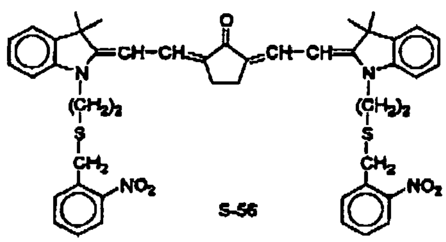

S-56

<Benzylidene dye>

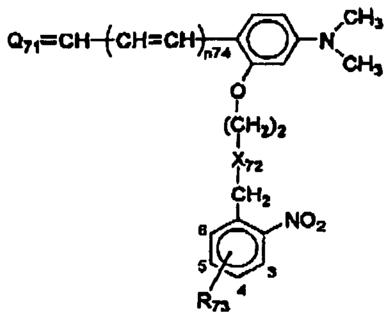

| | $Q_{71}$ | n74 | $X_{72}$ | $R_{73}$ |
|---|---|---|---|---|
| S-57 | 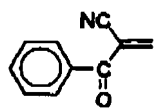 | 0 | —S— | — |
| S-58 | " | " | —O— | $6\text{-}NO_2$ |
| S-59 | 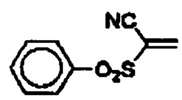 | " | —S— | — |
| S-60 | 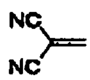 | " | " | — |
| S-61 | " | 1 | " | $4\text{-}OCH_3$, $5\text{-}OCH_3$ |
| S-62 | 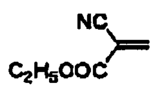 | 0 | " | — |
| S-63 | 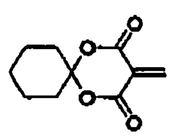 | 0 | " | — |
| S-64 | " | 1 | " | $6\text{-}NO_2$ |
| S-65 | 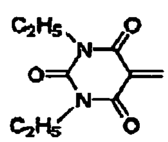 | 0 | " | — |
| S-68 | " | 1 | —NH— | — |
| S.67 | 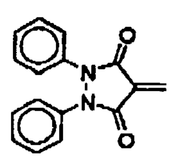 | 0 | —S— | — |

<Oxonol dye>

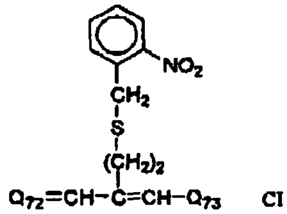

| | $Q_{72}$ | $C_{73}$ | Cl |
|---|---|---|---|
| S-68 | 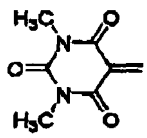 | 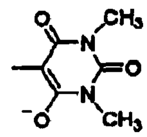 | $H^+$ |
| S-69 | 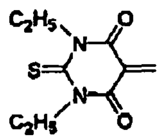 | 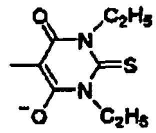 | 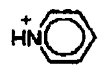 |
| S-70 | 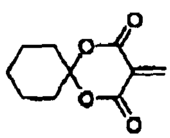 | 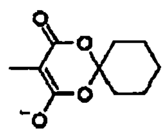 | $H^+$ |
| S-71 | 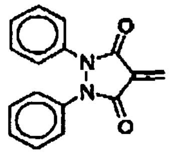 | 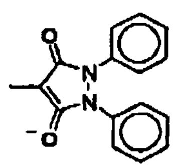 | $H^+$ |
| S-72 | 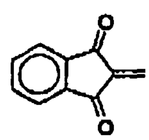 | 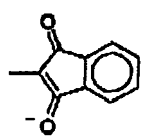 | $H\overset{+}{N}(C_2H_5)_3$ |
| S-72 | 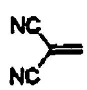 | 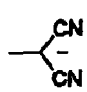 | $H^+$ |
| S73 | 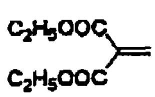 | 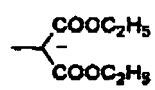 | $H^+$ |

In the case where a YAG laser second harmonic having a hologram recording wavelength of 532 nm is used, as the sensitizing dye, a trimethine cyanine dye having a benzooxazole ring is particularly preferred. In the case where a GaN or InGaN laser having a hologram recording wavelength of from 400 to 415 nm is used, a monomethine cyanine dye having a benzooxazole ring is particularly preferred.

A hologram recording method and hologram recording material of the invention will be further described hereinafter.

The hologram recording method of the invention preferably involves any of 1) polymerization reaction, 2) color development reaction, 3) latent image color development-coloring material self-sensitized amplification color development reaction, 4) latent image color development reaction-coloring material sensitizing polymerization reaction, 6) dye discoloration reaction and 7) remaining discolorable dye latent image-latent image sensitization polymerization reaction, preferably 2) color development reaction, 3) latent image color development-coloring material self-sensitized amplification color development reaction, 4) latent image color development reaction-coloring material sensitizing polymerization reaction, 6) dye discoloration reaction and 7) remaining discolorable dye latent image-latent image sensitization polymerization reaction, more preferably 2) color development reaction, 4) latent image color development reaction-coloring material sensitizing polymerization reaction, 6) dye discoloration reaction and 7) remaining discolorable dye latent image-latent image sensitization polymerization reaction, using a sensitizing dye represented by the formula (1) to record an interference fringes as refractive index modulation.

It is preferred that the hologram recording material of the invention be not subjected to wet process after hologram exposure.

The hologram recording material of the invention is preferably not of rewritable type. The term "not of rewritable type" as used herein is meant to indicate the type which causes irreversible reaction to perform recording. Once recorded, data can be stored without being rewritten even in an attempt to overwrite thereon. Thus, the hologram recording material of the invention is suitable for the storage of important data which are needed to be stored over an extended period of time. It goes without saying that data can be additionally recorded on unrecorded area. In this sense, this type of a recording material is called "write-once-read-many type" recording material.

The light to be used in the hologram recording method of the invention is preferably any of ultraviolet ray, visible light and infrared ray having a wavelength of from 200 to 2,000 nm, more preferably ultraviolet ray or visible light having a wavelength of from 300 to 700 nm, even more preferably visible light having a wavelength of from 400 to 700 nm.

The radiation to be used in the hologram recording method of the invention is preferably coherent laser beam (having uniform phase and wavelength). As the laser to be used herein there may be used any of solid laser, semiconductor laser, gas laser and liquid laser. Preferred examples of laser beam include YAG laser second harmonic having a wavelength of 532 nm, YAG laser third harmonic having a wavelength of 355 nm, semiconductor laser such as GaN laser or InGaN laser having a wavelength of from about 400 to 415 nm, semiconductor laser such as AlGaInP having a wavelength of about 650 nm to 660 nm, Ar ion laser having a wavelength of from 488 nm or 515 nm, He-Ne laser having a wavelength of 632 nm to 633 nm, Kr ion laser having a wavelength of 647 nm, ruby laser having a wavelength of 694 nm, and Ho-Cd laser having a wavelength of 636 nm, 634 nm, 538 nm, 534 nm and 442 nm.

Further, pulse laser on the order of nanosecond or picosecond is preferably used.

In the case where the hologram recording material of the invention is used as an optical recording medium, YAG laser second harmonic having a wavelength of 532 nm or semiconductor laser such as GaN laser or InGaN laser having a wavelength of from about 400 to 415 nm and AlGaInP laser having a wavelength of from about 650 to 660 nm is preferably used.

The wavelength of the light for use in hologram reproduction is preferably the same as or longer than, more preferably the same as that of the light for use in hologram exposure (recording).

The hologram recording material which has been subjected to hologram exposure may be fixed by either or both of light and heat. In the invention, however, fixing is preferably effected only by light, particularly light having a wavelength range that can be absorbed by LP in the sensitizing dye represented by the formula (1).

At the fixing step of the invention, it is preferred that the sensitizing dye represented by any of the formulae (1) and (3-1) to (3-5) be discolored so that it can no longer absorb hologram reproducing light, making it possible to obtain a high absolute diffraction efficiency and allowing reproduction without destroying recorded data even when irradiated with light during reproduction.

In the case of light fixing, the hologram recording material is entirely irradiated with ultraviolet ray or visible light (non-interference exposure). Preferred examples of the light employable herein include visible light laser, ultraviolet laser, carbon arc, high voltage mercury vapor lamp, xenon lamp, metal halide lamp, fluorescent lamp, tungsten lamp, LED, and organic EL.

In the case of heat fixing, fixing is preferably effect at a temperature of from 40˚C to 160˚C, more preferably from 60˚C to 130˚C.

In the case where both light fixing and heat fixing are effect, light and heat may be applied at the same time or separately.

The refractive index modulation during recording of interference fringes is preferably from 0.00001 to 0.5, more preferably from 0.0001 to 0.3. It is preferred that the more the thickness of the hologram recording material is, the less is the refractive index modulation. It is preferred that the less the thickness of the hologram recording material is, the more is the refractive index modulation.

The (relative) diffraction efficiency $\eta$ of a hologram recording material is given by the following equation:

$$\eta = Idiff/Io \quad \text{... (equation 1)}$$

where Io is the intensity of incident light; and Idiff is the intensity of light which is diffracted (transmitted type) or reflected (reflected type). The diffraction efficiency may range from 0% to 100%, preferably 30% or more, more preferably 60% or more, most preferably 80% or more.

The sensitivity of a hologram recording material is normally represented by exposure per unit area ($mJ/cm^2$). The less this value is, the higher is the sensitivity. The exposure at which the sensitivity is defined differs from literature or patent to literature or patent. In some cases, the exposure at which recording (refractive index modulation) begins is defined as sensitivity. In other cases, the exposure at which the maximum diffraction efficiency (refractive index modulation) is given is defined as sensitivity. In further cases, the exposure at which half the maximum diffraction efficiency is given is defined as sensitivity. In still further cases, the exposure at which the gradient of diffraction efficiency relative to exposure E becomes maximum is defined as sensitivity.

According to Kugelnick's theoretical equation, the refractive index modulation $\Delta n$ at which a certain diffraction efficiency is given is inversely proportional to the thickness d. In other words, the sensitivity at which a certain diffraction efficiency is given differs with thickness. Thus, the more the thickness d is, the less is the required refractive index modulation An. Accordingly, the sensitivity cannot be unequivocally compared unless the conditions such as thickness are uniform.

In the invention, sensitivity is defined by "exposure at which half the maximum diffraction efficiency is given ($mJ/cm^2$)". The sensitivity of the hologram recording material of the invention is preferably 2 $J/cm^2$ or less, more preferably 1 $J/cm^2$ or less, even more preferably 500 $mJ/cm^2$ or less, most preferably 200 $mJ/cm^2$ or less if the thickness is from about 10 $\mu$m to 200 $\mu$m.

In the case where the hologram recording material of the invention is used in holographic memory as an optical recording medium, it is preferred that many two-dimensional digital data (referred to as "signal light") be recorded using a spatial light modulation element (SLM) such as DMD and LCD. Recording is preferably accomplished by multiplexed recording to raise the recording density. Examples of multiplexed recording methods include angular multiplexed, phase multiplexed, wavelength multiplexed and shift multiplexed recording methods. Preferred among these multiplexed recording methods are angular multiplexed recording and shift multiplexed recording. In order to read reproduced three-dimensional data, CCD or CMOS is preferably used.

In the case where the hologram recording material of the invention is used in holographic memory as an optical recording medium, it is essential that multiplexed recording be effected to enhance the capacity (recording density). In this case, multiplexed recording involving preferably 10 or more times, more preferably 50 times or more, most preferably 100 times or more of recording jobs is performed. More preferably, any multiplexed recording can be effected always at a constant exposure to simplify recording system and enhance S/N ratio.

In the case where the hologram recording material of the invention is used as an optical recording medium, the hologram recording material is preferably stored in a light-shielding cartridge during storage. It is also preferred that the hologram recording material be provided with a light filter capable of cutting part of wavelength range of ultraviolet ray, visible light and infrared ray other than recording light and reproduced light on the surface or back surface or on the both surfaces thereof.

In the case where the hologram recording material of the invention is used as an optical recording medium, the optical recording medium may be in the form of disc, card or tape or in any other form.

The various hologram recording methods of the invention and various components of the hologram recording material allowing these recording methods will be further described hereinafter.

1) interference fringes recording by polymerization reaction

This recording process preferably involves the use of at least a sensitizing dye represented by any of the formulae (1) and (3-1) to (3-5), a polymerization initiator, a polymerizable compound and a binder wherein the polymerizable compound and the binder have different refractive indexes and allows the sensitizing dye to absorb light to cause photopolymerization which makes the composition ratio of the polymerizable compound to the binder different from the bright interference area to the dark interference area, whereby the recording of an interference fringes by refractive index modulation is effected.

When the sensitizing dyes represented by the formulae (1) and (3-1) to (3-5) of the invention are discolored and fixed by irradiating with light in a specific wavelength range after hologram recording, recorded data cannot be destroyed nor absorbed even upon irradiation with hologram reproducing light, making it possible to obtain a high absolute diffraction efficiency.

Referring to interference fringes recording involving polymerization reaction, the binder preferably has a refractive index different from that of the polymerizable compound. In order to enhance the refractive index modulation, it is preferred that the refractive index difference between the polymerizable compound and the binder in bulky form be great, more preferably 0.01 or more, even more preferably 0.05 or more, particularly 0.1 or more.

To this end, it is preferred that one of the polymerizable compound or the binder contain at least one aryl group, aromatic heterocyclic group, chlorine atom, bromine atom, iodine atom and sulfur atom and the other be free of these groups or atoms. Either the polymerizable compound or the binder may have a greater refractive index than the other.

The term "polymerizable compound" as used herein is meant to indicate a compound which can undergo addition polymerization with a radical, acid (Bronsted acid or Lewis acid) or base (Bronsted base or Lewis base) generated when the sensitizing dye (or coloring material) or polymerization initiator with light to form an oligomer or polymer.

The polymerizable compound of the invention may be monofunctional or polyfunedonal, may be of one-component system or multi-component system or may be a monomer, prepolymer (e.g., dimer, oligomer) or mixture thereof, preferably monomer.

The polymerizable compound may stay liquid or solid at room temperature but is preferably a liquid having a boiling point of 100˚C or more or a mixture of a liquid monomer having a boiling point of 100˚C or more and a solid monomer.

The polymerizable compound of the invention can be roughly divided into radical-polymerizable compound and cationically- or anioniocally-polymerizable compound.

Preferred examples of the radical-polymenzable compound and the cationically- or anioniocally- polymerizable compound will be described hereinafter in connection with the two groups: A) case where the refractive index of polymerizable compound is greater than that of binder and B) case where the refractive index of binder is greater than that of polymerizable compound. A) Preferred examples of radical-polymerizable compound having a greater refractive index than binder

In this case, the radical-polymerizable compound preferably has a high refractive index. The high refractive index radical-polymerizable compound of the invention is preferably a compound having at least one ethylenically-unsaturated double bond per molecule and at least one aryl group, aromatic heterocyclic group, chlorine atom, bromine atom, iodine atom or sulfur atom per molecule, more preferably a liquid having a boiling point of 100˚C or more.

Specific examples of the radical-polymerizable compound include the following monomers and prepolymers (dimer, oligomer) comprising these polymerizable monomers.

Preferred examples of the high refractive index radical-polymerizable monomer include styrene, 2-chlorostyrene, 2-bromostyrene, methoxystyrene, phenyl acrylate, p-chlorophenyl acrylate, 2-phenylethyl acrylate, 2-phenoxyethyl acrylate, 2-phenoxyethyl methacrylate, 2-(p-chlorophenoxy)ethyl acrylate, benzyl acrylate, 2-(l-naphthyloxy)ethyl acrylate, 2,2-di(p-hydroxyphenyl)propane diacrylate, 2,2-di(p-hydroxyphenyl)propane dimethacrylate, di(2-methacryloxyethyl)ether of bisphenol A, di(2-acryloxy ethyl)ether of bisphenol A, di(2-metbaayloxy)ether of tetrachloro-bisphenol A, di (2-methacryloxy)ether of tetrabromo-bisphenol A, 1,4-benzenediol dimethacrylate, and 1,4-diisopropenylbenzene. Even more desirable among these compounds are 2-phenoxyethyl acrylate, 2-phenoxyethyl methacrylate, 2-(p-chlorophenoxy)ethyl acrylate, p-chlorophenyl acrylate, phenyl acrylate, 2-phenylethyl acrylate, di(2-acryloxyethyl)ether of bisphenol A, and 2-(1-naphthyloxy)ethyl acrylate.

The preferred polymerizable compound is a liquid but may be used in admixture with a second solid polymerizable compound such as N-vinylcarbazole, 2-naphthyl acrylate, pentachlorophenyl acryatc, 2,4,6-tribromophenyl acrylate, disphenol A diacrylate, 2-(2-naphthyloxy)ethyl and N-phenylmaleimide. B) Preferred examples of radical-polymerizable compound having a smaller refractive index than binder

In this case, the radical-polymerizable compound preferably has a low refractive index. The low refractive index radical-polymerizable compound of the invention preferably has at least one ethylenically-unsaturated double bond per molecule but is free of aryl, group, aromatic heterocyclic group, chlorine atom, bromine atom, iodine atom and sulfur atom.

The radical-polymerizable compound of the invention is preferably a liquid having a boiling point of 100˚C or more.

Specific examples of the radical-polymerizable compound of the invention include the following polymerizable monomers and prepolymers (dimer, oligomer, etc.) comprising these polymerizable monomers.

Preferred examples of the low refractive index radical-polymerizable compound employable herein include t-butyl acrylate, cyclohexyl acrylate, isobornyl acrylate, 1,5-pentanediol diacrylate, ethylene glycol diacrylate, 1,4-butanediol diacrylate, diethylene glycol diacrylate, hexamethylene glycol diacrylate, 1,3-propanediol diacrylate, decamethylene glycol diacrylate, 1,4-cyclohexyldiol diacrylate, 2,2-dimethylolpropane diacrylate, glycerol diacrylate, trimethylolpropane diacrylate, pentacrythritol triacrylate, pentaerythritol tetraacrylate, triethylene glycol diacrylate, triethylene glycol dimethacrylate, ethylene glycol dimethacrylate, 1,3-propanediol dimethacrylate, 1,2,4-butanetriol trimethacrylate, 2,2,4-trimethyl-1.3-propanediol dimethacrylate, pentaerythritol trimethacrylate, pentaerythritol tetramethacrylate, trimethylolpropane trimethacrylate. 1,5-pentanediol dimethacrylate, diallyl fumarate, 1H,1H-perflurooctyl acrylate, 1H,1H, 2H,2H-perfluorooctyl methacrylate. 1H,1H, 2H,2H-perfluorooctyl acrylate, and 1-vinyl-2-pyrrolidone. More desirable among these low refractive index radical-polymerizable compounds are decanediol diacrylate, isobornyl acrylate, triethylene glycol diacrylate, diethylene glycol diacrylate, triethylene glycol diemethacrylate, ethoxyethoxy acrylate, triacrylate ester of

ethoxylated trimethylopropane, and 1-vinyl-2-pyrrolidine. Even more desirable among these low refractive index radical-polymerizable compounds are decanediol diacrylate, isobornyl acrylate, triethylene glycol diacrylate, diethylene glycol diacrylate, triethylene glycol diemethacrylate, ethoxyethoxy acrylate, 1H,1H-perflurooctyl acrylate, 1H,1H,2H,2H-perfluorooctyl methacrylate, 1H,1H, 2H,2H-perfluorooctyl acrylate, and 1-vinyl-2-pyrrolidone.

The preferred polymerizable compound is a liquid but may be used in admixture with a second solid polymerizable compound monomer such as N-vinylcaprolactam.

The term "cationically-polymerizable compound" as used herein is meant to indicate a compound which begins polymerization with an acid generated when the sensitizing dye and the cation polymerization initiator are irradiated with light. The term "anionically-polymerizable compound" as used herein is meant to indicate a compound which begins polymerization with a base generated when the sensitizing dye and the anion polymerization initiator are irradiated with light.

The cationically-polymerizable compound of the invention is preferably a compound having at least one oxirane ring, oxethanone ring, vinylether group or N-vinylcarbazole moiety, more preferably N-vinylcarbazole moiety per molecule.

The anionically-polymerizable compound of the invention is preferably a compound having at least one oxirane ring, oxethanone ring, vinylether group, N-vinyl carbazole moiety, ethylenic double bond moiety provided with an electrophilic substituent, lactone moiety, lactam moiety, cyclic urethane moiety, cyclic urea moiety or cyclic siloxane moiety per molecule, more preferably oxiranc ring moiety.

A) Preferred examples of cationically- or anionically- polymerizable compound having a greater refractive index than binder

In this case, the cationically- or anionically- polymerizable compound preferably has a high refractive index. The high refractive index cadonically- or anionically-polymerizable compound of the invention is preferably a compound having at least one oxirane ring, oxethanone ring, vinylether group or N-vinylcarbazole moiety per molecule and at least aryl group, aromatic heterocyclic group, chlorine atom, bromine atom, iodine atom or sulfur atom per molecule, more preferably at least one aryl group. The cationically- or anionically- polymerizable compound of the invention is preferably a liquid having a boiling point of 100˚C or more.

Specific examples of the cationically- or anionically-polymerizable compound of the invention include the following polymerizable monomers and prepolymers (dimer, oligomer, etc.) comprising these polymerizable monomers.

Preferred examples of the high refractive index cationically- or anionically-polymenzable monomers having oxirane ring include phenylglycidyl ether, phthalic acid diglycidyl ester, trimellitic acid triglycidyl ester, resorcine diglycidyl ether, dibromophenyl glycidyl ether, dibromoneopentyl glycol diglycidyl ether, 4,4'-bis(2,3-epoxypropoxyperfluoro isopropyl)diphenyl ether, p-bromostyrene oxide, bisphenol-A-diglycidyl ether, tetrabromobisphenol-A-diglycidyl ether, bisphenal-F-diglycidyl ether, and 1,3-bis(3',4'-epoxycyclohexyl)ethyl)-1,3,-diphenyl-1,3,-dimethyldisiloxane.

Specific examples of the high refractive index cation or anionically-polymerizable monomer having oxethanone ring include compounds obtained by replacing the oxirane ring in the specific examples of the high refractive index cation or anionically-polymerizable monomer having oxirane ring by oxethanone ring.

Specific examples of the high refractive index cationically- or anionically-polymerizable monomer having vinylether group moiety include vinyl-2-chloroethyl ether, 4-vinyletherstyrene, hydroquinone divinyl ether, phenylvinyl ether, bisphenol A divinyl ether, tetrabromobisphenol A divinyl ether, bisphenol F divinyl ether, phenoxyethylenevinyl ether, and p-bromophenoxycthylenevinyl ether.

Further preferred examples of the high refractive index cationically-polymerizable monomer include styrene-based monomers such as styrene, 2-chlorostyrene, 2-bromostyrene and methoxystyrene and N-vinylcarbazole.

B) Preferred examples of cationically- or anionically- polymerizable compound having a smaller refractive index than binder

In this case, the cationically- or anionically- polymerizable compound preferably has a low refractive index. The low refractive index cationically- or anionically-polymerizable compound of the invention is preferably a compound having at least one oxirane ring, oxethanone ring, vinylether group or N-vinylcarbazole moiety per molecule but free of aryl group, aromatic heterocyclic group, chlorine atom, bromine atom, iodine atom and sulfur atom. The cationically- or anionically-polymerizable compound of the invention is preferably a liquid having a boiling point of 100˚C or more.

Specific examples of the cationically- or anionically-polymerizable compound of the invention include the following polymerizable monomers and prepolymers (dimer, oligomer, etc.) comprising these polymerizable monomers.

Specific examples of the low refractive index cationically- or anionically-polymerizable monomer having oxirane ring include glyceroldiglycidyl ether, glyceroltriglycidyl ether, pentaerythritol polyglycidyl ether, trimethylolpropanctriglycidyl ether, 1,6-hexanediolglycidyl ether, ethylene glycol diglycidyl ether, ethylene glycol monoglycidyl ether, propylene

glycol diglycidyl ether, neopentyl glycol diglycidyl ether, adipic acid diglycidyl ester, 1,2,7,8-dicpoxyoctane, 1,6-dimethylolperfluorohexane diglycidyl ether, vinyl cyclohexene dioxide, 3,4-epoxycyclohexylmethyl-3',4'-epoxycyclohexane carboxylate, 3,4-epoxycyclohexyloxirane, bis(3,4-epoxycyclohexyl)adipate, 2,2-bis(4-(2,3-epoxypropoxy) cyclohexyl)propane, 2,2-bis(4-(2,3-epoxypropoxy)cyclohexyl)hexafluoropropane, 2-(3,4-epoxycyclohexyl)-3',4'-epoxy-1,3-dioxane-5-spirocyclohexane, 1,2-ethylenedioxy-bis(3,4-epoxycyclohexylmethane), ethyleneglycol-bis(3,4-epoxycyclohexanerboxylate), bis-(3,4-epoxycyclohexylmethyl)adipate, di-2,3-epoxycyelapentyl ether, vinyl glycidyl ether, allyl glycidyl ether, 2-ethylhexyl glycidyl ether, and 1,3-bis(3',4'-epoxycyclohexyl)ethy)-1,1,3,3-tetra,methyldisiloxane.

Specific examples of the low refractive index cationically- or anionically-polymerizable monomer having oxathanone ring include compounds obtained by replacing the oxirane ring in the aforementioned specific examples of low refractive index cationically- or anionically-polymerizable monomer having oxirane ring by oxethanone ring.

Specific examples of the low refractive index cationically- or anionically-polymerizable monomer having vinylether group moiety include vinyl-n-butylether, vinyl-t-butylether, ethylene glycol divinyl ether, ethylene glycol monovinyl ether, propylene glycol divinyl ether, neopentyl glycol divinyl glycol, glycerol divinyl ether, glycerol trivinyl ether, trietbylene glycol divinyl ether, trimethylol propane monovinyl ether, trimethylol propane divinyl ether, trimethylol propane trivinyl ether, allyl vinyl ether, 2,2-bis(4-cyclohexanol)propanol divinyl ether, and 2,2-bis(4-cyclohexanol)trifluoropropane divinyl ether.

Specific preferred examples of the binder to be used in recording of interference fringes by polymerization reaction will be described hereinafter in connection with the two groups: A) case where the refractive index of polymerizable compound is greater than that of binder and B) case where the refractive index of binder is greater than that of polymerizable compound.

A) Preferred examples of binder having a smaller refractive index than polymerizable compound

In this case, the binder preferably has a low refractive index. The binder of the invention is preferably a binder free of aryl group, aromatic heterocyclic group, chlorine atom, bromine atom, iodine atom and sulfur atom.

Specific preferred examples of the low refractive index binder include acrylates, $\alpha$-alkyl acrylates, acidic polymers, interpolymers (e.g., polymethacrylic acid methyl, polymethacrylic acid ethyl, copolymer of methyl methacylate with other (meth)acrylic acid akylesters), polyvinylesters (e.g., polyvinyl acetate, polyacetic acid/acrylic acid vinyl, polyacetic acid/methacrylic acid vinyl, hydrolyzable polyvinyl acetate), ethylene/vinyl acetate copolymers, saturated and unsaturated polyurethanes, butadiene polymers and copolymers, isoprene polymers and copolymers, high molecular polyethylene oxides of polyglycol having an average molecular weight of from about 4,000 to 1,000,000, epoxy compounds (e.g., epoxylated compounds having acrylate or methacrylate), polyamides (e.g., N-methoxy methylpolyhexamethylene adipamide), cellulose esters (e.g., cellulose acetate, cellulose acetate succinate, cellulose acetate butyrate), cellulose ethers (e.g., methyl cellulose, ethyl cellulose, ethylbenzeyl cellulose), polycarbonates, polyvinyl acetals (e.g., polyvinyl butyral, polyvinyl formal), polyvinyl alcohols, and polyvinyl pyrrolidones.

Further preferred examples of the low refractive index binder include fluorine atom-containing polymers. A preferred example of the fluorine atom-containing polymers is an organic solvent-soluble polymer comprising a fluoroolefin as an essential component and one or more unsaturated monomers selected from the group consisting of alkylvinyl ether, alicyclic vinyl ether, hydroxyvinyl ether, olefin, haloolefin, unsaturated carboxylic acid, ester thereof and carboxylic acid vinyl ester as copolymerizable components. The fluorine atom-containing polymer preferably has a weight-average molecular weight of from 5,000 to 200,000 and a fluorine atom content of from 5 to 70% by weight.

Specific examples of the aforementioned fluorine atom-containing polymer include Lumiflon Series (e.g., Lumiflon LF200; weight-average molecular weight: approx. 50,000, produced by Asahi Glass Co., Ltd.), which are organic solveat-soluble fluorine atom-containing polymers having hydroxyl group. Besides these products, organic solvent-soluble fluorine atom-containing polymers have been marketed by DAIKIN INDUSTRIES, LTD., Central Glass Co., Ltd., Penwalt Corp., etc. These products, too, can be used.

Further preferred examples of the fluorine atom-containing polymer include silicon compounds such as pioly (dimethylsiloxane) and silicon oil free of aromatic group.

Besides the aforementioned compounds, epoxy oligomer compounds free of aromatic groups can be used as low refractive index reactive binders.

B) Preferred examples of binder having a greater refractive index than polymerizable compound

In this case, the binder preferably has a high refractive index. The binder of the invention is preferably a binder containing at least one aryl group, aromatic heterocyclic group, chlorine atom, bromine atom, iodine atom or sulfur atom, more preferably aryl group.

Specific preferred examples of the high refractive index binder include polystyrene polymers, acrylonitrile, maleic anhydride, acrylic acid, methacrylic acid, methacrylic acid ester copolymer, vinylidene chloride copolymer (e.g.,

vinylidene chloride/acrylonitrile copolymer, vinylidene chloride/methacrylate copolymer, vinylidene/vinyl acetate copolymer), polyvinyl chloride copolymer (e.g., polyvinyl chloride/acetate, vinyl chloride/acrylonitrile copolymer), polyvinyl benzal synthetic rubber (e.g., butadiene/acrylonitrile copolymer, acrylonitrile/butadiene/styrene copolymer, methacrylate/acrylonitrile/butadiene/styrene copolymer, 2-chlorobutadiene-1,3-polymer, chlorinated rubber, styrene/butadiene/styrene, styrene/isoprene/styrene block copolymer), polymethylene glycol of copolyester (represented, e.g., by the formula $HO(CHV_2)_nOH$ (in which n is an integer of from 2 to 10), those produced from the reaction product of (I) hexahydroterephthalic acid, sebacic acid and terephthalic acid, (2) terephthalic acid, isophthalic acid and sebacic acid, (3) terephthalic acid and sebacic acid, (4) terephthalic acid and isophthalic acid, (5) the glycol and mixture of copolyesters produced from (i) terephthalic acid, isophthalic acid and sebacic acid and (ii) terephthalic acid, isophthalic acid, sebacic acid and adipic acid, poly-N-vinylcarbazole, copolymer thereof, and polycarbonate made of carboxylic acid ester and bisphenol.

Further preferred examples of the high refractive index binder include silicon compounds such as poly (methylphenylsiloxane) and 1,3,5 trimethyl-1,1,3,5,5-pentaphenyltrisiloxane and silicon oil containing much aromatic groups.

Besides these compounds, epoxy oligomer compounds containing much aromatic groups can be used as high refractive index reactive binder.

Preferred examples of the polymerization initiator to be used interference fringes recording involving polymerization reaction of the invention include ketone-based, organic peroxide-based, trihalomethyl-substituted triazine-based, diazonium salt-based, diaryl iodonium salt-based, sulfonium salt-based, borate-based, diaryl iodonium-organic boron complex-based, sulfonium-organic boron complex-based, cationic sensitizing dye-organic boron complex-based, anionic sensitizing dye-onium salt complex-based, metal-allene complex-based and sulfonic acid ester-based radical polymerization initiators (radical generators), cationic polymerization initiators (acid generators) and radical polymerization-cationic polymerization initiators.

In this case, an acid proliferator is preferably used to enhance sensitivity. Preferred examples of the acid proliferator employable herein include those exemplified in Japanese Patent Application No. 2003-182849.

Further, an anionic polymerization initiator and a base generator (base generator) is preferably used. Moreover, in this case, a base proliferator is preferably used to enhance sensitivity. Specific preferred examples of the anionic polymerization initiator and base proliferator include those exemplified in Japanese Patent Application No. 2003-178083.

Specific preferred examples of the polymerization initiator, polymerization compound and binder of the invention include those exemplified in Japanese Patent Application No. 2004-238392.

Specific preferred examples of the polymerization initiator of the invention will be given below, but the invention is not limited thereto.

<Radical polymerization initiator (radical generator), cationic polymerization initiator (acid generator)>

I-1

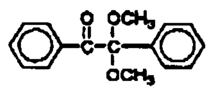

I-2

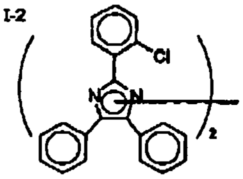

I-3

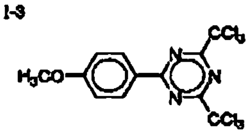

I-4

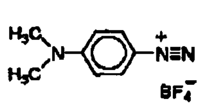

I-5

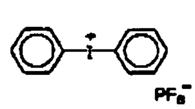

I-6

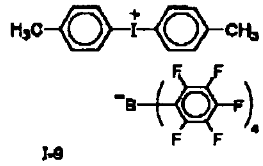

I-7

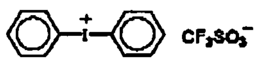

I-8

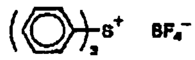

I-9

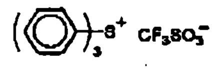

I-10

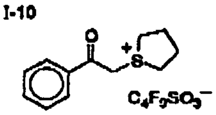

I-11

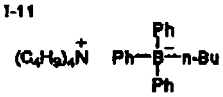

I-12

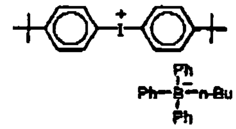

I-13

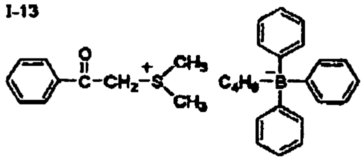

I-14

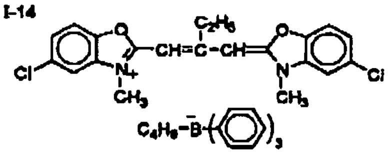

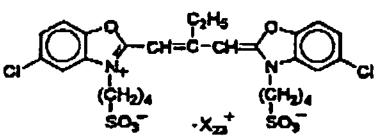

| | $X_{23}^{+}$ | |
|---|---|---|
| I-15 | 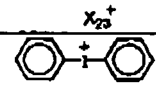 | (=C-1) |
| I-16 | 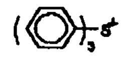 | (=C-2) |
| I-17 | 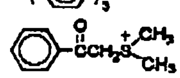 | (=C-3) |

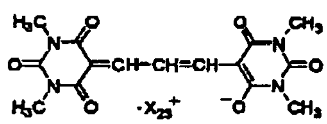

| | $X_{23}^{+}$ |
|---|---|
| I-18 | C-1 |
| I-19 | C-2 |
| I-20 | C-3 |

I-21

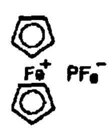

I-22

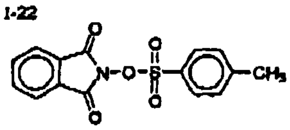

I-23

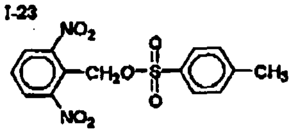

Anionic polymerization initiator (base generator)

PB-1

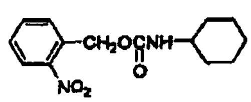

PB-2

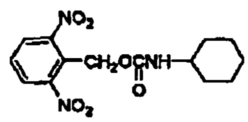

PB-3

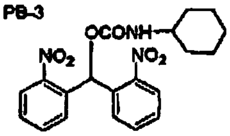

PB-4

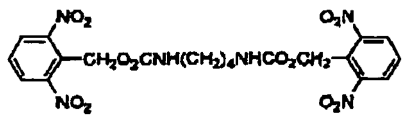

PB-5

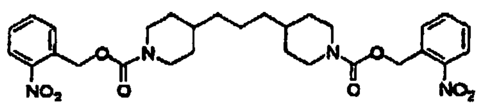

PB-6

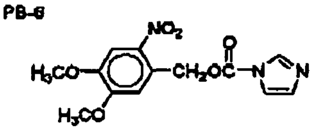

PB-7

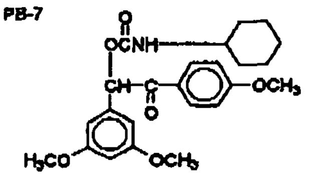

PB-8

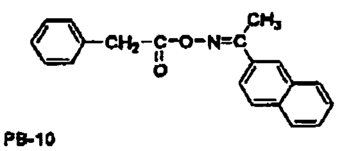

PB-9

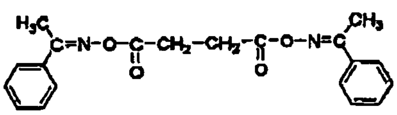

PB-10

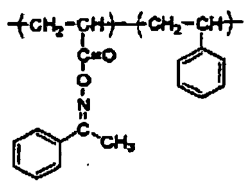

PB-11

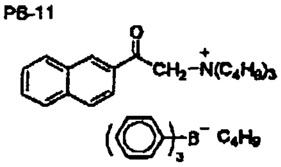

PB-12

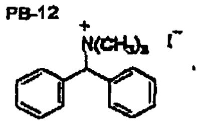

2) Recording of interference fringes by color development reaction

The term "color development reaction" as used herein is meant to indicate a reaction involving the change of absorption spectrum form or preferably either or both of the shift of λmax to longer wavelength and rise of ε in absorption spectrum in the range of ultraviolet ray, visible light and infrared ray having a wavelength of from 200 mn to 2,000 nm. The color development reaction preferably occurs at a wavelength of from 200 nm to 1,000 nm, more preferably from 300 nm to 900 nm

In the case where recording involves color development reaction, the hologram recording material of the invention preferably contains at least:

1) A sensitizing dye represented by any of the formulae (1) and (3-1) to (3-5) which absorbs light upon hologram exposure to generate excited state; and
2) An interference fringe-recording component containing a dye precursor which can form a coloring material that has absorption at longer wavelength than in the original state (i.e., the dye precursor) and no absorption at hologram reproducing light wavelength, which interference fringe-recording component can undergo electron or energy transfer from excited state of sensitizing dye to cause color development leading to refractive index modulation by which an interference fringes is recorded.

When the sensitizing dyes represented by the formulae (1) and (3-1) to (3-5) of the invention are discolored and fixed by irradiating with light in a specific wavelength range after hologram recording, recorded data cannot be destroyed nor absorbed even upon irradiation with hologram reproducing light, making it possible to obtain a high absolute diffraction efficiency.

The refractive index of the dye rises in the range of from close to linear absorption maxima wavelength (λmax) to wavelength longer than linear absorption maxima wavelength (λmax), rises drastically in the range of from λmax to

wavelength about 200 nm longer than λmax. In this wavelength range, some dyes show a refractive index of more than 1.8, as high as more than 2 in some cases. On the other hand, organic compounds which are not a dye, such as binder polymer, normally have a refractive index of from about 1.4 to 1.6.

It is thus made obvious that the color development of the dye precursor by hologram exposure makes it possible to fairly make not only a difference in absorbance but also a great difference in refractive index.

In the hologram recording material of the invention, the refractive index of the dye formed by the recording component preferably reaches maximum in the vicinity of laser wavelength at which reproduction is effected.

Preferred examples of the sensitizing dye include those exemplified above.

Preferred examples of the interference fringe-recording component include the following combinations. Specific preferred examples of these combinations include those described in Japanese Patent Application No. 2004-238077.

i) Combination of at least an acid-colorable dye precursor as dye precursor, an acid generator and optionally an acid proliferator

As the acid generator there may be used a diaryl iodonium salt, sulfonium salt or sulfonic acid ester, preferably the aforementioned acid generator (cationic polymerization initiator).

Preferred examples of the coloring material produced from the acid-colorable dye precursor include xanthene dyes, fluorane dyes, and triphenylmethane dyes. Particularly preferred examples of the acid-colorable dye precursor will be given below, but the invention is not limited thereto.

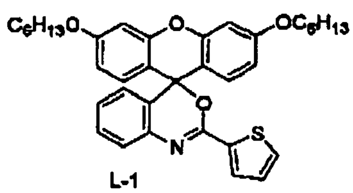

L-1

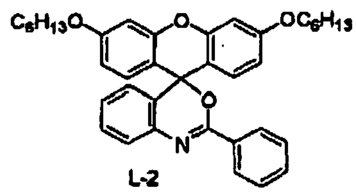

L-2

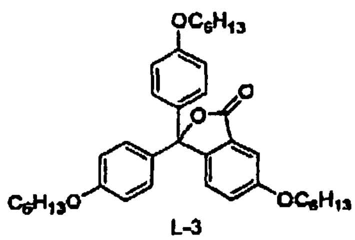

L-3

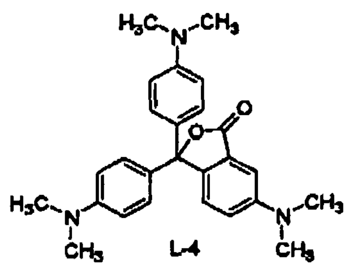

L-4

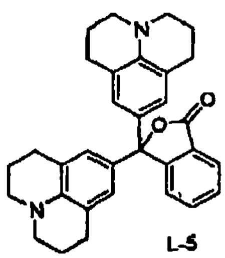

L-5

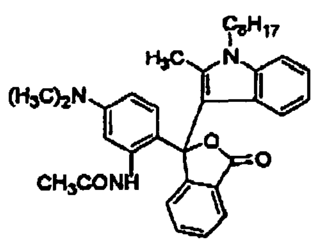

L-6

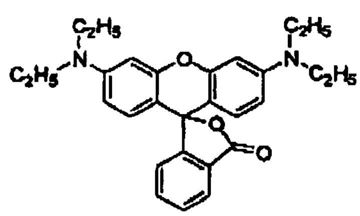

L-7

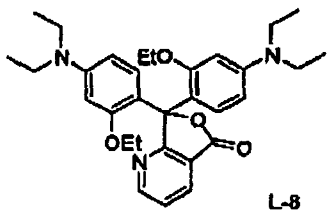

L-8

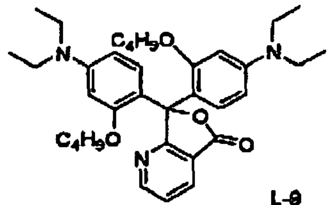

L-9

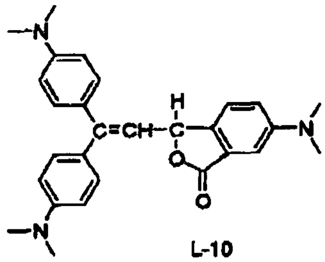

L-10

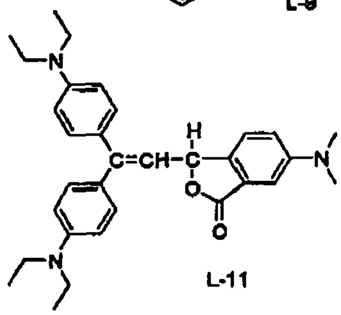

L-11

As the acid generation type dye precursor of the invention there is preferably used a cyanine base (leucocyanine dye) which develops color when an acid (proton) is added thereto. Specific preferred examples of the cyanine base will be given below, but the invention is not limited thereto.

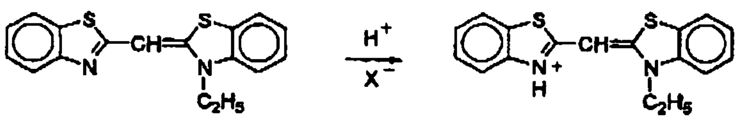


Cyanine base (Leucocyanine dye), colorless

Cyanine dye (yellow)

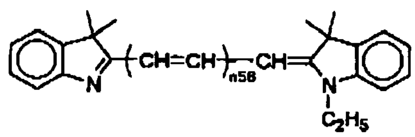

| | $n_{56}$ |
|---|---|
| LC-1 | 0 |
| LC-2 | 1 |
| LC-3 | 2 |

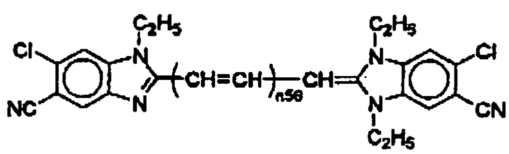

| | $n_{56}$ |
|---|---|
| LC-4 | 0 |
| LC-5 | 1 |
| LC-6 | 2 |

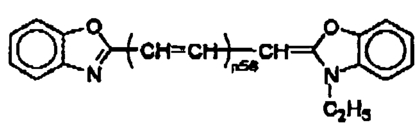

| | $n_{56}$ |
|---|---|
| LC-7 | 0 |
| LC-8 | 1 |

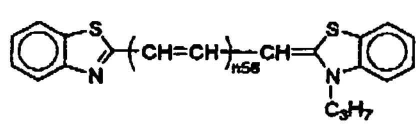

| | $n_{56}$ |
|---|---|
| LC-9 | 0 |
| LC-10 | 1 |

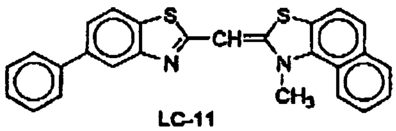

LC-11

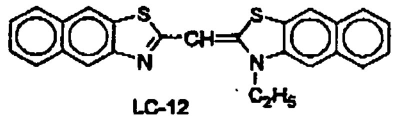

LC-12

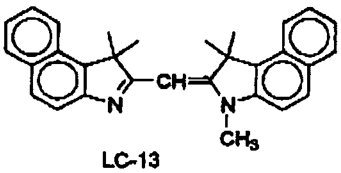

LC-13

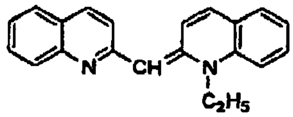

LC-14

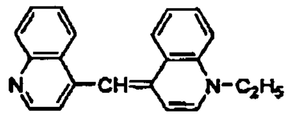

LC-15

ii) Combination of at least a base-colorable dye precursor as dye precursor, a base generator and optionally a base proliferator

As the base generator there is preferably used the aforementioned base generator (anionic polymerization initiator). Examples of the base-colorable dye precursor include dissociative azo dyes, dissociative azomethine dyes, dissociative oxonol dyes, dissociative xanthene dyes, dissociative fluorane dyes and dissociative triphenylmethane dyes in undissociated form.

Particularly preferred examples of the base-colorable dye precursor will be given below, but the invention is not limited thereto.

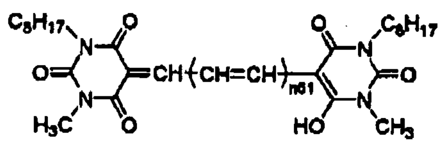

| | n61 |
|---|---|
| DD-1 | 1 |
| DD-2 | 2 |
| DD-3 | 3 |

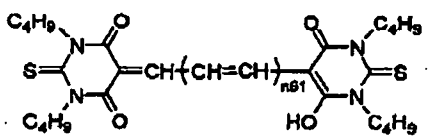

| | n61 |
|---|---|
| DD-4 | 0 |
| DD-5 | 1 |
| DD-6 | 2 |

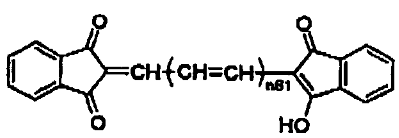

| | n61 |
|---|---|
| DD-7 | 0 |
| DD-8 | 1 |
| DD-9 | 2 |

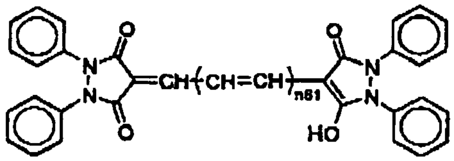

| | n61 |
|---|---|
| DD-10 | 0 |
| DD-11 | 2 |
| DD-12 | 3 |

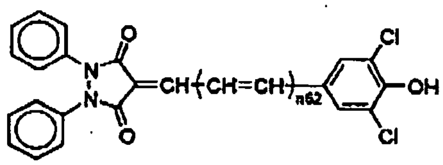

| | n62 |
|---|---|
| DD-13 | 0 |
| DD-14 | 1 |

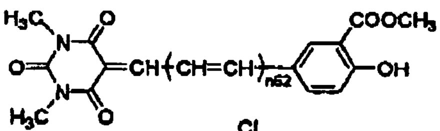

| | n62 |
|---|---|
| DD-15 | 0 |
| DD-16 | 1 |

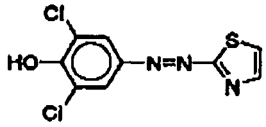

DD-17

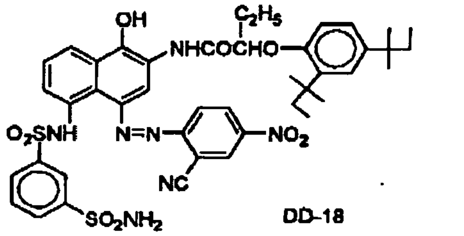

DD-18

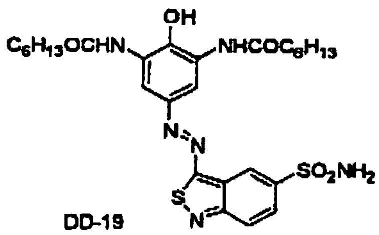

DD-19

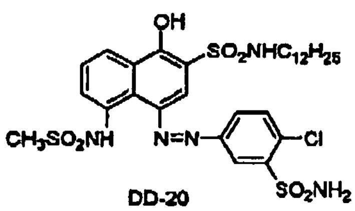

DD-20

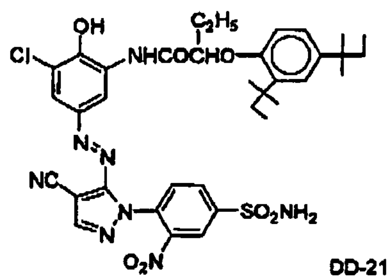

DD-21

DD-22

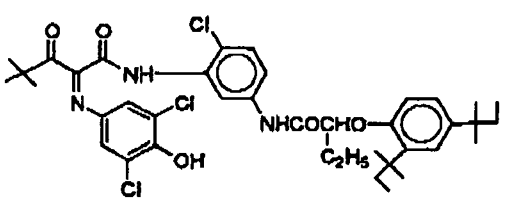

DD-23

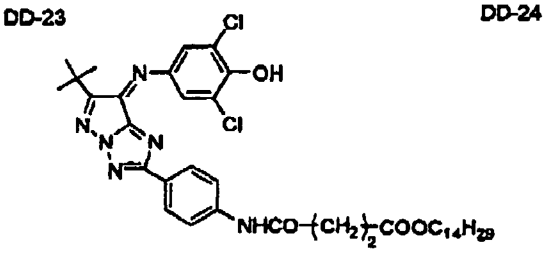

DD-24

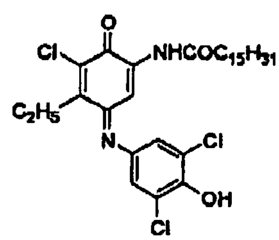

DD-25

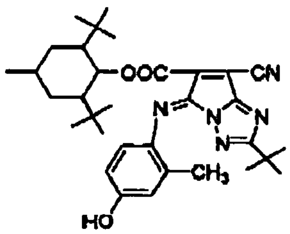

DD-26

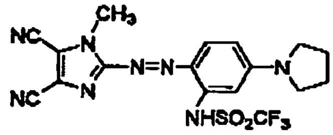

DD-27

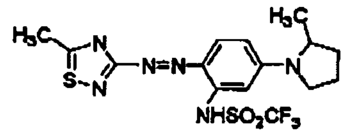

DD-28

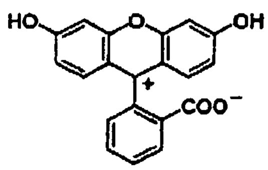

DD-29

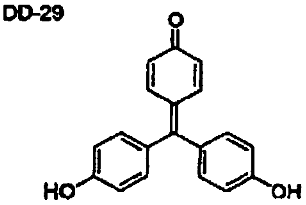

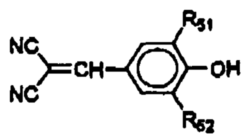

| | $R_{51}$ | $R_{52}$ |
|---|---|---|
| DD-30 | $-H$ | $-H$ |
| DD-31 | $-Cl$ | $-H$ |
| DD-32 | $-Cl$ | $-Cl$ |

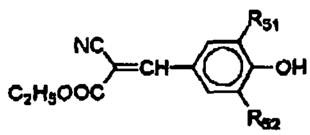

| | $R_{51}$ | $R_{52}$ |
|---|---|---|
| DD-33 | $-H$ | $-H$ |
| DD-34 | $-Cl$ | $-H$ |
| DD-35 | $-Cl$ | $-Cl$ |
| DD-36 | $-H$ | $-OCH_3$ |
| DD-37 | $-CH_3$ | $-CH_3$ |
| DD-38 | $-C_3H_7$-i | $-C_3H_7$-i |

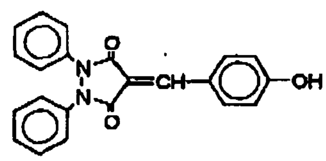

DD-39

iii) A compound having an organic compound moiety capable of severing covalent bond upon electron or energy transfer from or to excited state of sensitizing dye represents by any of the formulae (1) and (3-1) to (3-5) and an organic compound moiety capable of forming a coloring material during covalent bonding and when released, which moieties being covalently bound, optionally combined with a base. Particularly preferred examples of such a combination will be given below, but the invention is not limited thereto.

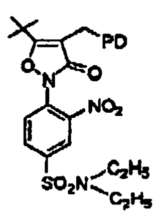

| | PD | | PD | | PD |
|---|---|---|---|---|---|
| E-1 | PD-1 | E-6 | PD-10 | E-11 | PD-19 |
| E-2 | PD-2 | E-7 | PD-12 | E-12 | PD-20 |
| E-3 | PD-22 | E-8 | PD-13 | E-13 | PD-24 |
| E-4 | PD-27 | E-9 | PD-18 | E-14 | PD-25 |
| E-5 | PD-8 | E-10 | PD-18 | E-15 | PD-29 |

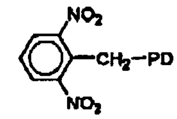

| | PD | | PD | | PD |
|---|---|---|---|---|---|
| E-16 | PD-22 | E-21 | PD-11 | E-26 | PD-20 |
| E-17 | PD-2 | E-22 | PD-14 | E-27 | PD-23 |
| E-18 | PD-27 | E-23 | PD-15 | E-28 | PD-25 |
| E-19 | PD-7 | E-24 | PD-17 | E-29 | PD-26 |
| E-20 | PD-8 | E-25 | PD-18 | E-30 | PD-29 |

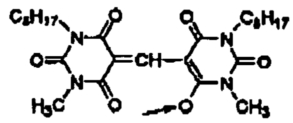

PD-1

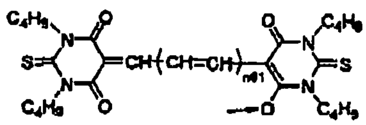

| | n61 |
|---|---|
| PD-2 | 0 |
| PD-3 | 1 |
| PD-4 | 2 |

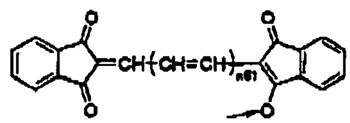

| | n61 |
|---|---|
| PD-5 | 0 |
| PD-6 | 2 |

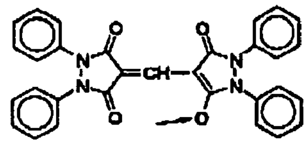

PD-7

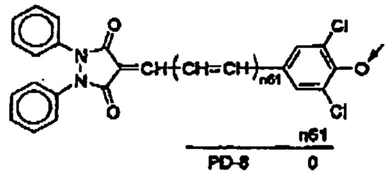

| | n61 |
|---|---|
| PD-8 | 0 |
| PD-9 | 1 |

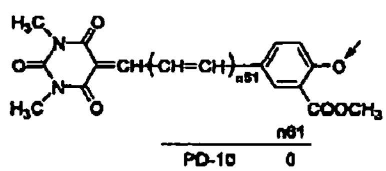

| | n61 |
|---|---|
| PD-10 | 0 |
| PD-11 | 1 |

PD-12

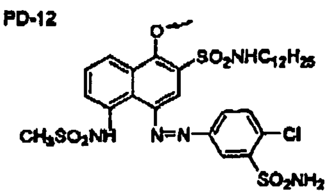

PD-13

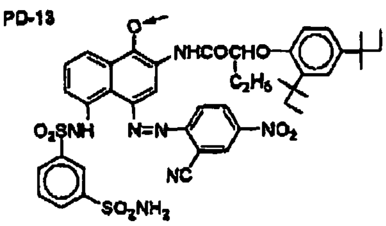

PD-14

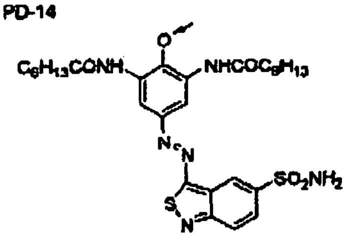

PD-15

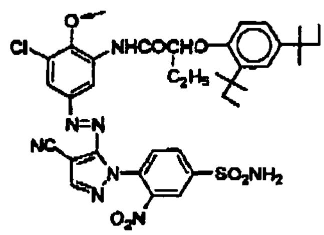

PD-16

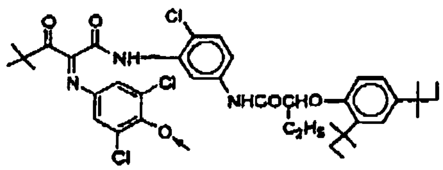

PD-17

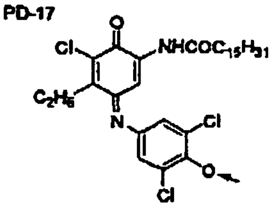

PD-18

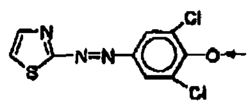

PD-19

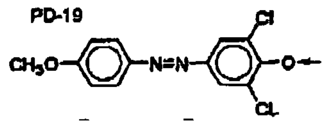

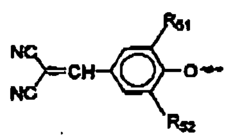

| | $R_{51}$ | $R_{52}$ |
|---|---|---|
| PD-20 | —H | —H |
| PD-21 | —Cl | —H |
| PD-22 | —Cl | —Cl |
| PD-23 | —Cl | $-COOC_2H_5$ |
| PD-24 | —Cl | —CN |

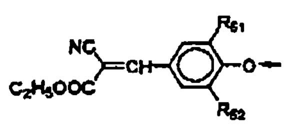

| | $R_{51}$ | $R_{52}$ |
|---|---|---|
| PD-25 | —H | —H |
| PD-26 | —Cl | —H |
| PD-27 | —Cl | —Cl |
| PD-28 | $-OCH_3$ | $-OCH_3$ |
| PD-29 | $-CH_3$ | $-CH_3$ |
| PD-30 | $-C_3H_7$-i | $-C_3H_7$-i |

iv) Compound capable of reacting upon electron movement from or to excited state of sensitizing dye represented by any of the formulae I) and (3-1) to (3-5) to change absorption form. A so-called electrochromic compound is preferably used.

More preferably, a binder polymer is incorporated in the compound. Preferred examples of the binder polymer include those exemplified above with reference to (1) polymerization reaction and those disclosed in Japanese Patent Application No. 2004-238077.

3) Recording of interference fringes by latent image color development-coloring material self-sensitized amplification color development reaction

This hologram recording method comprises at least a first step of forming a coloring material having no absorption at hologram reproducing light wavelength as a latent image by hologram exposure and a second step of irradiating the coloring material latent image with light having a wavelength different from hologram exposure wavelength, at which the sensitizing dye represented by any of the formulae (1) and (3-1) to (3-5) exhibits a molar absorption coefficient of 5,000 or less to cause the self-sensitized amplification of the coloring material, whereby an interference fringes is recorded as refractive index modulation, which steps being effected in a dry process. This hologram recording method

is advantageous in high speed writing properties, high S/N ratio reproducibility, etc.

The term "latent image" as used herein is meant to indicate that the refractive index difference formed after the second step is preferably one second or less (that is, magnification or 2 or more is preferably effected at the second step), more preferably one fifth, even more preferably one tenth, most preferably one thirtieth (that is, magnification of 5 or more, more preferably 10 or more, most preferably 30 or more is effected at the second step).

The second step preferably involves the irradiation with light or both of the irradiation with light and the application of heat, more preferably the irradiation with light. The irradiation with light preferably involves entire exposure (so-called solid exposure, blanket exposure or non-imagewise exposure).

Preferred examples of the light source to be used herein include visible light laser, ultraviolet laser, infrared laser, carbon are, high voltage mercury vapor lamp, xenon lamp, metal halide lamp, fluorescent lamp, tungsten lamp, LED, and organic EL. In order to irradiate the hologram recording material with light having a specific wavelength, a sharp cut filter, band pass filter, diffraction grating or the like is preferably used as necessary.

During this procedure, it is preferred that the sensitizing dye represented by any of the formulae (1) and (3-1) to (3-5) of the invention, too, be discolored and fixed at the same time with the other compounds. As a result, even upon irradiation with hologram reproducing light, recorded data cannot be destroyed nor absorbed, making it possible to obtain a high absolute diffraction efficiency.

Further, the hologram recording material allowing the aforementioned hologram recording method preferably comprises at least:

1) A sensitizing dye represented by any of the formulae (1) and (3-1) to (3-5) which absorbs light upon hologram exposure to generate excited state; and

2) An interference fringe-recording component containing a dye precursor which can form a coloring material that has absorption at longer wavelength than in the original state and no absorption at hologram reproducing light wavelength, which interference fringe-recording component can undergo electron or energy transfer from excited state of sensitizing dye or coloring material to cause color development leading to refractive index modulation by which an interference fringes is recorded.

Preferred examples of the interference fringe-recording component include those exemplified with reference to 2) color development reaction.

The light emitted at the second step preferably has a wavelength range at which the sensitizing dye represented by any of the formulae (1) and (3-1) to (3-5) exhibits a molar absorption coefficient of 1,000 or less, more preferably 500 or less.

Further, the light emitted at the second step preferably has a wavelength range at which the coloring material exhibits a molar absorption coefficient of 1,000 or more.

The concept of "latent image color development-coloring material self-sensitized amplification color development reaction process" will be described hereinafter.

For example, the hologram recording material is irradiated with YAG-SHG laser beam having a wavelength of 532 nm so that the laser beam is absorbed by the sensitizing dye to generate excited state. Energy or electron is then moved from the excited state of sensitizing dye to the interference fringe-recording component to cause the dye precursor contained in the interference fringe-recording component to change to a coloring material, whereby a latent image is formed by color development (first step). Subsequently, the hologram recording material is irradiated with light having a wavelength of from 350 nm to 420 nm so that the light is absorbed by the coloring material which is then self-sensitized to cause the amplification thereof (second step). At the area which has become a dark interference area at the first step, there is produced little latent image. Therefore, little self-sensitized color development reaction occurs at the second step as well. As a result, a great refractive index modulation can be performed between the bright interference area and the dark interference area. The refractive index modulation can be recorded as interference fringes. For example, when the hologram recording material having data, image, etc. recorded thereon is again irradiated with a laser beam having a wavelength of 532 nm, the data, image, etc, can be reproduced.

Specific preferred examples of the latent image color development-coloring material self-sensitized amplification color development reaction include those exemplified in Japanese Patent Application No. 2004-238427.

4) Recording of interference fringes by latent image color development-coloring material sensitized polymerization reaction

This hologram recording method preferably comprises at least a first step of forming a coloring material having no absorption at hologram reproducing light wavelength as a latent image by hologram exposure and a second step of irradiating the coloring material latent image with light having a wavelength different from hologram exposure wavelength to cause polymerization, whereby an interference fringes is recorded as refractive index modulation, which steps being effected in a dry process. This hologram recording method is excellent in high speed writing properties, storage properties, etc.

It is also preferred that the polymerization be effected while causing self-sensitized amplification of coloring material

at the second step.

At the second step, it is preferred that the sensitizing dye represented by any of the formulae (1) and (3-1) to (3-5) of the invention, too, be discolored and fixed at the same time with the other compounds. As a result, even upon irradiation with hologram reproducing light, recorded data cannot be destroyed nor absorbed, making it possible to obtain a high absolute diffraction efficiency.

Further, the hologram recording material allowing the aforementioned hologram recording method comprises at least:

1) A sensitizing dye represented by any of the formulae (1) and (3-1) to (3-5) which absorbs light upon hologram exposure to generate excited state at the first step;
2) An interference fringe-recording component containing a dye precursor which can form a coloring material that has absorption at longer wavelength than in the original state, at which wavelength the sensitizing dye exhibits a molar absorption coefficient of 5,000 or less, and that no absorption at hologram reproducing light wavelength when electron or energy moves from excited state of sensitizing dye at the first step or from excited state of coloring material at the second step;
3) A polymerization initiator which can initiate the polymerization of a polymerizable compound when electron or energy moves from excited state of sensitizing dye at the first step and from excited state of coloring material at the second step;
4) A polymerizable compound; and
5) A binder.

Preferred examples of the sensitizing dye and the interference fringe-recording component include those exemplified with reference to 2) color development reaction.

Preferred examples of the polymerization initiator, the polymerizable compound and the binder include those exemplified with reference to 1) polymerization reaction.

The light emitted at the second step preferably has a wavelength range at which the sensitizing dye represented by any of the formulae (1) and (3-1) to (3-5) exhibits a molar absorption coefficient of 1,000 or less, more preferably 500 or less.

Further, the light emitted at the second step preferably has a wavelength range at which the coloring material exhibits a molar absorption coefficient of 1,000 or more.

In the hologram recording method of the invention and the hologram recording material allowing the hologram recording method, it is preferred that the coloring material be decomposed and fixed at the second step or the subsequent fixing step involving either or both of irradiation with light and application of heat.

The concept of "latent image color development-coloring material sensitized polymerization reaction process" will be described hereinafter.

For example, the hologram recording material is irradiated with YAG·SHG laser beam having a wavelength of 532 nm so that the laser beam is absorbed by the sensitizing dye to generate excited state. Energy or electron is then moved from the excited state of sensitizing dye to the interference fringe-recording component to cause the dye precursor contained in the interference fringe-recording component to change to a coloring material, whereby a latent image is formed by color development (first step). Subsequently, the hologram recording material is irradiated with light having a wavelength of from 350 nm to 420 nm so that the light is absorbed by the coloring material. Thus, electron or energy is moved to the polymerization initiator to activate the polymerization initiator to initiate polymerization. For example, when the polymerizable compound has a smaller refractive index than the binder, the polymerizable compound gathers at the polymerization area, causing the drop of refractive index (second step). At the area which has become a bright interference area at the first step, there is less remaining discolorable dye forming a latent image. Therefore, little polymerization occurs in the bright interference area at the second step. Thus, the proportion of binder is higher in the bright interference area. As a result, a great refractive index modulation can be performed between the bright interference area and the dark interference area. The refractive index modulation can be recorded as interference fringes. So far as the sensitizing dye and remaining discolorable dye can be decomposed and discolored at the first and second steps or the subsequent fixing step, a hologram recording material excellent in non-destructive reproduction, storage properties and diffraction efficiency can be provided.

For example, when the hologram recording material having data, image, etc. recorded thereon is again irradiated with a laser bearn having a wavelength of 532 nm, the data, image, etc. can be reproduced.

Specific preferred examples of the latent image-coloring material sensitized polymerization reaction include those exemplified in Japanese Patent Application No. 2004-238392.

5) Recording of interference fringes by the change of orientation of compound intrinsic birefringence

This hologram recording method preferably involves the change of orientation of a compound having an intrinsic birefringence upon hologram exposure. The compound is then chemically reacted so that it is fixed. In this manner, an interference fringes can be recorded as refractive index modulation in a non-rewritable process. As the compound

having an intrinsic birefringence there is preferably used a liquid crystal-based compound, more preferably a low molecular liquid crystal-based compound, even more preferably a low molecular liquid crystal-based compound having a polymerizable group. Specific preferred examples of these compounds include those exemplified in Japanese Patent Application No. 2003-327594.

It is preferred that a sensitizing dye represented by any of the formulae (1) and (3-1) to (3-5) is incorporated as a sensitizing dye for photopolymerization and, after hologram recording, the sensitizing dye represented by the formula (1) be discolored and fixed upon irradiation with light. As a result, even upon irradiation with hologram reproducing light, recorded data cannot be destroyed nor absorbed, making it possible to obtain a high absolute diffraction efficiency.

6) Dye discoloration reaction

In this hologram recording method, at least one discolorable dye is used and the discolorable dye is discolored during hologram exposure to cause refractive index modulation by which an interference fringes is formed.

The term "discolorable dye" as used herein generically indicates a dyc which has absorption in the ultraviolet range of from 200 to 2,000 nm, visible light range and infrared range and directly or indirectly causes any, preferably both of shifting of λmax to shorter wavelength and reduction of molar absorption coefficient when irradiated with light. The discoloration reaction occurs preferably in the wavelength range of from 200 to 1,000 nm, more preferably from 300 to 900 nm.

A hologram recording method wherein there are provided at least a sensitizing dye represented by any of the formulae (1) and (3-1) to (3-5) having absorption at hologram exposure wavelength and a discolorable dye having a molar absorption coefficient of 1,000 or less, preferably 100 or less at hologram reproducing light wavelength and the sensitizing dye absorbs light during hologram exposure to generate excitation energy by which electron or energy moves to discolor the discolorable dye, causing refractive index modulation by which an interference fringes is formed.

It is more preferred that there is provided a discoloring agent precursor other than the discolorable dye and the sensitizing dyes represented by the formulae (1) and (3-1) to (3-5) and when subjected to hologram exposure, the sensitizing dyes represented by the formulae (1) and (3-1) to (3-5) or the discolorable dye generates excited state in which it then undergoes energy movement or electron movement with the discoloring agent precursor to cause the discoloring agent precursor to generate a discoloring agent which then discolors the discolorable dye, causing refractive index modulation by which an interference fringes is formed. The discoloring agent is preferably any of radical, acid, base, nucleophilic agent, electrophilic agent and singlet oxygen. Accordingly, the discoloring agent precursor is preferably any of radical generator, acid generator, base generator, nucleophilic agent generator, electrophilic agent generator and triplet oxygen. The discoloring agent precursor is preferably any of radical generator, acid generator and base generator.

When the sensitizing dyes represented by the formulae (1) and (3-1) to (3-5) of the invention are discolored and fixed by irradiating with light in a specific wavelength range after hologram recording, recorded data cannot be destroyed nor absorbed even upon irradiation with hologram reproducing light, making it possible to obtain a high absolute diffraction efficiency.

In any case, it is more desirable that a binder polymer is incorporated more. Preferred examples of the binder polymer employable herein include those mentioned in the description for 1) polymerization reaction and those exemplified in Japanese Patent Application No. 2004-238077.

The discolorable dye for making the refractive index different from the bright interference area to the dark interference area in the "dye discoloration reaction process" will be further described hereinafter.

The discolorable dye preferably has a molar absorption coefficient in the hologram recording wavelength of 1,000 or less, more preferably 100 or less and most preferably 0. λmax of the discolorable dyc is preferably in the range between the hologram recording wavelength and a wavelength shorter than the hologram recording wavelength by 200 nm.

In the process (B), the discolorable dye is preferably any of cyanine dye, squarilium cyanine dye, styryl dye, pyrilium dye, melocyanine dye, benzylidene dye, oxonol dye, coumarine dye, pyrane dye, xanthene dye, thioxanthene dye, phenothiazine dye, phenoxazine dye, phenazine dye, phthalocyanine dye, azaporphiline dye, porphiline dye, fused ring aromatic dye, Perylene dye, azomethine dye, azo dye, anthraquinone dye and metal complex dye, more preferably any of cyanine dye, styryl dye, melocyanine dye, benzylidene dye, oxonol dye, coumarine dye, xanthene dye, azomethine dye, azo dye and metal complex dye.

In particular, when the discoloring agent is an acid, the discolorable dye is preferably a dissociation product of dissociative benzylidene dye,, dissociative oxonol dye, dissociative xanthene dye or dissociative azo dye, more preferably a dissociation product of dissociative benzylidene dye,, dissociative oxonol dye or dissociative azo dye.

The term "dissociative dye" as used herein generically indicates a dye having an active hydrogen having pKa of from about 2 to 14 such as -OH group, -SH group, -COOH group, $-NHSO_2R$ group and $-CONHSO_2R$ group which undergoes deprotonation to have absorption in longer wavelength or with higher ε. Accordingly, such a dissociative dye can be previously treated with a base to form a dissociated dye from which a dye having absorption in longer

wavelength or with higher s can be prepared, making it possible to render the dye non-dissociative during photo-acid generation so that it is discolored (have absorption in lower wavelength or with lower ε).
In particular, in the case where the discoloring agent is a base, when a product of color development of an acid-colorable dye such as triphenylmethane dye, xanthene dye and fluorane dye with an acid is used as a discolorable dye, it can be converted to unprotonated product and thus discolored (have absorption in lower wavelength or with lower s) during photo-base generation.
Specific examples of the discolorable dye of the invention will be given below, but the invention is not limited thereto.

G-1

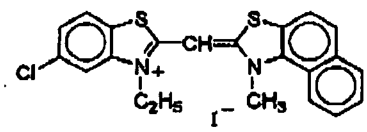

G-2

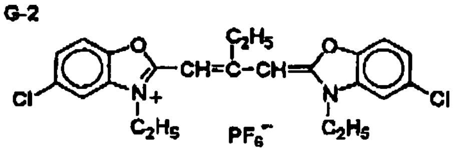

G-3

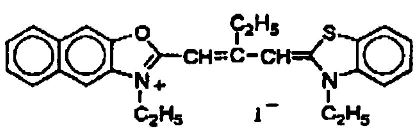

G-4

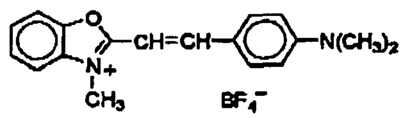

G-5

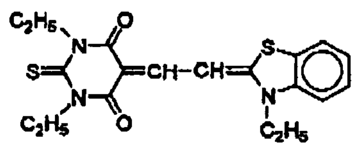

G-6

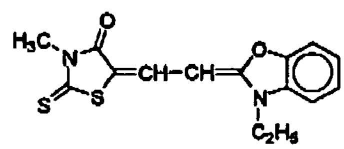

G-7

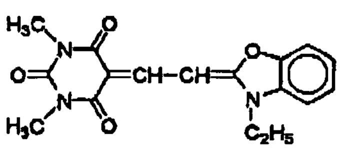

G-8

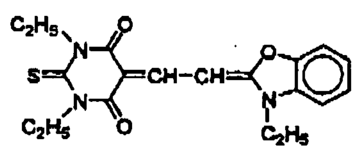

G-9

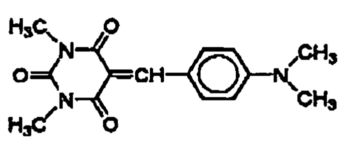

G-10

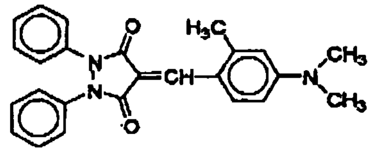

G-11

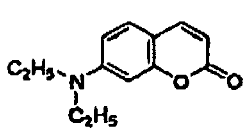

G-12

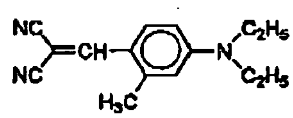

<Dissociation product of dissociative dye, mainly acid- discolorable dye>

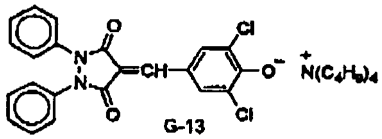

G-13

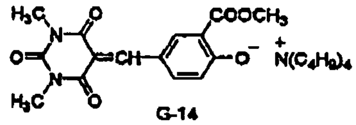

G-14

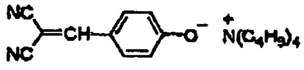

G-15

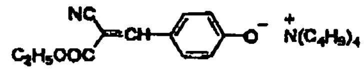

G-16

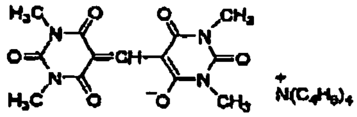

G-17

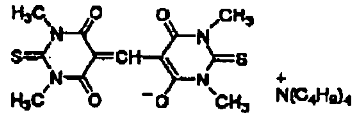

G-18

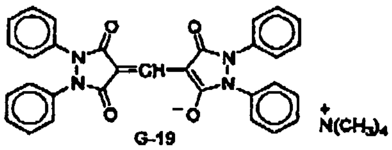

G-19

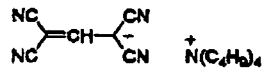

G-20

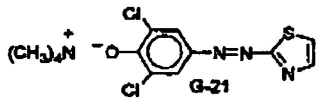

G-21

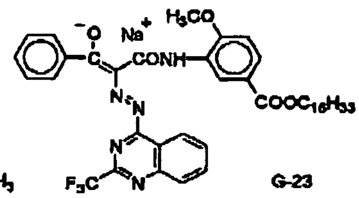

G-23

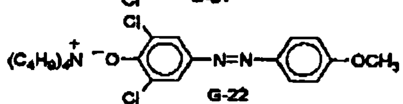

G-22

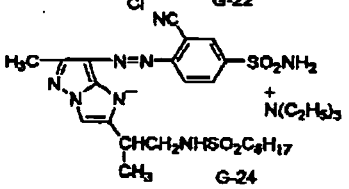

G-24

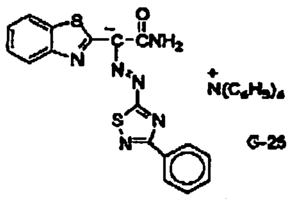

G-25

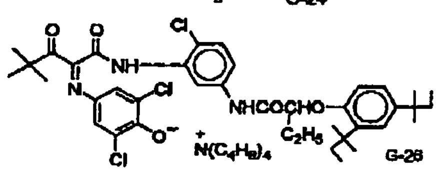

G-26

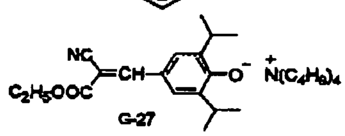

G-27

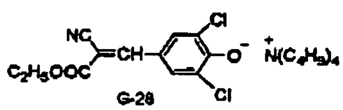

G-28

<Color development product of acid-colorable dye, mainly base-discolorable dye>

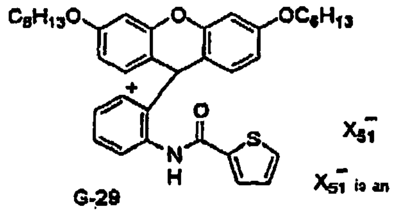

$X_{51}^-$ is an anion.

G-29

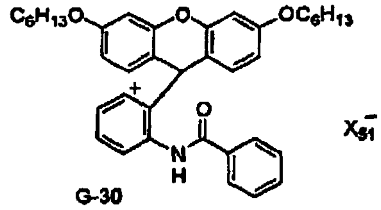

G-30

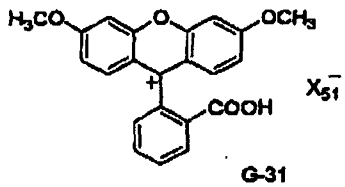

G-31

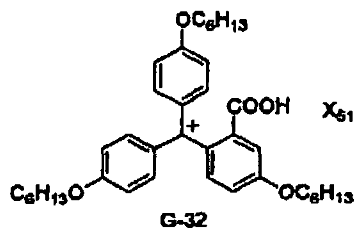

G-32

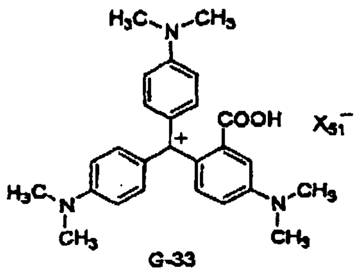

G-33

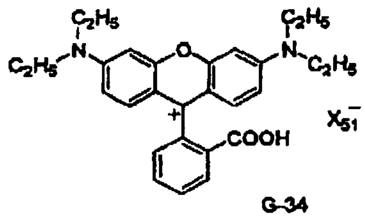

G-34

<Acid-color development product of cyanine base, mainly base-discolorable dye>

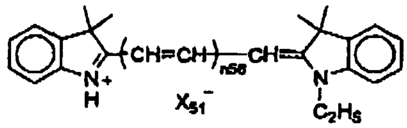

| | $n_{56}$ |
|---|---|
| G-35 | 0 |
| G-36 | 1 |
| G-37 | 2 |

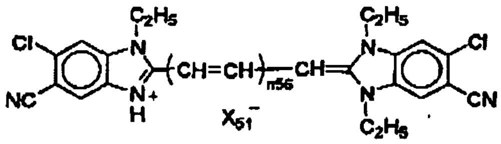

| | $n_{56}$ |
|---|---|
| G-38 | 0 |
| G-39 | 1 |

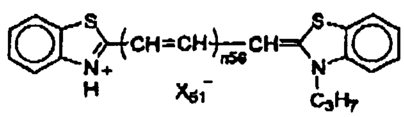

| | $n_{56}$ |
|---|---|
| G-40 | 0 |
| G-41 | 1 |

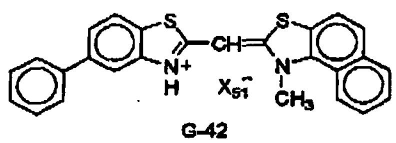

G-42

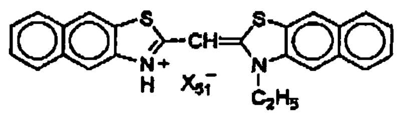

G-43

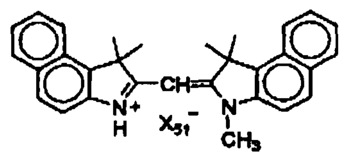

G-44

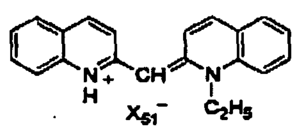

G-45

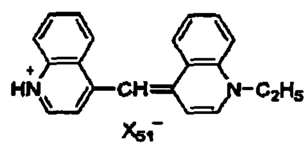

G-46

A preferred example of the discolorable dye of the invention is the following discolorable dye which is subjected to hologram exposure to generate excited state of sensitizing dye represented by any of the formulae (1) and (3-1) to (3-5) from which electron moves to severe the bond, resulting in the discoloration thereof.

Such a discolorable dye is originally a cyanine dye. However, when the electron movement causes the bond to be severed, the discolorable dye is converted to a cyanine base (leucocyanine dye), causing the absorption to be eliminated or shifted to lower wavelength.

<Discoloration by severation of bond by electron movement>

$X_{51}^-$ is an anion.

| $R_{51}$ | 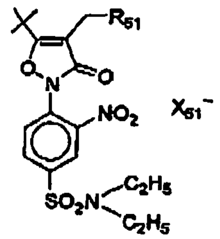 | 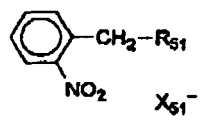 |
|---|---|---|
| GD-1 | G-47 | G-54 |
| GD-2 | G-48 | G-55 |
| GD-3 | G-49 | G-56 |
| GD-4 | G-50 | G-57 |
| GD-5 | G-51 | G-58 |
| GD-6 | G-52 | G-59 |
| GD-7 | G-53 | G-60 |

*: Substitution at position

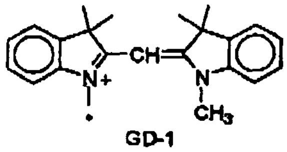
GD-1

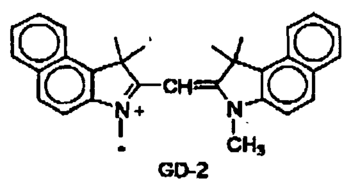
GD-2

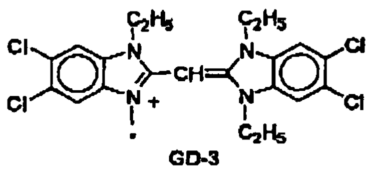
GD-3

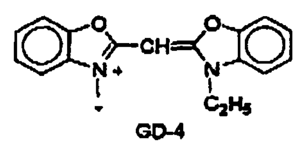
GD-4

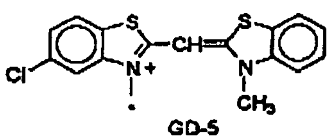
GD-5

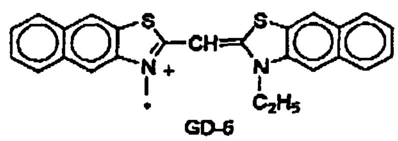
GD-6

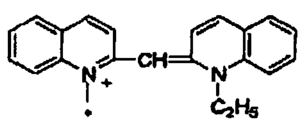
GD-7

Preferred examples of the discoloring agent precursor which is an acid generator include those exemplified above with reference to cationic polymerization initiator. Preferred examples of the discoloring agent precursor which is a radical generator include those exemplified above with reference to radical polymerization initiator. Preferred examples of the discoloring agent precursor which is a base generator include those exemplified above with reference to anionic polymerization initiator.

Specific preferred examples of the dye discoloration reaction include those exemplified in Japanese Patent Application No. 2004-88790.

7) Remaining discolorable dye latent image-latent image sensitized polymerization reaction

This hologram recording method preferably comprises a first step at which the sensitizing dye represented by any of the formulae (1) and (3-1) to (3-5) having absorption at hologram exposure wavelength absorbs light during hologram exposure to generate excited state with the energy of which it then discolors the discolomble dye having a molar absorption coefficient of 1,000 or less, preferably 100 or less, most preferably 0 at hologram reproducing light wavelength, whereby the discolorable dye left undiscolored forms a latent image and a second step at which the latent

image of discolorable dye left undiscolored is irradiated with light having a wavelength different from that used for hologram exposure to cause polymerization by which an interference fringes is recorded as refractive index modulation. This hologram recording method is excellent in high speed recording properties, adaptability to multiplexed recording, storage properties after recording, etc.

This hologram recording method more preferably comprises a first step at which the sensitizing dye represented by any of the formulae (1) and (3-1) to (3-5) having absorption at hologram exposure wavelength absorbs light during hologram exposure to generate excited state in which it then undergoes energy movement or electron movement with the discoloring agent precursor as defined in Clause 6) to cause the discoloring agent precursor to generate a discoloring agent which then discolors the discolorable dye whereby the discolorable dye left undiscolored forms a latent image and a second step at which the latent image of discolorable dye left undiscolored is irradiated with light having a wavelength different from that used for hologram exposure to cause energy movement or electron movement by which a polymerization initiator is activated to cause polymerization by which an interference fringes is recorded as refractive index modulation. At the second step, it is preferred that the sensitizing dye represented by any of the formulae (1) and (3-1) to (3-5) of the invention, too, be discolored and fixed at the same time with the other compounds. As a result, even upon irradiation with hologram reproducing light, recorded data cannot be destroyed nor absorbed, making it possible to obtain a high absolute diffraction efficiency.

Further, the compound group allowing the aforementioned hologram recording method preferably comprises at least:

1) A sensitizing dye represented by any of the formulae (1) and (3-1) to (3-5) which absorbs light upon hologram exposure to generate excited state at the first step;
2) A discolorable dye having a molar absorption coefficient of 1,000 or less at hologram reproducing light wavelength capable of performing direct energy or electron movement to the discoloring agent precursor from excited state of sensitizing dye to generate a discoloring agent with which discoloration can be effected at the first step;
3) A polymerization initiator (optionally acting as a discoloring agent precursor 2) as well) which can undergo electron or energy transfer from excited state of remaining discolorable dye to initiate the polymerization of the polymerizable compound at the second step;
4) A polymerizable compound; and
5) A binder.

In the case where the discolorable dye 2) undergoes energy or electron movement to a discoloring agent precursor, the compound group preferably further contains 6) a discoloring agent precursor capable of undergoing electron or energy movement from excited state of sensitizing dye to generate a discoloring agent at the first step.

Preferred examples of the polymerization initiator, the polymerizable compound and the binder include those exemplified with reference to 1) polymerization reaction.

The light emitted at the second step preferably has a wavelength range at which the sensitizing dye represented by any of the formulae (1) and (3-1) to (3-5) exhibits a molar absorption coefficient of 1,000 or less, more preferably 500 or less.

Further, at the wavelength range of the light emitted at the second step, the discolorable dye preferably exhibits a molar absorption coefficient of 1,000 or more.

In the "remaining discolorable dye latent image-latent image sensitized polymerization process" of the invention, it is also preferred that the discoloring agent precursor and the polymerization initiator partly or wholly act as each other.

In the case where a discolorable dye is added in addition to the sensitizing dye represented by any of the formulae (1) and (3-1) to (3-5), when the discoloring agent precursor and the polymerization initiator arc different from each other (e.g., when the discoloring agent precursor is an acid generator or base formula and the polymerization initiator is a radical polymerization initiator or when the discoloring agent precursor is a radical generator or nucleophilic agent generator and the polymerization initiator is an acid generator or base generator), it is preferred that the sensitizing dyc can perform electron movement sensitization only on the discoloring agent precursor and the polymerization initiator can perform electron movement sensitization only by the discolorable dye.

In the hologram recording method of the invention and the hologram recording material allowing the hologram recording method, it is preferred that the remaining discolorable dye be decomposed and fixed at the second step or the subsequent fixing step involving either or both of irradiation with light and application of heat.

The concept of "remaining discolorable dye latent image-latent image sensitized polymerization reaction process" will be described hereinafter.

For example, the hologram recording material is irradiated with YAG·SHG laser beam having a wavelength of 532 nm so that the laser beam is absorbed by the sensitizing dye to generate excited state. Energy or electron is then moved from the excited state of sensitizing dye to the discoloring agent precursor to generate a discoloring agent by which the discolorable dye is then discolored. As a result, a latent image can be formed by the remaining discolorable

dye (first step). Subsequently, the hologram recording material is irradiated with light having a wavelength of from 350 nm to 420 nm so that the light is absorbed by the remaining discolorable dye. Then, electron or energy is moved to the polymerization initiator to activate the polymerization initiator to initiate polymerization. For example, when the polymerizable compound has a smaller refractive index than the binder, the polymerizable compound gathers at the polymerization area, causing the drop of refractive index (second step). At the area which has become a bright interference area at the first step, there is less remaining discolorable dye forming a latent image. Therefore, little polymerization occurs in the bright interference area at the second step. Thus, the proportion of binder is higher in the bright interference area. As a result, a great refractive index modulation can be performed between the bright interference area and the dark interference area. The refractive index modulation can be recorded as interference fringes. So far as the sensitizing dye and remaining discolorable dye can be decomposed and discolored at the first and second steps or the subsequent fixing step, a hologram recording material excellent in non-destructive reproduction, storage properties and diffraction efficiency can be provided.

For example, when the hologram recording material having data, image, etc. recorded thereon is again irradiated with a laser beam having a wavelength of 532 nm, the data, image, etc. can be reproduced. Alternatively, the hologram recording material of the invention can act as a desired optical material.

Specific preferred examples of the remaining discolorable dye latent image-latent image sensitized polymerization reaction include those exemplified in Japanese Patent Application No. 2004-88790.

The hologram recording material of the invention may further comprise additives such as electron-donating compound, electron-accepting compound, chain transfer agent, crosslinking agent, heat stabilizer, plasticizer and solvent incorporated therein besides the aforementioned sensitizing dyes represented by the formulae (1) and (3-1) to (3-5), interference fringe-recording component, polymerization initiator, polymerizable compound, binder, discolorable dye, discoloring agent precursor, etc. as necessary.

The electron-donating compound is capable of reducing the radical cation in the sensitizing dyes represented by the formulae (1) and (3-1) to (3-5), coloring materials or discolorable dyes. The electron-accepting compound is capable of oxidizing the radical anion in the sensitizing dyes represented by the formulae (1) and (3-1) to (3-5), coloring materials or discolorable dyes. Thus, both the electron-donating compound and the electron-accepting compound are capable of reproducing the sensitizing dye. Specific preferred examples of these compounds include those exemplified in Japanese Patent Application No. 2004-238077.

In particular, the electron-donating compound is useful for the enhancement of sensitivity because it can rapidly reproduce from the radical cation of the sensitizing dyes represented by the formulae (1) and (3-1) to (3-5), coloring materials or discolorable dye produced by the movement of electron to the dye precursor group. As the electron-donating compound there is preferably used one having a more negative oxidation potential than sensitizing dye, coloring material and discolorable dye. Specific preferred examples of the electron-donating compound will be given below, but the invention is not limited thereto.

Examples of electron-donating compound for reproduction of sensitizing dye

A-1

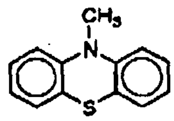

A-2

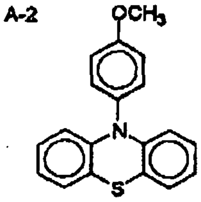

A-3

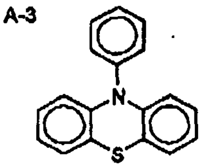

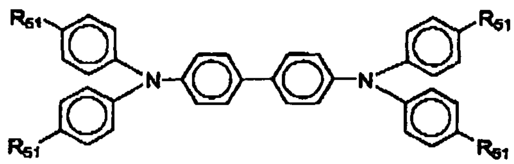

| | $R_{51}$ |
|---|---|
| A-4 | H |
| A-5 | $-OCH_3$ |

A-6

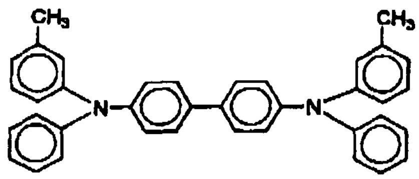

A-7

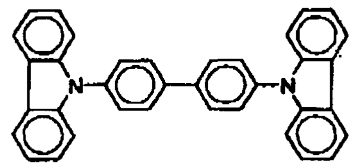

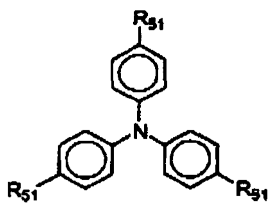

| | $R_{51}$ |
|---|---|
| A-8 | H |
| A-9 | $-CH_3$ |
| A-10 | $-OCH_3$ |

A-11

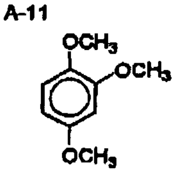

A-12

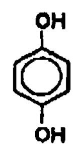

A-13

$(C_4H_9)_4\overset{+}{N}\ I^-$

A-14

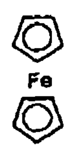

Particularly preferred examples of the electron-donating compound include phenothiazine-based compounds (e.g., 10-methylphenothiazine, 10-(4'-methoxyphenyl) phenothiazine), triphenylamine-based compounds (e.g., triphenylamine, tri(4'-methoxyphenyl)amine), and TPD-based compounds (e.g., TPD). More desirable among these electron-donating compounds arc phenothiazine-based compounds. Most desirable among these electron-donating compounds is N-methylphenothtazine.

The sensitizing dye, acid generator, base generator, dye precursor, discolorable dye, discoloring agent precursor, electron-donating compound and other components described above may be in the form of oligomer or polymer. These oligomers or polymers may be incorporated in the main chain or side chain. These components may be also in the form of copolymer.

The polymer chain may have any structure. Preferred examples of the structure of the polymer chain include polyethers such as polyacrylate, polymethactylate, polystyrene and polyethylene oxide, polyesters, and polyamides.

The number of repeating units constituting the polymer or oligomer is from not smaller than 2 to not greater than 1,000,000, preferably from not smaller than 3 to not greater than 1,000,000, more preferably from not smaller than 5 to not greater than 500,000, even more preferably from not smaller than 10 to not greater than 100,000.

The molecular weight of the polymer or oligomer is preferably from not smaller than 500 to not greater than 10,000,000, more preferably from not smaller than 1,000 to not greater than 5,000,000, even more preferably from not smaller than 2,000 to not greater than 1,000,000, most preferably from not smaller than 3,000 to not greater than 1,000,000.

Specific preferred examples of chain transfer agent, crosslinking agent, heat stabilizer, plasticizer, solvent, etc. include those exemplified in Japanese Patent Application No. 2004-238392.

Preferred examples of the chain transfer agent include thiols. Examples of these thiols include 2-mercaptobenzoxazole, 2-mercaptobenzthiazole, 2-mercaptobenzimidazole, 4-methyl-4H-1,2,4-triazole-3-thiol, p-bromobenzenethiol, thiocyanuric acid, 1,4-bis(mercapto)benzene, and p-toluenethiol.

In particular, in the case where the polymerization initiator is a 2,4,5-triphenylimidazolyl dimer, a chain transfer agent is preferably used.

The hologram recording material of the invention may comprise a heat stabilizer incorporated therein to enhance the storage properties thereof during storage.

Examples of useful heat stabilizers include hydroquinone, phenidonc, p-methoxypheno, alkyl-substituted hydroquinone, alkyl-substituted quinone, aryl-substituted hydroquinone, aryl-substituted quinone, catechol, t-butylcatechol, pyrogallol, 2-naphthol, 2,6-di-t-butyl-p-cresol, phenothiazine, and chloranyl.

The plasticizer is used to change the adhesivity, flexibility, hardness and other mechanical properties of the hologram recording material. Examples of the plasticizer employable herein include triethylene glycol dicaprylate, triethylene glycol bis(2-ethylhexanoate), tetraethylene glycol diheptanoate, diethyl sebacate, dibutyl sberate, tris(2-ethylhexyl) phosphate, tricresyl phosphate, dibutyl phthalate, alcohols, and phenols.

The hologram recording material of the invention may be prepared by any ordinary method.

For the production of the film of the hologram recording material of the invention, the aforementioned binder and various components may be spread over the substrate in the form of solution in a solvent or the like using a spin coater, bar coater or the like.

Preferred examples of the solvent to be used herein include ketone-based solvents such as methyl ethyl ketone, methyl isobutyl ketone, acetone and cyclohexanone, ester-based solvents such as ethyl acetate, butyl acetate, ethylene glycol diacetate, ethyl lactate and cellosolve acetate, hydrocarbon-based solvents such as tetrahydrofurane, dioxane and diethyl ether, cellosolve-based solvents such as methyl cellosolve, ethyl cellosolve, butyl cellosolve and dimethyl cellosolve, alcohol-based solvents such as methanol, ethanol, n-propanol, 2-propanol, n-butanol and diacetone alcohol, fluorine-based solvents such as 2,2,3,3-tetrafluoropropanol, halogenated hydrocarbon-based solvents such as dichloromethane, chloroform and 1,2-dichlorocthane, amide-based solvents such as N,N-dimethylformamide, and nitrile-based solvents such as acetonitrile and propionitrile.

The hologram recording material of the invention can be prepared by spreading the aforementioned coating solution directly over the substrate using a spin coater, roll coater, bar coater or the like or by casting the coating solution into a film which is then laminated on the substrate using an ordinary method.

The term "substrate" as used herein is meant to indicate an arbitrary natural or synthetic support, preferably one which can occur in the form of flexible or rigid film, sheet or plate.

Preferred examples of the substrate include polyethylene terephthalate, resin-undercoated polyethylne terephthalate, flame- or electrostatically discharged polyethylene terephthalate, cellulose acetate, polycarbonate, polymethyl methacrylate, polyester, polyvinyl alcohol, and glass.

The solvent used can be evaporated away during drying. The evaporation may be effected under heating or reduced pressure.

The film of the hologram recording material of the invention may be prepared by melting the binder comprising various components at a temperature of not lower than the glass transition temperature or melting point of the binder, and then melt-extruding or injection-molding the molten binder. During this procedure, a reactive crosslinkable binder may be used as the binder so that the binder thus extruded or molded can be crosslinked and cured to raise the strength of the film. In this case, the crosslinking reaction may involve radical polymerization reaction, cationic polymerization reaction, condensation polymerization reaction, addition polymerization reaction or the like. Alternatively, methods disclosed in JP-A-2000-250382, JP-A-2000-172154, etc. are preferably used.

Further, a method is preferably used which comprises dissolving various components in a monomer solution for forming a binder, and than subjecting the monomer to photopolymerization or photopolymerization to produce a polymer which is then used as a binder. Examples of the polymerization method employable herein include radical polymerization reaction, cationic polymerization reaction, condensation polymerization reaction, and addition polymerization reaction.

Moreover, a protective layer for blocking oxygen may be formed on the hologram recording material. The protective layer may be formed by laminating a film or sheet of a plastic such as polyolefin (e.g., polypropylene, polyethylene), polyvinyl chloride, polyvinylidene chloride, polyvinyl alcohol, polyethylene terephthalate and cellophane on the hologram recording material using an electrostatic contact method or an extrusion machine or by spreading the aforementioned polymer solution over the hologram recording material. Alternatively, a glass sheet may be laminated on the hologram recording material. Further, an adhesive or liquid material may be provided interposed between the protective layer and the photosensitive layer and/or between the substrate and the photosensitive layer to enhance airtightness.

In the case where the hologram recording material of the invention is used for holographic light memory, it is preferred from the standpoint of enhancement of S/N ratio during the reproduction of signal that the hologram recording material undergo no shrinkage after hologram recording.

To this end, it is preferred that the hologram recording material of the invention comprise an inflating agent disclosed in JP-A-2000-86914 incorporated therein or a shrinkage-resistant binder disclosed in JP-A-200-250382, JP-A-2000-172154 and JP-A-11-344917 incorporated therein.

Further, it is preferred that the interference fringes gap be adjusted using a diffusion element disclosed in JP-A-3-46687, JP-A-5-204288, JP-T-9-506441, etc.

When a known ordinary photopolymer as disclosed in JP-A-6-43634, JP-A-2-50588, JP-A-3-50599, JP-A-5-107999, JP-A-8-16078, JP-T-2001-523842 and JP-T-11-512847 is subjected to multiplexed recording, the latter half of multiplexed recording is conducted on the area where polymerization has proceeded so much. Therefore, the latter half of multiplexed recording requires more exposure time to record the same signal than the former half of multiplexed recording (lower sensitivity). This has been a serious problem in system design. In other, it has been disadvantageous in that the range within which the refractive index modulation shows linear rise with respect to exposure is very narrow.

On the contrary, 2) color development reaction, 3) latent image color development-coloring material self-sensitized amplification color development reaction and 6) dye discoloration reaction process recording methods of the invention involve no polymerization during the recording of interference fringes. Even 4) latent image color development-coloring material sensitized polymerization reaction and 7) remaining discolorable dye latent image-latent image sensitized polymerization reaction process recording methods of the invention involve little polymerization reaction during hologram exposure (first step) and entire exposure causing block polymerization by which refractive index modulation is conducted at the second step. Accordingly, much multiplexed recording can be conducted in any of the recording methods 2) to 4), 6) and 7). Further, any multiplexed recording can be conducted at a constant exposure, i.e., with a linear rise of refractive index modulation relative to exposure. Therefore, a broad dynamic range can be obtained. Thus, 2) to 4) and 6) and 7) process recording methods of the invention are very advantageous from the standpoint of the aforementioned adaptability to multiplexed recording.

This is advantageous from the standpoint of enhancement of density (capacity), simplification of recording system, enhancement of S/N ratio, etc.

As mentioned above, the hologram recording material of the invention gives drastic solution to the aforementioned problems. In particular, the hologram recording material of the invention allows quite a new recording method which attains high sensitivity, good storage properties, dry processing properties and multiplexed recording properties (high recording density). The hologram recording material is particularly suited for optical recording medium (holographic optical memory).

In particular, when the sensitizing dye is optically discolored and fixed after hologram recording, no deterioration can occur even upon irradiation with reproducing light after recording. In other words, non-destructive reproduction can be made, providing excellent storage properties. Further, when fixing is effected after recording, no absorption of hologram reproducing light can occur, making it possible to obtain a high absolute diffraction efficiency.

The hologram recording material of the invention can be used as three-dimensional display hologram, holographic optical element (HOE, such as headup display (HUD) for automobile, pickup lens for optical disc, head mount display, color filter for liquid crystal, reflector for reflective liquid crystal, lens, diffraction grating, interference filter, connector for optical fiber, light polarizer for facsimile, window glass for building), cover paper for book, magazine, and display for POP, etc. The hologram recording material of the invention is preferably used for gift and credit card, paper money and packaging for the purpose of security against forgery.

Specific examples of the invention will be described in connection with the results of experiments, but the invention is not limited thereto.

An example of synthesis scheme of the compound represented by the formulae (1) of the invention will be described hereinafter, but the invention is not limited thereto.

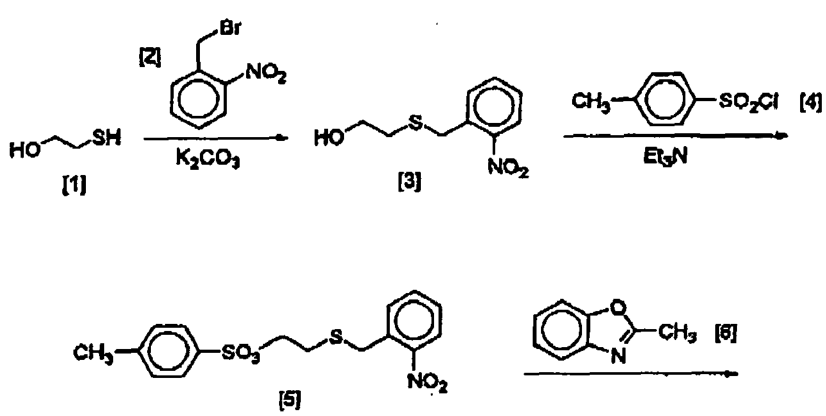

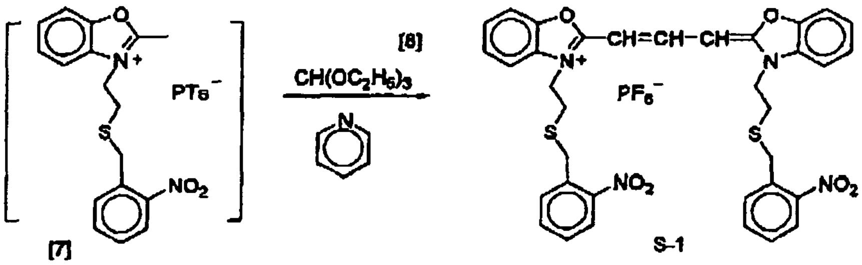


50.0 g (0.232 mol) of nitinobenzyl bromide (2) and 82.8 g (0.6 mol) of potassium carbonate were dissolved in dried 100 ml of N,N-dimethylformamide (DMF). The mixture was stirred at room temperature in a nitrogen atmosphere for 3 minutes. To the solution was then added dropwise a solution of 19.8 g of mercapto ethanol (1) in 40 ml of DMF in 30 minutes. The mixture was then stirred for 30 minutes. The solution was then poured in 500 ml of saline solution. The solution was then extracted with 200 ml of ethyl acetate three times. The extract was washed with saline solution, dried over magnesium sulfate, concentratcd, and then purified through silica gel chromatography (developing solvent: hexane : ethyl acetate = 5 : 1 → 2 : 1) to obtain 46.6 g (yield: 94%) of a yellow oil of alcohol (3).

35.8 g (0.168 mol) of alcohol (3) was dissolved in 100 ml of methylene chloride. To the solution was then added 34.0 g (0.336 mol) of triethylamine with stirring in a nitrogen atmosphere while being cooled with ice. To the mixture was then added dropwise a solution of 32.0 g (0.168 mol) of tosyl chloride (4) in 40 ml of methylene chloride. The mixture was then stirred at room temperature for 8 hours. The solution was neutralized with a 1 M hydrochloric acid, and then stirred while being cooled with ice for 1 hour. The resulting aqueous phase was separated away. The remaining organic phase was washed with an aqueous solution of sodium bicarbonate, dried over magnesium sulfate, and then concentrated to obtain 45.5 g (yield: 71%) of a yellow oil of tosylate (5)

17.2 g (74 mmol) of tosylate (5) and 5.0 g (37.6 mmol) of 2-methyl benzooxaole (6) were heated to 140˚C free from solvent with stirring in a nitrogen atmosphere for 3 hours. After cooled, the mixture was subjected to decantation with ethyl acetate five times to obtain a quaternary salt (7). To the quaternary salt (7) were then added 28.6 g (0.194 mol) of triethyl orthoformate and 100 ml of pyridine. The mixture was then heated under reflux for 20 minutes. The product was concentrated, subjected to decantation with ethyl acetate five times, purified through silica gel chromatography (developing solvent: 10 : 1 mixture of methylene and methanol), and then dissolved in methanol. 5.21 g (32 mmol) of ammonium hexafluorophosphate was then dissolved in the solution. The resulting crystal was withdrawn by filtration, washed with methanol, and then recrystallized from chloroform to obtain 1.36 g (yield: 4.5%) of an orange crystal of the desired compound S-1. The structure of the product was identified by NMR and MS spectrosropy.

The other inventive compounds represented by the formula (1) can be similarly synthesized.

(Example 1)

(Hologram recording method by polymerization process)

As described in Example 1 of JP-A-6-43634, 1.20% by weight of a radical polymerization initiator I-2, 1.80% by weight of a chain transfer agent MBO, 46.5% by weight of POEA as a monomer and 50.5% by weight of cellulose acetate butylate CAB 531-1 as a binder were used A known sensitizing dye DEAW described in JP-A-6-43634, and the inventive sensitizing dyes S-1 and S-7 were then used in an amount of 0.069% by weight, 1.00% by weight and 0.54% by weight, respectively, based on the solid content of the aforementioned mixture. These amounts were calculated from the molar absorption coefficient at 532 nm of the sensitizing dye which exhibits a transmission of 50% at a hologram recording wavelength of 532 nm when the thickness thereof is 100 μm. These components were then dissolved in a triple amount of methylene chloride (optically 2-butanone and acetone as well) to prepare Comparative Sample 1 of composition for hologram recording material and Inventive Samples 11 and 12.

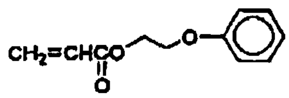

POEA

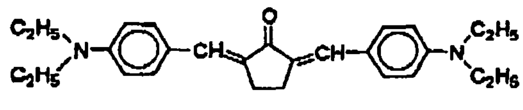

DEAW

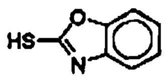

MBO

Comparative Sample 1 of composition for hologram recording material and Inventive Samples 11 and 12 were each spread (optionally in a multi-layer form) over a glass substrate to a thickness of about 100 μm using a blade to form a photosensitive layer which was then dried at room temperature in vacuo for 1 day to remove the solvent. The photosensitive layer was then covered by TAC layer to prepare a comparative hologram recording material 1 and inventive hologram recording materials 11 and 12.

The hologram recording materials were each then exposed to YAG laser second harmonic (532 nm; output: 2W) as a light source in a two-flux optical system for transmission hologram recording shown in Fig. 1 to perform recording. The angle of the object light with respect to the reference light was 30 degrees. The light had a diameter of 0.6 cm and an intensity of 8 mW/cm$^2$. During exposure, the holographic exposure time was varied from 0.1 to 200 seconds (radiation energy ranging from 0.8 to 1,600 mJ/cm$^2$). During hologram exposure, He-Ne laser beam having a wavelength of 632 nm was passed through the center of exposed area at the Bragg angle. The ratio of diffracted light to incident light (absolute diffraction efficiency) was then measured at real time. When a maximum diffraction efficiency was given, exposure was then suspended. Since the sensitizing dye shows no absorption at 632 nm, the hologram recording material is not sensitive to He-Ne laser beam.

Thereafter, the hologram recording materials were each then entirely irradiated with ultraviolet rays to visible light having a wavelength range of from 300 to 410 nm from a xenon lamp through a band pass filter so that the sensitizing dye was optically self-discolored to undergo fixation. Also during fixation, a He-No laser beam having a wavelength of 632 nm was passed through the center of the exposed area at the Bragg angle. The ratio of diffracted light to incident light (absolute diffraction efficiency) was measured at real time.

After the termination of fixation, the hologram recording materials were each irradiated with reproducing light which is the same as the reference light having a wavelength of 532 nm used during recording. The ratio of diffracted light to incident light (absolute diffraction efficiency) was then measured.

The results of evaluation of absolute diffraction efficiency of the comparative hologram recording material 1 and the inventive hologram recording materials 11 and 12 which had been fixed at 632 nm and 532 nm are set forth in Table 1. The exposure energy required for the inventive hologram recording materials 11 and 12 relative to that of the comparative hologram recording material 1 which exhibits half the maximum diffraction efficiency as 1 is also set forth in Table 1, The smaller this value is, the higher is the sensitivity at which the hologram recording material can perform recording.

Table 1

| Sample | Absolute diffraction efficiency ηat 632 nm | Absolute diffraction efficiency η at 532 nm | Relative sensitivity (The smaller it is, the higher is sensitivity) |
|---|---|---|---|
| 11 | 77% | 76% | 0.24 |
| 12 | 76 | 74 | 0.36 |
| Comparative Example 1 | 75 | 50 | 1 |

As can be seen in Table 1, the inventive hologram recording materials 11 and 12 exhibit a higher sensitivity than Comparative Example 1. It is thus made obvious that the inventive sensitizing dye can provide a hologram recording material having a higher sensitivity than known sensitizing dyes in the polymerization process (photopolymer process).

Further, Comparative Example 1, which is known in JP-A-6-43634, exhibits a high absolute diffraction efficiency at 632 nm but exhibits a low absolute diffraction efficiency at 532 nm because the sensitizing dye cannot be fully decomposed and the remaining sensitizing dye absorbs reproducing light.

On the other hand, the inventive hologram recording materials 11 and 12 can be further optically self-discolored

at the fixing step and thus exhibit no absorption at 532 nm. Thus, the inventive hologram recording materials 11 and 12 give a high absolute diffraction efficiency at 632 nm as well as at 532 nm to advantage.

When irradiated with light having a wavelength of 532 nm as reproducing light for 10 hours, the inventive hologram recording materials 11 and 12 showed no drop of diffraction efficiency. After one month of storage at room temperature, the inventive hologram recording materials 11 and 12 were each then measured for diffraction efficiency. These inventive hologram recording materials showed no special drop of diffraction efficiency.

Samples which had been prepared in the same manner as Samples 11 and 12 excellent the sensitizing dye was changed to S-2 to S-6, S-8, S-14, S-19 to S-21, S-30, and S-41 to S-43 showed similar effects.

(Example 2)

(Hologram recording method by color development method)

The sensitizing dye, electron-donating compound, interference Binge-recording component, additives and binder PMMA-EA (poly(methyl methacrylate)-5% ethyl acrylate) copolymer; Mw: 101,000) set forth in Table 2 were dissolved in a double to quadruple amount of methylene chloride (optionally acetone or acetonitrile as well) under a red light to prepare hologram recording materials 101 to 107. The term "%" as used herein is meant to indicate % by weight based on binder PMMA-EA.

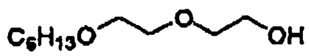

SO-3

Table 2

| Sample | Sensitizing dye | | Electron-donating, compound | Interference fringe-recording component | Additives |
|---|---|---|---|---|---|
| 101 | S-1 | 2.8% | A-1 42% | I-5 50%+L-2 10% | SO-3 8% |
| 102 | S-7 | 1.5% | " | " | " |
| 103 | S-14 | 3.0% | " | " | " |
| 104 | S-19 | 2.9% | " | " | " |
| 105 | S-2 | 1.8% | " | PB-2 20%+DD-32 10% | - |
| 106 | S-1 | 2.0% | " | E-3 25% | Trioctylamine 10% |
| 107 | S-6 | 21% | " | E-4 25% | " |

The compositions 101 to 107 for hologram recording material were each spread (optionally in a multi-layer form) over a glass substrate to a thickness of about 80 μm using a blade to form a photosensitive layer which was then dried at room temperature in vacuo for 1 day to remove the solvent. The photosensitive layer was then covered by TAC layer to prepare hologram recording materials 101 to 107.

The hologram recording materials were each then exposed to YAG laser second harmonic (532 nm; output: 2W) as a light source in a two-flux optical system for transmission hologram recording shown in Fig. 1 to perform recording. The angle of the object light with respect to the reference light was 30 degrees. The light had a diameter of 0.6 cm and an intensity of 8 $mW/cm^2$. During exposure, the holographic exposure time was varied from 0.1 to 400 seconds (radiation energy ranging from 0.8 to 1,600 $mJ/cm^2$). During hologram exposure, He-Ne laser beam having a wavelength of 632 nm was passed through the center of exposed area at the Bragg angle. The ratio of diffracted light to incident light (absolute diffraction efficiency) was then measured at real time. When a maximum diffraction efficiency was given, exposure was then suspended. Since the sensitizing dye shows no absorption at 632 nm, the hologram recording material is not sensitive to He-Ne laser beam.

Thereafter, the hologram recording materials were each then entirely irradiated with ultraviolet rays to visible light having a wavelength range of from 300 to 410 mn from a xenon lamp through a band pass filter so that the sensitizing dye was optically self-discolored to undergo fixation. Also during fixation, a He-Ne laser beam having a wavelength of 632 nm was passed through the center of the exposed area at the Bragg angle. The ratio of diffracted light to incident light (absolute diffraction efficiency) was measured at real time.

After the termination of fixation, the hologram recording materials were each irradiated with reproducing light which is the same as the reference light having a wavelength of 532 nm used during recording. The ratio of diffracted

light to incident light (absolute diffraction efficiency) was then measured.

The results of evaluation of absolute diffraction efficiency and percent shrinkage of the hologram recording materials 101 to 107 which had been fixed at 632 nm and 532 nm are set forth in Table 3. For the calculation of the percent shrinkage of the hologram recording materials, the change of the thickness of the layer from before to after recording was determined. For comparison, a radical polymerization photopolymer process hologram recording material disclosed in Example 1 of JF-A-6-43634 was prepared.

Table 3

| Sample | Absolute diffraction efficiency η at 632 nm | Absolute diffraction efficiency η at 532 nm | % Shrinkage |
|---|---|---|---|
| 101 | 79% | 78% | < 0.01% |
| 102 | 77 | 76 | " |
| 103 | 78 | 76 | " |
| 104 | 76 | 74 | " |
| 105 | 75 | 73 | " |
| 106 | 76 | 75 | " |
| 107 | 75 | 74 | " |
| Comparative Example | 75 | 50 | 5.1% |

As can be seen in Table 3, the comparative example, which is known in JP-A-6-43634, exhibits a high absolute diffraction efficiency at 632 nm but shows a shrinkage as great as more than 5% during recording because it employs a photopolymer process involving radical polymerization. The comparative example shows an extremely deteriorated S/N ratio when used as holographic memory. Thus, the comparative example is not suitable for this purpose. The comparative example exhibits a low absolute diffraction efficiency at 532 because the sensitizing dye cannot be fully decomposed and the remaining sensitizing dye absorbs reproducing light.

On the other hand, the inventive hologram recording materials 101 to 107 employ a recording process which is quite different from the known hologram recording process, i.e., hologram recording process involving refractive index modulation by discoloration reaction rather than by the movement and polymerization of material. Thus, the inventive hologram recording materials 101 to 107 can perform recording at a shrinkage as extremely small as 0.01% or less and thus are suitable particularly for holographic memory.

The inventive hologram recording materials 101 to 107 can be optically self-discolored at the fixing step and thus exhibit no absorption at 532 nm. Thus, the inventive hologram recording materials 101 to 107 give a high absolute diffraction efficiency at 632 mn as well as at 532 nm to advantage.

When irradiated with light having a wavelength of 532 nm as reproducing light for 10 hours, the inventive hologram recording materials 101 to 107 showed no drop of diffraction efficiency.

Further, the inventive hologram recording materials show a substantially linear rise of An (calculated from modulation of refractive index in interference fringes, diffraction efficiency and layer thickness on the basis of Kugelnick's equation) with exposure ($mJ/cm^2$) and thus are advantageous in multiplexed recording.

Multiplexed hologram recording was actually made on the same area of a hologram recording material of the invention 10 times at a dose corresponding to one tenth of the exposure giving the maximum diffraction efficiency at 632 nm and a reference light angle varying by 2 degrees every recording job. Thereafter, the hologram recording material was fixed in the same manner as mentioned above so that the sensitizing dye was optically self-discolored and decomposed, and then irradiated with a reproducing light at an angle varying by 2 degrees. As a result, it was confirmed that these object lights can be reproduced. It can be thus made obvious that the hologram recording material of the invention can be subjected to multiplexed recording at the same exposure and thus is adapted for multiplexed recording. Thus, the hologram recording material of the invention allows many multiplexed recording jobs and hence high density (capacity) recording.

On the contrary, the known photopolymer process hologram recording material as disclosed in JP-A-6-43634 was found to require more radiation dose in the latter stage of multiplexed recording than in the initial stage of multiplexed recording to perform the same recording because the polymerization of photopolymer has proceeded such that the rate of movement of monomer required for recording is reduced. Thus, the known photopolymer process hologram recording material leaves something to be desired in the enhancement of multiplexiry, i.e., recording density.

Even when the sensitizing dye to be used in Samples 101 to 107 were changed to S-3 to S-5, S-8, S-20, S-21, S-30 or S-41 to S-43, similar effects were obtained.

Further, even when the acid generator to be used as interference fringe-recording component in Samples 101 to 104 were changed to I-3, I-4, I-6 to I-10, 4-(octylphenyl)phenyl iodonium hexafluoroantimonate, tris(4-methylphenyl)sulfonium tetra (pentafluorophenyl)borate, triphenylsulfonium perfluoropentanoate, bis(1-(4-diphenylsulfonium) phenylsulfide ditrifurate, dimethylphenasyl sulfonium perfluorobutane sulfonate, benzoyl tosylate, 1-22 or 1-23 or when the acid-colorable dye precursor to be used as interference fringe-recording component in Samples 101 to 107 were changed to L-1, L-3, LC-1, LC-4, LC-9 or LC-11 to LC-13, similar effects were obtained.

Further, eve when the base generator to be used as interference fringe-recording component in Sample 105 was changed to PB-1 and PB-3 to PB-9 or when the base-colorable dye precursor (non-dissociative product of dissociative dye) to be used in Sample 105 was changed to DD-1, DD-13, DD-15, DD-17, DD-22, DD-30, DD-31 or DD-33 to DD-38, similar effects were obtained.

Further, even when the interference fringe-recording component to be used in Samples 106 and 107 were changed to E-5, E-9 to E-16, E-18, E-20 or E-25 to E-30, similar effects were obtained.

Further, even when the electron donator to be used in Samples 101 to 107 were changed to A-2 to A-6 or A-9 to A-11, similar effects were obtained.

Further, even when the binder to be used in Samples 101 to 107 were changed to polymethyl methacrylates (Mw: 996,000, 350,000, 120,000), poly (methyl methacrylate-butyl methacrylate) copolymer (Mw: 75,000), polyvinyl acetate (Mw: 83,000), polycarbonate, cellulose acetate butyrate, etc., similar effects were obtained.

(Example 3)

(Hologram recording by latent image color development-coloring material self-sensitized amplification color development reaction)

The sensitizing dye, electron-donating compound, dye precursor group + polymerization initiator, polymmizable compound and binder set forth in Table 4 were dissolved in a double to quintuple amount of methylene chloride (optionally acetone, acetonitrile or methanol in a small portion as well) under a red light to prepare hologram recording materials 201 to 204. The term "%" as used herein is meant to indicate % by weight.

M-1

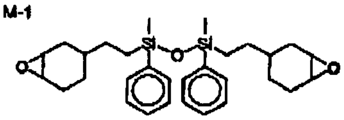

M-2

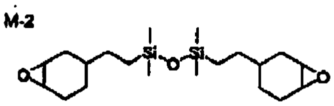

POEA

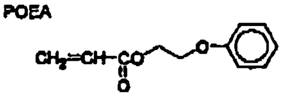

NVC

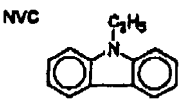

NA

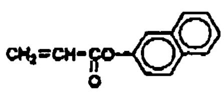

MBO

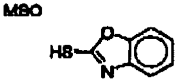

Table 4

| Sampl e | Sensitizing dye Moamm-donating compound | | Dye precursor group + polymerization initiator | Polymerizable compound | Binder |
|---|---|---|---|---|---|
| 201 | S-1 | 1.4% | L-2(5%) + I-5(20%) | M-131.6% | Polydimethyl siloxane 32% |
| | A-1 | 10% | | | |
| 202 | S-7 | 0.8% | L-2(5%) + I-5(20%) | POEA:NA =4:1 32.2% in total | Polyvinyl acetate 32% |
| | A-1 | 10% | | | |
| 203 | S-6 | 1.5% | DD-33(5%) + PB-2 (20%) | M-2 31.5% | Poly(methylphenyl) siloxane |

(continued)

| Sampl e | Sensitizing dye Moamm-donating compound | | Dye precursor group + polymerization initiator | Polymerizable compound | Binder |
|---|---|---|---|---|---|
| | A-1 | 10% | | | 32% |
| 204 | S-1 | 1.4% | E-4(20%) + I-2 (1.6%) | POEA:NVC | Cellulose acetate butyrate |
| | A-1 | 10% | + MBO(2.4%) | = 2 : 1 | 32% |
| | | | | 32.6% in total | |

The hologram recording material compositions 201 to 204 were each spread (optionally in a multi-layer form) over a glass substrate to a thickness of about 80 μm using a blade to form a photosensitive layer which was then dried at room temperature in vacuo for 1 day to remove the solvent. The photosensitive layer was then covered by TAC layer to prepare hologram recording materials 201 to 204.

The hologram recording materials were each then exposed to YAG laser second harmonic (532 nm; output: 2W) as a light source in a two-flux optical system for transmission hologram recording shown in Fig. 1 to perform recording. The angle of the object light with respect to the reference light was 30 degrees. The light had a diameter of 0.6 cm and an intensity of 8 $mW/cm^2$. During exposure, the holographic exposure time was varied from 0.1 to 40 seconds (radiation energy ranging from 0.8 to 320 $mJ/cm^2$) (first step). He-Ne laser beam having a wavelength of 632 nm was passed through the center of exposed area at the Bragg angle. The ratio of diffracted light to incident light (absolute diffraction efficiency) was then measured at real time (diffraction efficiency η after first step).

Since the sensitizing dye shows no absorption at 632 nm, the hologram recording material is not sensitive to He-Ne laser beam.

Thereafter, the hologram recording materials were each then entirely irradiated with light rays having a wavelength range of from 300 to 410 nm from a xenon lamp through a band pass filter (second step). The absolute diffraction efficiency was measured at 632 run and 532 nm (diffraction efficiency η after second step).

By dividing the radiation dose required to give the maximum diffraction efficiency using only the first step rather than the second step by the radiation dose required at the first step if the second step is used, the "percent amplification" was determined. The results are set forth in Table 5.

Table 5

| Sample | Diffraction efficiency η after first step | Diffraction step efficiency η after second | | % Amplification |
|---|---|---|---|---|
| | 632 nm | 632 nm | 532 nm | |
| 201 | 16% | 73% | 72% | 6.3 |
| 202 | 15 | 75 | 74 | 6.7 |
| 203 | 14 | 72 | 71 | 5.1 |
| 204 | 15 | 73 | 71 | 5.7 |

As can be seen in Table 5, when the hologram recording material of the invention is used, the radiation dose required at the first step can be reduced to one seventh to one fifth of that required when the second step is not employed It is also made obvious that the second step allows block exposure and hence polymerization with the discolorable dye left undiscolored at the first step as a latent image, resulting in amplification of refractive index modulation that allows the reduction of the first step, i.e., enhancement of sensitivity. It goes without saying that the known hologram recording material disclosed in JP-A-6-43634 cannot undergo such amplification that allows enhancement of sensitivity.

Since the sensitizing dye, too, can be optically self-discolored and decomposed at the second step, the inventive hologram recording material shows no absorption at 532 nm and thus gives a high absolute diffraction efficiency at 632 nm as well as at 532 nm.

When irradiated with light having a wavelength of 532 nm as reproducing light for 10 hours, the inventive hologram recording materials 201 to 204 showed no drop of diffraction efficiency. After one month of storage at room temperature, the inventive hologram recording materials 201 to 204 were each then measured for diffraction efficiency. As a result, these inventive hologram recording materials showed no special drop of diffraction efficiency.

Further, the hologram recording material of the invention shows a substantially linear rise of An (refractive index modulation in interference fringes, calculated from diffraction efficiency and layer thickness by Kugelnick's equation) with exposure ($mJ/cm^2$) both after the first and second steps and thus is favorable for multiplexed recording.

Multiplexed hologram recording was actually made on the same area of a hologram recording material of the

invention 10 times at a dose corresponding to one tenth of the exposure giving the aforementioned maximum diffraction efficiency and a reference light angle varying by 2 degrees every recording job (first step). Thereafter, the hologram recording material was entirely irradiated with light having a wavelength of from 300 nm to 410 nm to perform recording amplification by polymerization (second step). As a result, it was confirmed that these object lights can be reproduced by irradiating the hologram recording material with a reproducing light at an angle varying by 2 degrees. It can be thus made obvious that the hologram recording material of the invention can be subjected to multiplexed recording at the same exposure and thus is adapted for multiplexed recording. Thus, the hologram recording material of the invention allows many multiplexed recording jobs and hence high density (capacity) recording.

On the contrary, the known photopolymer process hologram recording material as disclosed in JP-A-6-43634 was found to require more radiation dose in the latter stage of multiplexed recording than in the initial stage of multiplexed recording to perform the same recording because the polymerization of photopolymer has proceeded such that the rate of movement of monomer required for recording is reduced. Thus, the known photopolymer process hologram recording material leaves something to be desired in the enhancement of multiplexity, Le., recording density.

On the other hand, the hologram recording method of the invention employs color development reaction as a means of forming a latent image rather than polymerization during hologram recording (first step) and thus is not subject to the aforementioned disadvantages. Therefore, the hologram recording method of the invention is superior to the known photopolymer process.

Even when the sensitizing dye to be used in Samples 201 to 204 were changed to S-2 to S-5, S-8, S-14, S-19 to S-21, S-30 or S-41 to S-43, similar effects were obtained.

Further, even when the acid generator (which acts also as cationic or radical polymerization initiator) to be used as interference fringe-recording component in Samples 201 and 202 were changed to I-3, I-4, I-6 to I-10, 4-(octylphenyl)phenyl iodonium hexafluoroantimonate, tris(4-methylphenyl)sulfonium tetra (pentafluorophenyl)borate, triphenylsulfonium perfluoropentanoate, bis(1-(4-diphenylsulfonium) phenylsulfide ditrifurate, dimethylphenasyl sulfoniuxn perfluorobutane sulfonate or benzoyl tosylate or when the acid-colorable dye precursor to be used as interference fringe-recording component in Samples 201 and 202 were changed to L-1, L-3, LC-1, LC-4, LC-9 or LC-11 to LC-13, similar effects were obtained.

Further, eve when the base generator (which acts also as anionic polymerization initiator) to be used as interference fringe-recording component (or polymerization initiator) in Sample 203 was changed to PB-3 to PB-9 or when the base-colorable dye precursor (non-dissociative product of dissociative dye) to be used in Sample 203 was changed to DD-1, DD-13, DD-15, DD-17, DD-22, DD-30 to DD-32 or DD-34 to DD-38, similar effects were obtained.

Further, even when the dye precursor to be used in Sample 204 was changed to E-3, E-5, E-9 to E-16, E-18, E-20 or E-25 to E-30 or when the radical polymerization initiator to be used in Sample 204 was changed to I-1 or I-11 to I-20, similar effects were obtained.

Further, even when the electron donator to be used in Samples 201 to 204 were changed to A-2 to A-6 or A-9 to A-11, similar effects were obtained.

The lights with which the hologram recording material was entirely irradiated during the aforementioned procedure had an optimum wavelength in the respective system.

(Example 4)

(Discoloration process (sensitizing dye + discolorable dye) hologram recording method)

Under a red lamp, the sensitizing dye, electron-donating compound, discoloring agent precursor, discolorable dye and binder PMMA-EA (poly(methyl methacrylate-3% ethyl acrylate) copolymer; Mw: 101,000) set forth in Table 6 were dissolved in methylene chloride (optionally with acetone or acetonitrile) in an amount of twice to four times the weight of these components to prepare hologram recording material compositions 301 to 305. The term "%" as used herein is meant to indicate wt-% based on the weight of binder PMMA-EA.

Table 6

| Sample | Sensitizing dye | | Electron-donating compound | | Discoloring agent precursor | | Discolorable dye | |
|---|---|---|---|---|---|---|---|---|
| 301 | S-1 | 1.4% | A-1 | 42.0% | I-5 | 50% | G-16 | 8% |
| 302 | S-1 | 1.4% | A-1 | 42.0% | I-5 | 50% | G-28 | 8% |
| 303 | S-7 | 0.8% | A-1 | 42.0% | I-5 | 50% | G-15 | 8% |
| 304 | S-6 | 1.5% | A-1 | 42.0% | I-5 | 50% | G-13 | 8% |

(continued)

| Sample | Sensitizing dye | | Electron-donating compound | | Discoloring agent precursor | | Discolorable dye | |
|---|---|---|---|---|---|---|---|---|
| 305 | S-1 | 1.2% | A-1 | 42.0% | PB-2 | 20% | G-40 | 8% |

($X_{51}$ represents $PF_6^-$)

The hologram recording material compositions 301 to 305 were each spread (optionally in a multi-layer form) over a glass substrate to a thickness of about 80 μm using a blade to form a photosensitive layer which was then dried in vacuo at room temperature for one day to remove the solvent. The photosensitive layer was then covered by TAC layer to prepare hologram recording materials 301 to 305,

The hologram recording materials were each then exposed to YAG laser second harmonic (532 nm; output: 2W) as a light source in a two-flux optical system for transmission hologram recording shown in Fig. 1 to perform recording. The angle of the object light with respect to the reference light was 30 degrees. The light had a diameter of 0.6 cm and an intensity of 8 $mW/cm^2$. During exposure, the holographic exposure time was varied from 0.1 to 400 seconds (radiation energy ranging from 0.8 to 3,200 $mJ/cm^2$). During hologram exposure, He-Ne laser beam having a wavelength of 632 nm was passed through the center of exposed area at the Bragg angle. The ratio of diffracted light to transmitted light (relative diffraction efficiency) was then measured at real time. When a maximum diffraction efficiency was given, exposure was then suspended. Since the sensitizing dye shows no absorption at 632 nm, the hologram recording material is not sensitive to He-Ne laser beam.

Thereafter, the hologram recording materials were each then entirely irradiated with ultraviolet rays to visible light having a wavelength range of from 300 to 410 nm from a xenon lamp through a band pass filter so that the sensitizing dye was optically self-discolond to undergo fixation. Also during fixation, a He-Ne laser beam having a wavelength of 632 nm was passed through the center of the exposed area at the Bragg angle. The ratio of diffracted light to incident light (absolute diffraction efficiency) was measured at real time.

After the termination of fixation, the hologram recording materials were each irradiated with reproducing light which is the same as the reference light having a wavelength of 532 nm used during recording. The ratio of diffracted light to incident light (absolute diffraction efficiency) was then measured.

The results of evaluation of absolute diffraction efficiency and percent shrinkage of the hologram recording materials 301 to 305 which had been fixed at 632 nm and 532 nm are set forth in Table 7. For the calculation of the percent shrinkage of the hologram recording materials, the change of the thickness of the layer from before to after recording was determined. For comparison, a radical polymerization photopolymer process hologram recording material disclosed in Example 1 of JP-A-6-43634 was prepared.

Table 7

| Sample | Absolute diffraction efficiency η at 632 nm | Absolute diffraction efficiency η at 532 nm | % Shrinkage |
|---|---|---|---|
| 301 | 81% | 78% | < 0.01% |
| 302 | 82 | 79 | " |
| 303 | 79 | 76 | " |
| 304 | 78 | 74 | " |
| 305 | 75 | 73 | " |
| Comparative Example | 75 | 50 | 5.1% |

As can be seen in Table 7, the comparative example, which is known in JP-A-6-43634, exhibits a high absolute diffraction efficiency at 632 nm but shows a shrinkage as great as more than 5% during recording because it employs a photopolymer process involving radical polymerization. The comparative example shows an extremely deteriorated S/N ratio when used as holographic memory. Thus, the comparative example is not suitable for this purpose. The comparative example exhibits a low absolute diffraction efficiency at 532 because the sensitizing dye cannot be fully decomposed and the remaining sensitizing dye absorbs reproducing light.

On the other hand, the inventive hologram recording materials 301 to 305 employ a recording process which is quite different from the known hologram recording process, i.e., hologram recording process involving refractive index modulation by discoloration reaction rather than by the movement and polymerization of material. Thus, the inventive hologram recording materials 301 to 305 can perform recording at a shrinkage as extremely small as 0.01% or less and thus are suitable particularly for holographic memory.

The inventive hologram recording materials 301 to 305 can be optically self-discolored at the fixing step and thus exhibit no absorption at 532 nm. Thus, the inventive hologram recording materials give a high absolute diffraction

efficiency at 632 nm as well as at 532 nm to advantage.

When irradiated with light having a wavelength of 532 nm as reproducing light for 10 hours, the inventive hologram recording materials 301 to 305 showed no drop of diffraction efficiency.

Further, the inventive hologram recording materials show a substantially linear rise of $\Delta n$ (calculated from modulation of refractive index in interference fringes, diffraction efficiency and layer thickness on the basis of Kugelnick's equation) with exposure ($mJ/cm^2$) and thus are advantageous in multiplexed recording.

Multiplexed hologram recording was actually made on the same area of a hologram recording material of the invention 10 times at a dose corresponding to one tenth of the exposure giving the maximum diffraction efficiency at 632 nm and a reference light angle varying by 2 degrees every recording job. Thereafter, the hologram recording material was fixed in the same manner as mentioned above so that the sensitizing dye was optically self-discolored and decomposed, and then irradiated with a reproducing light at an angle varying by 2 degrees. As a result, it was confirmed that these object lights can be reproduced. It can be thus made obvious that the hologram recording material of the invention can be subjected to multiplexed recording at the same exposure and thus is adapted for multiplexed recording. Thus, the hologram recording material of the invention allows many multiplexed recording jobs and hence high density (capacity) recording.

On the contrary, the known photopolymer process hologram recording material as disclosed in JP-A-6-43634 was found to require more radiation dose in the latter stage of multiplexed recording than in the initial stage of multiplexed recording to perform the same recording because the polymerization of photopolymer has proceeded such that the rate of movement of monomer required for recording is reduced. Thus, the known photopolymer process hologram recording material leaves something to be desired in the enhancement of multiplexity, i.e., recording density.

(Example 5)

(Hologram recording by remaining discolorable dye latent image-latent image sensitization polymerization reaction)

The sensitizing dye, electron-donating compound, discolorable dye, discoloring agent precursor, polymerisation initiator, polymerizable compound and binder set forth in Table 8 were dissolved in a double to quintuple amount of methylene chloride (optionally acetone, acetonitrile or methanol in a small portion as well) under a red light to prepare hologram recording materials 401 to 404. The term "%" as used herein is meant to indicate % by weight.

M-2

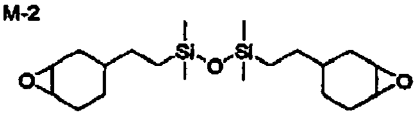

MBO

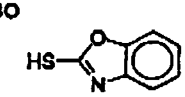

DDA

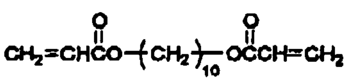

PFOA

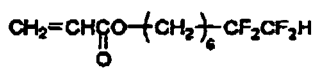

TEGDA

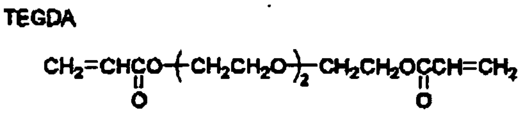

Table 8

| Sample | Sensitizing dye Electron-donating compound | | Discolorable dye | | Discoloring agent precursor Polymerization initiator | | Polymerizable compound Binder |
|---|---|---|---|---|---|---|---|
| 401 | S-1 | 1.4% | G-16 | 4% | I-5 | 18% | M-2 33.6% |
| | A-1 | 10% | | | | | Polymethylphenyl siloxane 33% |
| 402 | S-1 | 1.4% | G-28 | 4% | I-5 | 18% | TEGDA 32.4% |

(continued)

| Sample | Sensitizing dye Electron-donating compound | | Discolorable dye | | Discoloring agent precursor Polymerization initiator | | Polymerizable compound Binder |
|---|---|---|---|---|---|---|---|
| | A-1 | 10% | | | | | Poly(styrene-acrylonitrile)75:25 34% |
| 403 | S-7 | 0.8% | G-30 | 4% | PB-2 | 18% | M-2 34.2% |
| | A-1 | 10% | ($X_{51}$ represents $PF_6$') | | | | Polymethylphenyl siloxane 33% |
| 404 | S-6 | 1.6% | G-47 | 13% | - | | DDA28% PFOA7% |
| | A-1 | 10% | | | I-2 | 1.6%+MBO 2.4% | Polystyrene 36.4% |

The hologram recording material compositions 401 to 404 were each spread (optionally in a multi-layer form) over a glass substrate to a thickness of about 80 μm using a blade to form a photosensitive layer which was then dried at room temperature in vacuo for 1 day to remove the solvent. The photosensitive layer was then covered by TAC layer to prepare hologram recording materials 401 to 404.

The hologram recording materials were each then exposed to YAG laser second harmonic (532 nm; output: 2W) as a light source in a two-flux optical system for transmission hologram recording shown in Fig. I to perform recording. The angle of the object light with respect to the reference light was 30 degrees. The light had a diameter of 0.6 cm and an intensity of 8 $mW/cm^2$. During exposure, the holographic exposure time was varied from 0.1 to 40 seconds (radiation energy ranging from 0.8 to 320 $mJ/cm^2$) (first step). He-Ne laser beam having a wavelength of 632 nm was passed through the center of exposed area at the Bragg angle. The ratio of diffracted light to incident light (absolute diffraction efficiency) was then measured at real time (diffraction efficiency η after first step).

Since the sensitizing dye shows no absorption at 632 nm, the hologram recording material is not sensitive to He-Ne laser beam.

Thereafter, the hologram recording materials were each then entirely irradiated with light rays having a wavelength range of from 300 to 410 nm from a xenon lamp through a band pass filter (second step). The absolute diffraction efficiency was measured at 632 nm and 532 nm (diffraction efficiency η after second step).

By dividing the radiation dose required to give the maximum diffraction efficiency using only the first step rather than the second step by the radiation dose required at the first step if the second step is used, the ''percent amplification" was determined. The results are set forth in Table 9.

Table 9

| Sample | Diffraction efficiency η after first step 632 nm | Diffraction step efficiency η after second 632 nm | 532 mn | % Amplification |
|---|---|---|---|---|
| 401 | 16% | 74% | 72% | 6.3 |
| 402 | 15 | 77 | 74 | 6.9 |
| 403 | 14 | 72 | 70 | 5.1 |
| 404 | 14 | 74 | 71 | 6.0 |

As can be scen in Table 9, when the hologram recording material of the invention is used, the radiation dose required at the first step can be reduced to one seventh to one fifth of that required when the second step is not employed. It is also made obvious that the second step allows block exposure and hence polymerization with the discolorable dye left undiscolored at the first step as a latent image, resulting in amplification of refractive index modulation that allows the reduction of the first step, i.e., enhancement of sensitivity. It goes without saying that the known hologram recording material disclosed in JP-A-6-43634 cannot undergo such amplification that allows enhancement of sensitivity.

Since the sensitizing dye, too, can be optically self-discolored and decomposed at the second step, the inventive hologram recording material shows no absorption at 532 nm and thus gives a high absolute diffraction efficiency at 632 nm as well as at 532 nm.

When irradiated with light having a wavelength of 532 nm as reproducing light for 10 hours, the inventive hologram recording materials 401 to 404 showed no drop of diffraction efficiency. After one month of storage at room temperature, the inventive hologram recording materials 401 to 404 were each then measured for diffraction efficiency.

As a result, these inventive hologram recording materials showed no special drop of diffraction efficiency.

Further, the hologram recording material of the invention shows a substantially linear rise of $\Delta n$ (refractive index modulation in interference fringes, calculated from diffraction efficiency and layer thickness by Kugelnick's equation) with exposure (mJ/cm$^2$) both after the first and second steps and thus is favorable for multiplexed recording.

Multiplexed hologram recording was actually made on the same area of a hologram recording material of the invention 10 times at a dose corresponding to one tenth of the exposure giving the aforementioned maximum diffraction efficiency and a reference light angle varying by 2 degrees every recording job (first step). Thereafter, the hologram recording material was entirely irradiated with light having a wavelength of from 300 nm to 410 nm to perform recording amplification by polymerization (second step). As a result, it was confirmed that these object lights can be reproduced by irradiating the hologram recording material with a reproducing light at an angle varying by 2 degrees. It can be thus made obvious that the hologram recording material of the invention can be subjected to multiplexed recording at the same exposure and thus is adapted for multiplexed recording. Thus, the hologram recording material of the invention allows many multiplexed recording jobs and hence high density (capacity) recording.

On the contrary, the known photopolymer process hologram recording material as disclosed in JP-A-6-43634 was found to require more radiation dose in the latter stage of multiplexed recording than in the initial stage of multiplexed recording to perform the same recording because the polymerization of photopolymer has proceeded such that the rate of movement of monomer required for recording is reduced. Thus, the known photopolymer process hologram recording material leaves something to be desired in the enhancement of multiplexity, i.e., recording density.

On the other hand, the hologram recording method of the invention employs color development reaction as a means of forming a latent image rather than polymerization during hologram recording (first step) and thus is not subject to the aforementioned disadvantages. Therefore, the hologram recording method of the invention is superior to the known photopolymer process.

Even when the sensitizing dye to be used in Samples 301 to 305 and 401 to 404 were changed to S-2 to S-5, S-8, S-20, S-21, S-30 or S-41 to S-43, similar effects were obtained.

Further, even when the discoloring agent precursor (acid generator, which optionally acts also as acid or radical polymerization initiator) to be used in Samples 301 to 304, 401 and 402 were changed to I-3, I-4, I-6 to 1-10, 4-(octylphenyl) pbenyl iodonium hexafluoroantimonate, tris(4-methylphenyl)sulfonium tetra (pentafluorophenyl)borate, triphenylsulfonium perfluoropentanoate, bis(1-(4-diphenylsulfonium) phenylsulfide ditrifurate, dimethylphenasyl sulfonium perfluorobutane sulfonate or benzoyl tosylate 1-22, I-23 or when the acid-discolorable dye to be used in Samples 301 to 304, 401 and 402 were changed to G-14, G-17, G-21, G-22, G-26 or G-27, similar effects were obtained.

Further, eve when the discoloring agent (base generator which acts also as anionic polymerization initiator) to be used in Samples 305 and 403 were changed to PB-3 to PB-9 or when the base-discolorable dye to be used in Samples 305 and 403 were changed to G-29, G-32, G-38, G-40 or G-42 to G-45, similar effects were obtained.

Further, even when the radical polymerization initiator to be used in Sample 404 was changed to I-1 or I-11 to I-20 or when the discolorable dye to be used in Sample 404 was changed to G-48 to G-52, similar effects were obtained.

Further, even when the electron donator to be used in Samples 301 to 305 and 401 to 404 were changed to A-2 to A-6 or A-9 to A-11, similar effects were obtained.

Further, even when the binder to be used in Samples 301 to 305 were changed to polymethyl methacrylates (Mw: 996,000, 350,000, 120,000), poly (methyl methacrylate-butyl methacrylate) copolymer (Mw: 75,000), polyvinyl acetate (Mw: 83,000), polycarbonate, cellulose acetate butyrate, etc., similar effects were obtained.

The lights with which the hologram recording material was entirely irradiated during the aforementioned procedure had an optimum wavelength in the respective system.

While the invention has been described in detail and with reference to specific embodiments thereof, it will be apparent to one skilled in the art that various changes and modifications can be made therein without departing from the spirit and scope thereof.

The entire disclosure of each and every foreign patent application from which the benefit of foreign priority has been claimed in the present application is incorporated herein by reference, as if fully set forth herein.

## Claims

**1.** A hologram recording material comprising:

a sensitizing dye capable of absorbing hologram recording light to generate an excited state thereof and capable of discoloring itself upon irradiation after hologram recording, the sensitizing dye being a compound represented by formula (1):

D-L-E-LP

wherein D represents a group containing a sensitizing dye, L represents a single bond or a connecting group, E represents a site capable of disconnecting the bond between E and LP to discolor the sensitizing dye, and LP represents a group containing a site capable of disconnecting the bond between E and LP upon irradiation, and

an interference fringe-recording component capable of recording interference fringes providing a refractive index modulation by an electron or energy transfer from the excited state.

**2.** The hologram recording material according to Claim 1, wherein E is a site generating at least one of a nucleating agent, an electrophilic agent and a radical by disconnecting the bond between E and LP.

**3.** The hologram recording material according to Claim 1, wherein E is a site generating a nucleating agent by disconnecting the bond between E and LP.

**4.** The hologram recording material according to Claim 3, wherein the nucleating agent is at least one of -S-, -SH, -O-, -OH and $-NHR_{31}$, wherein $R_{31}$ represents a hydrogen atom, alkyl group, alkenyl group, cycloalkyl group, aryl group or heterocyclic group.

**5.** The hologram recording material according to Claim I, wherein LP is a group represented by formula (2):

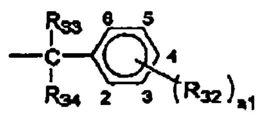

wherein $R_{32}$ represents a substituent; $R_{33}$ and $R_{34}$ each independently represent a hydrogen atom, alkyl group, alkenyl group, cycloalkyl group, aryl group, heterocyclic group or acyl group; and a1 represents an integer of 1 to 5.

**6.** The hologram recording material according to Claim 1, wherein D represents a group containing at least one of a cyanine dye, a melocyanine dye, an oxonol dye, a benzylidene dye and a styryl dye.

**7.** The hologram recording material according to Claim 1, wherein the compound represented by formula (1) is represented by one of formulae (3-1) to (3-5):

(3-1)

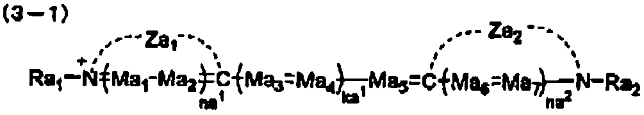

CIy

(3-2)

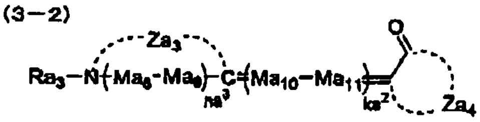

CIy

(3-3)

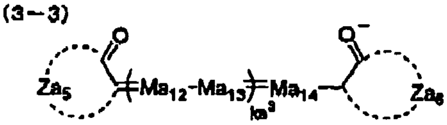

CIy

(3-4)

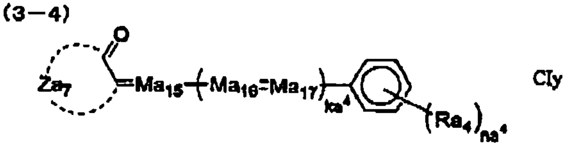

(3-5)

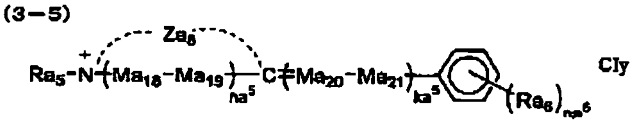

wherein $Za_1$, $Za_2$, $Za_3$ and $Za_8$ each independently represent an atomic group constituting a 5-membered or 6-membered nitrogen-containing heterocyclic group; and $Za_4$ to $Za_7$ each independently represent an atomic group constituting a 5-membered or 6-membered ring,

$Ra_1$, $Ra_2$, $Ra_3$ and $Ra_5$ each independently represent a hydrogen atom, alkyl group, alkenyl group, aryl group or heterocyclic group; and $Ra_4$ and $Ra_6$ each independently represent a substituent,

$Ma_1$ to $Ma_{21}$ each independently represent a methine group which may have a substituent and may form a ring with a methine group,

$na^1$, $na^2$, $na^3$ and $na^5$ each independently represent 0 or 1; and $na^4$ and $na^6$ each independently represent an integer of 0 to 5, with the proviso that when $na^4$ is 2 or more, $Ra_4$'s are the same or different and may be connected to each other to form a ring, and with the proviso that when $na^6$ is 2 or more, $Ra_6$'s are the same or different and may be connected to each other to form a ring,

$ka^1$ to $ka^5$ each independently represent an integer of 0 to 3, with the proviso that: when $ka^1$ is 2 or more, $Ma_3$'s are the same or different and $Ma_4$'s are the same or different; when $ka^2$ is 2 or more, $Ma_{10}$'s are the same or different and $Ma_{11}$'s are the same or different; when $ka^3$ is 2 or more, $Ma_{12}$'s are the same or different and $Ma_{13}$'s are the same or different; when $ka^4$ is 2 or more, $Ma_{16}$'s are the same or different and $Ma_{17}$'s are the same or different; and when $ka^5$ is 2 or more, $Ma_{20}$'s are the same or different and $Ma_{21}$'s are the same or different,

CI represents an ion that neutralizes electric charge of the compound,

y represents the number of CI's required to neutralize the electric charge,

the sensitizing dye represented by formula (3-1) comprises a group represented by formula (4) in at least one of $Ra_1$, $Ra_2$ and $Ma_3$ to $Ma_5$,

the sensitizing dye represented by formula (3-2) comprises a group represented by formula (4) in at least one of $Ra_3$, $Ma_{10}$ and $Ma_{11}$,

the sensitizing dye represented by formula (3-3) comprises a group represented by formula (4) in at least one of $Ma_{12}$ to $Ma_{14}$,

the sensitizing dye represented by formula (3-4) comprises a group represented by formula (4) in at least one of $Ra_4$, $Ma_{16}$ and $Ma_{17}$, and

the sensitizing dye represented by formula (3-5) comprises a group represented by formula (4) in at least one of $Ra_5$, $Ra_6$, $Ma_{20}$ and $Ma_{21}$:

**Formula (4):**

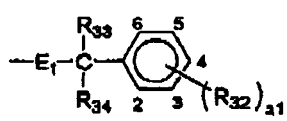

wherein $R_{32}$, $R_{33}$, $R_{34}$ and a1 are as defined in formula (2); and El represents at least one of -O-, -Sand -$NR_{31}$-, wherein $R_{31}$ represents a hydrogen atom, alkyl group, alkenyl group, cycloalkyl group, aryl group or heterocyclic group.

**8.** The hologram recording material according to Claim 1, wherein LP does not disconnect the bond between E and LP and does not discolor itself upon irradiation with hologram recording light; and LP disconnects the bond between E and LP upon irradiation with light other than the hologram recording light to discolor itself.

**9.** A hologram recording method comprises:

effecting hologram recording with a sensitizing dye represented by formula (1):

D-L-E-LP

wherein D represents a group containing a sensitizing dye, L represents a single bond or a connecting group, E represents a site capable of disconnecting the bond between E and LP to discolor the sensitizing dye, and LP represents a group containing a site capable of disconnecting the bond between E and LP upon irradiation; and
irradiating with light other than hologram recording light so that the sensitizing dye represented by formula (1) is self-discolored and fixed, to record interference fringes providing a refractive index modulation,

wherein a hologram recorded by the hologram recording method can be reproduced by irradiating with the same light as the hologram recording light without extinguishing the interference fringes.

**10.** A hologram recording method, which comprises recording interference fringes providing a refractive index modulation in a hologram recording material according to Claim 1 by at least one of 1) a polymerization reaction, 2) a color development reaction, 3) a color development reaction amplified by a self-sensitization with a coloring material of a latent image, 4) a polymerization reaction sensitized with a coloring material of a latent image, 5) an alignment change in a compound having a birefringence, 6) a dye discoloration reaction, and 7) a latent image-sensitized polymerization reaction sensitized by a latent image of a residual of a discolorable dye.

**11.** The hologram recording method according to Claim 10, wherein
the recording of the interference fringes is performed by 3) the color development reaction amplified by a self-sensitization with a coloring material of a latent image, and
the recording of the interference fringes comprises:

a first step of generating a coloring material as a latent image by holographic exposure, the coloring material having no absorption in a wavelength of a hologram reproducing light; and
a second step of irradiating the latent image of the coloring material with a light having a wavelength, which is different from that of the holographic exposure and in which the sensitizing dye represented by formula (1) has a molar absorption coefficient of 5,000 or less, to self-sensitive and self-amplify the coloring material,

wherein each of the first and second steps is dry process.

**12.** The hologram recording method according to Claim 10, wherein
the interference fringe-recording component is a component capable of recording the interference fringes by at least one of 2) the color development reaction and 3) the color development reaction amplified by a self-sensitization with a coloring material of a latent image,
the component comprises a dye precursor capable of forming a coloring material, wherein the coloring material has an absorption shifted to a longer wavelength than that of the dye precursor and has no absorption in a wavelength of a hologram reproducing light, and
the interference fringes are recorded by forming the refractive index modulation through a color development of the coloring material as a result of an electron or energy transfer from the excited state of the sensitizing dye or an excited state of the coloring material.

**13.** The hologram recording method according to Claim 10, wherein
the recording of the interference fringes is performed by 4) the polymerization reaction sensitized with the coloring material of the latent image, and
the recording of the interference fringes comprises:

a first step of generating a coloring material as a latent image by holographic exposure, the coloring material having no absorption in a wavelength of a hologram reproducing light; and
a second step of irradiating the latent image of the coloring material with a light having a wavelength, which is different from that of the holographic exposure, to cause a polymerization reaction.

wherein each of the first and second steps is dry process.

**14.** The hologram recording method according to Claim 13, wherein

the sensitizing dye represented by formula (1) absorbs light upon the holographic exposure in the first step to generate the excited state thereof, and
the interference fringe-recording component comprises:

a dye precursor capable of forming a coloring material by an electron or energy transfer from the excited state of the sensitizing dye in the first step or from an excited state of the coloring material in the second step, wherein the coloring material has an absorption shifted to a longer wavelength than that in the dye precursor, the coloring material has an absorption in a wavelength in which the sensitizing has a molar absorption coefficient of 5,000 or less, and the coloring material has no absorption in a wavelength of a hologram reproducing light;
a polymerizable compound;
a polymerization initiator capable of initiating a polymerization of the polymerizable compound by an energy or electron transfer from the excited state of the sensitizing dye in the first step or from an excited state of the coloring material in the second step; and
a binder.

**15.** The hologram recording method according to Claim 10, wherein
the recording of the interference fringes is performed by 6) the dye discoloration reaction,
the interference fringe-recording component comprises at least one of a discolorable dye and a discoloring agent precursor, the discoloring agent precursor comprising at least one of a radical generator, an acid generator, a base generator, a nucleophilic agent generator, an electrophilic agent generator and an triplet oxygen, and
the interference fringes are recorded by forming the refractive index modulation through at least one of: discoloring the discolorable dye as a result of an energy or electron transfer from the excited state of the sensitizing dye directly to the discolorable dye; and discoloring the discolorable dye by a discoloring agent formed by an energy or electron transfer from the excited state of the sensitizing dye to the discoloring agent precursor

**16.** The hologram recording method according to Claim 10, wherein
the recording of the interference fringes is performed by 7) the latent image-sensitized polymerization reaction sensitized by a latent image of a residual of a discolorable dye, and
the interference fringe-component records the interference fringes by a method comprising:

a first step in which:

the sensitizing dye represented by formula (1) absorbs light upon holographic exposure to generate the excited state thereof,
a color of a discolorable dye is discolored by at least one of, an energy or electron transfer from the excited state of the sensitizing dye directly to the discolorable dye; and a discoloring agent formed by an energy or electron transfer from the excited state of the sensitizing dye to a discoloring agent precursor, the discoloring agent precursor comprising at least one of a radical generator, an acid generator, a base generator, a nucleophilic agent generator, an electrophilie agent generator and an triplet oxygen, and
a residual of the discolorable dye forms a latent image; and

a second step of irradiating the latent image of the residual of the discolorable dye with light having a wavelength, which is different from that the holographic exposure, to cause a polymerization reaction by activating a polymerization initiator as a result of an energy or electron transfer from the residual of the discolorable dye.

**17.** The hologram recording method according to Claim 16, wherein the interference fringe-recording component comprises:

a discolorable dye capable of discoloring itself in the first step as a result of at least one of: an energy or electron transfer directly from the excited state of the sensitizing dye; and an generation of the discoloring agent by an energy or electron transfer from the excited state of the sensitizing dye to the discoloring agent precursor, the discolorable dye having a molar absorption coefficient of 1,000 or less at a wavelength of a hologram reproducing light;
a polymenzable compound;
a polymerization initiator capable of initiating a polymerization of the polymerizable compound by an electron or energy transfer from the excited state of the residual of the discolorable dye in the second step; and
a binder.

**18.** The hologram recording material according to Claim 1, wherein the interference fringes are non-rewritable.

**19.** The hologram recording method according to Claim 10, comprising performing a multiplexed recording by subjecting the hologram recording material to holographic exposure ten times or more.

**20.** The hologram recording method according to Claim 19, wherein the multiplexed recording is performed under a common exposure amount in each holographic exposure.

**21.** An optical recording medium comprising a hologram recording material according to Claim 1.

**22.** The optical recording medium according to Claim 21, which is stored in a light-shielding cartridge during a storage period.

**23.** A compound represented by one of the formulae (5-1) to (5-5):

(5-1)

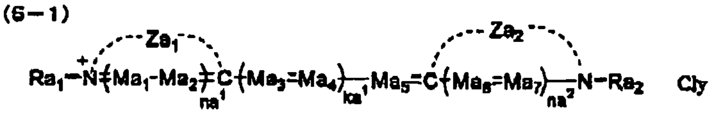

(5-2)

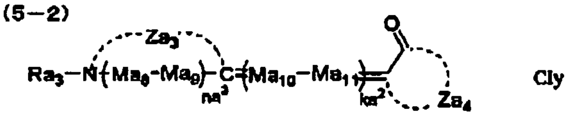

(5-3)

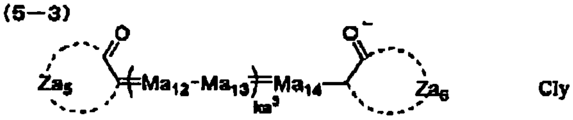

(5-4)

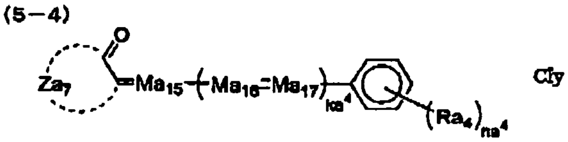

(5-5)

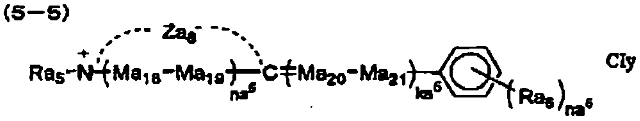

wherein $Za_1$, $Za_2$, $Za_3$ and $Za_8$ each independently represent an atomic group constituting a 5-membered or 6-membered nitrogen-containing heterocyclic group; and $Za_4$ to $Za_7$ each independently represent an atomic group constituting a 5-membered or 6-membered ring,
$Ra_1$, $Ra_2$, $Ra_3$ and $Ra_5$ each independently represent a hydrogen atom, alkyl group, alkenyl group, aryl group or heterocyclic group; and $Ra_4$ and $Ra_6$ each independently represent a substituent,
$Ma_1$ to $Ma_{21}$ each independently represent a methine group which may have a substiuierit and may form a ring with a methine group,
$na^1$, $na^2$, $na^3$ and $na^5$ each independently represent 0 or 1; and $na^4$ and $na^6$ each independently represent an integer of 0 to 5, with the proviso that when $na^4$ is 2 or more, $Ra_4$'s are the same or different and may be connected to each other to form a ring, and with the proviso that when $na^6$ is 2 or more, $Ra_6$'s are the same or different and may be connected to each other to form a ring,
$ka^1$ to $ka^5$ each independently represent an integer of 0 to 3, with the proviso that: when $ka^1$ is 2 or more, $Ma_3$'s

are the same or different and $Ma_4$'s are the same or different; when $ka^2$ is 2 or more, $Ma_{10}$'s are the same or different and $Ma_{11}$'S are the same or different; when $ka^3$ is 2 or more, $Ma_{12}$'s are the same or different and $Ma_{13}$'s are the same or different; when $ka^4$ is 2 or more, $Ma_{16}$'s arc the same or different and $Ma_{17}$'s are the same or different; and when $ka^5$ is 2 or more, $Ma_{20}$'s are the same or different and $Ma_{21}$'s are the same or different, CI represents an ion that neutralizes electric charge of the compound,

y represents the number of CI's required to neutralize the electric charge,

the compound represented by comprises a group represented by one of formulae (6-1) to (6-3) in at least one of $Ra_1$, $Ra_2$ and $Ma_3$ to $Ma_5$,

the compound represented by formula (5-2) comprises a group represented by one of formulae (6-1) to (6-3) in at least one of $Ra_3$, $Ma_{10}$ and $Ma_{11}$,

the compound represented by formula (5-3) comprises a group represented by one of formulae (6-1) to (6-3) in at least one of $Ma_{12}$ to $Ma_{14}$,

the compound represented by formula (5-4) comprises a group represented by one of formulae (6-1) to (6-3) in at least one of $Pa_4$, $Ma_{16}$ and $Ma_{17}$, and

the compound represented by formula (5-5) comprises a group represented by one of the formulae (6-1) to (6-3) in at least one of $Ra_5$, $Ra_6$, $Ma_{20}$ and $Ma_{21}$:

(6-1)

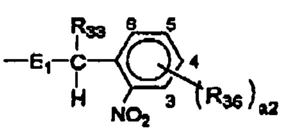

(6-2)

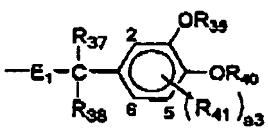

(6-3)

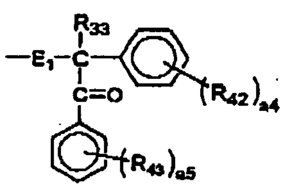

wherein El represents at least one of -O-, -S- and $-NR_{31}-$, wherein $R_{31}$ represents a hydrogen atom, alkyl group, alkenyl group, cycloalkyl group, aryl group or heterocyclic group,

$R_{35}$ represents a hydrogen atom, alkyl group or aryl group; $R_{36}$ represents a substituent; and a2 represents an integer of 0 to 4, with the proviso that when a2 is 2 or more, $R_{36}$'s are the same or different and may be connected to each other to form a ring,

$R_{37}$ and $R_{38}$ each independently represent a hydrogen atom or alkyl group; $R_{39}$ and $R_{40}$ each independently represent an alkyl group; $R_{41}$ represents a substituent; and a3 represents an integer of 0 to 3, with the proviso that when a3 is 2 or more, $R_{41}$'s are the same or different and may be connected to each other to form a ring, and

$R_{42}$ and $R_{43}$ each independently represent a substituent, and a4 and a5 each independently represent an integer of 0 to 5, with the proviso that when a4 is 2 or more, $R_{42}$'s are the same or different and may be connected to each other to form a ring, and with the proviso that when a5 is 2 or more, $R_{43}$'s are the same or different and may be connected to each other to form a ring.

**24.** The compound according to Claim 23, which is an optical self-discolorable dye.

FIG. 1